# EUROPEAN PATENT APPLICATION

(11) **EP 4 235 791 A1**
(43) Date of publication of application: **30.08.2023**
(21) Application number: 21882863.0
(22) Date of filing: 20.10.2021
(51) Int. Cl.: H01L 27/146

(54) **IMAGING DEVICE AND LIGHT RECEIVING ELEMENT**

(30) Priority: 23.10.2020 JP 2020178463
(71) Applicant: Sony Semiconductor Solutions Corporation, Atsugi-shi, Kanagawa 243-0014 (JP)
(72) Inventor: NAKAZAWA, Keiichi, Atsugi-shi, Kanagawa 243-0014 (JP); KOJIMA, Takashi, Atsugi-shi, Kanagawa 243-0014 (JP); IMAI, Shinichi, Atsugi-shi, Kanagawa 243-0014 (JP); KANEGUCHI, Tokihisa, Atsugi-shi, Kanagawa 243-0014 (JP); SAGA, Koichiro, Atsugi-shi, Kanagawa 243-0014 (JP); TOKUHIRO, Kai, Atsugi-shi, Kanagawa 243-0014 (JP); HIRANO, Takaaki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/038768
(87) International publication number: WO 2022/085722

(57) **Abstract**

An imaging device according to an embodiment of the present disclosure includes: a first semiconductor layer including, for each pixel, a photoelectric conversion section and a charge accumulation section that accumulates signal charge generated in the photoelectric conversion section; a second semiconductor layer stacked on the first semiconductor layer and having a first surface provided with a pixel transistor, in which the pixel transistor has a three-dimensional structure and reads the signal charge from the charge accumulation section; and a through-wiring line that directly couples the charge accumulation section and a gate electrode of the pixel transistor to each other.

## Description

### Technical Field

The present disclosure relates to an imaging device and a light-receiving element which have a three-dimensional structure.

### Background Art

For example, PTL 1 discloses an imaging element including: a first substrate including a sensor pixel that performs photoelectric conversion; and a second substrate including a readout circuit, in which the first substrate and the second substrate are stacked on each other and electrically coupled to each other by a through-wiring line provided inside an interlayer insulating film.

### Citation List

### Patent Literature

PTL 1: International Publication No. WO2019/131965

### Summary of the Invention

Incidentally, an imaging element of a three-dimensional structure as described above is required to have improved area efficiency of a second substrate in which a readout circuit is formed.

It is desirable to provide an imaging device that makes it possible to improve area efficiency.

An imaging device according to an embodiment of the present disclosure includes: a first semiconductor layer including, for each pixel, a photoelectric conversion section and a charge accumulation section that accumulates signal charge generated in the photoelectric conversion section; a second semiconductor layer stacked on the first semiconductor layer and having a first surface provided with a pixel transistor, in which the pixel transistor has a three-dimensional structure and reads the signal charge from the charge accumulation section; and a through-wiring line that directly couples the charge accumulation section and a gate electrode of the pixel transistor to each other.

A light-receiving element according to an embodiment of the present disclosure includes: a first semiconductor layer including a photoelectric conversion section and a charge accumulation section that accumulates signal charge generated in the photoelectric conversion section; a second semiconductor layer stacked on the first semiconductor layer and having a first surface provided with a transistor, in which the transistor has a three-dimensional structure and reads the signal charge from the charge accumulation section; and a through-wiring line that directly couples the charge accumulation section and a gate electrode of the transistor to each other.

In the imaging device of an embodiment of the present disclosure and the light-receiving element of an embodiment of the present disclosure, the charge accumulation section provided in the first semiconductor layer and the pixel transistor having the three-dimensional structure provided in the second semiconductor layer are directly coupled to each other by the through-wiring line. This enables a reduction in an area for formation of components other than the pixel transistor in a plane of the second semiconductor layer.

### Brief Description of the Drawings

[FIG. 1] FIG. 1 is a block diagram illustrating an example of a functional configuration of an imaging device according to a first embodiment of the present disclosure.
[FIG. 2] FIG. 2 is a schematic plan view of an outline configuration of the imaging device illustrated in FIG. 1.
[FIG. 3] FIG. 3 is a schematic view of a cross-sectional configuration taken along a line III-III' illustrated in FIG. 2.
[FIG. 4] FIG. 4 is an equivalent circuit diagram of a pixel sharing unit illustrated in FIG. 1.
[FIG. 5] FIG. 5 illustrates an example of a coupling mode between a plurality of pixel sharing units and a plurality of vertical signal lines.
[FIG. 6] FIG. 6 is a schematic cross-sectional view of an example of a specific configuration of an imaging device illustrated in FIG. 3.
[FIG. 7A] FIG. 7A is a schematic view of an example of a planar configuration of a main part of a first substrate illustrated in FIG. 6.
[FIG. 7B] FIG. 7B is a schematic view of a planar configuration of a pad section together with the main part of the first substrate illustrated in FIG. 7A.
[FIG. 8] FIG. 8 is a schematic view of an example of a planar configuration of a second substrate (semiconductor layer) illustrated in FIG. 6.
[FIG. 9] FIG. 9 is a schematic view of an example of a planar configuration of main parts of a pixel circuit and the first substrate together with a first wiring layer illustrated in FIG. 6.
[FIG. 10] FIG. 10 is a schematic view of an example of a planar configuration of the first wiring layer and a second wiring layer illustrated in FIG. 6.
[FIG. 11] FIG. 11 is a schematic view of an example of a planar configuration of the second wiring layer and a third wiring layer illustrated in FIG. 6.
[FIG. 12] FIG. 12 is a schematic view of an example of a planar configuration of the third wiring layer and a fourth wiring layer illustrated in FIG. 6.
[FIG. 13] FIG. 13 is a schematic view of a cross-sectional configuration of main parts of the imaging device illustrated in FIG. 1.
[FIG. 14] FIG. 14 is a schematic view of an example of a planar configuration of the second substrate illustrated in FIG. 13.
[FIG. 15] FIG. 15 is a schematic view of a cross-sectional configuration as a comparative example of the main parts of the imaging device illustrated in FIG. 13.
[FIG. 16] FIG. 16 is a schematic view of an example of a planar configuration of the second substrate illustrated in FIG. 15.
[FIG. 17A] FIG. 17A is a flowchart of a manufacturing step of the main parts of the imaging device illustrated in FIG. 13.
[FIG. 17B] FIG. 17B is a schematic cross-sectional view of a step subsequent to FIG. 17A.
[FIG. 17C] FIG. 17C is a schematic cross-sectional view of a step subsequent to FIG. 17B.
[FIG. 17D] FIG. 17D is a schematic cross-sectional view of a step subsequent to FIG. 17C.
[FIG. 18] FIG. 18 is a schematic view for describing a path of an input signal to the imaging device illustrated in FIG. 3.
[FIG. 19] FIG. 19 is a schematic view for describing a signal path of a pixel signal of the imaging device illustrated in FIG. 3.
[FIG. 20] FIG. 20 is a schematic view of a cross-sectional configuration of main parts of an imaging device according to Modification Example 1 of the present disclosure.
[FIG. 21] FIG. 21 is a schematic view of a cross-sectional configuration of main parts of an imaging device according to Modification Example 2 of the present disclosure.
[FIG. 22] FIG. 22 is a schematic view of a cross-sectional configuration of main parts of an imaging device according to Modification Example 3 of the present disclosure.
[FIG. 23] FIG. 23 is a schematic view of a cross-sectional configuration of main parts of an imaging device according to Modification Example 4 of the present disclosure.
[FIG. 24] FIG. 24 is a schematic view of a cross-sectional configuration of main parts of an imaging device according to Modification Example 5 of the present disclosure.
[FIG. 25] FIG. 25 is a schematic view of an example of a planar configuration of a second substrate of the imaging device illustrated in FIG. 24.
[FIG. 26] FIG. 26 is a schematic view of a cross-sectional configuration of main parts of an imaging device according to Modification Example 6 of the present disclosure.
[FIG. 27] FIG. 27 is a schematic view of a cross-sectional configuration of main parts of an imaging device according to Modification Example 7 of the present disclosure.
[FIG. 28A] FIG. 28A is a flowchart of an example of a manufacturing step according to Modification Example 8 of the present disclosure.
[FIG. 28B] FIG. 28B is a schematic cross-sectional view of a step subsequent to FIG. 28A.
[FIG. 28C] FIG. 28C is a schematic cross-sectional view of a step subsequent to FIG. 28B.
[FIG. 28D] FIG. 28D is a schematic cross-sectional view of a step subsequent to FIG. 28C.
[FIG. 28E] FIG. 28E is a schematic cross-sectional view of a step subsequent to FIG. 28D.
[FIG. 28F] FIG. 28F is a schematic cross-sectional view of a step subsequent to FIG. 28E.
[FIG. 29A] FIG. 29A is a flowchart of another example of the manufacturing step according to Modification Example 8 of the present disclosure.
[FIG. 29B] FIG. 29B is a schematic cross-sectional view of a step subsequent to FIG. 29A.
[FIG. 29C] FIG. 29C is a schematic cross-sectional view of a step subsequent to FIG. 29B.
[FIG. 29D] FIG. 29D is a schematic cross-sectional view of a step subsequent to FIG. 29C.
[FIG. 30A] FIG. 30A is a flowchart of another example of the manufacturing step according to Modification Example 8 of the present disclosure.
[FIG. 30B] FIG. 30B is a schematic cross-sectional view of a step subsequent to FIG. 30A.
[FIG. 30C] FIG.30C is a schematic cross-sectional view of a step subsequent to FIG. 30B.
[FIG. 30D] FIG. 30D is a schematic cross-sectional view of a step subsequent to FIG. 30C.
[FIG. 31A] FIG. 31A is a flowchart of an example of a manufacturing step according to Modification Example 8 of the present disclosure.
[FIG. 31B] FIG. 31B is a schematic cross-sectional view of a step subsequent to FIG. 31A.
[FIG. 31C] FIG. 31C is a schematic cross-sectional view of a step subsequent to FIG. 31B.
[FIG. 31D] FIG. 31D is a schematic cross-sectional view of a step subsequent to FIG. 31C.
[FIG. 32] FIG. 32 is a schematic view of a cross-sectional configuration of main parts of an imaging device according to a second embodiment of the present disclosure.
[FIG. 33] FIG. 33 is a schematic view of an example of a planar configuration of the imaging device illustrated in FIG. 32.
[FIG. 34] FIG. 34 is an enlarged view for describing structures of the main parts of the imaging device illustrated in FIG. 32.
[FIG. 35A] FIG. 35A is a flowchart of an example of a manufacturing step of the main parts of the imaging device illustrated in FIG. 32.
[FIG. 35B] FIG. 35B is a schematic cross-sectional view of a step subsequent to FIG. 35A.
[FIG. 35C] FIG. 35C is a schematic cross-sectional view of a step subsequent to FIG. 35B.
[FIG. 35D] FIG. 35D is a schematic cross-sectional view of a step subsequent to FIG. 35C.
[FIG. 35E] FIG. 35E is a schematic cross-sectional view of a step subsequent to FIG. 35D.
[FIG. 35F] FIG. 35F is a schematic cross-sectional view of a step subsequent to FIG. 35E.
[FIG. 35G] FIG. 35G is a schematic cross-sectional view of a step subsequent to FIG. 35F.
[FIG. 35H] FIG. 35H is a schematic cross-sectional view of a step subsequent to FIG. 35G.
[FIG. 35I] FIG. 35I is a schematic cross-sectional view of a step subsequent to FIG. 35H.
[FIG. 36] FIG. 36 is a schematic view of a cross-sectional configuration as a comparative example of the main parts of the imaging device illustrated in FIG. 33.
[FIG. 37] FIG. 37 is a schematic view of a cross-sectional configuration of main parts of an imaging device according to Modification Example 9 of the present disclosure.
[FIG. 38A] FIG. 38A is a flowchart of an example of a manufacturing step of the main parts of the imaging device illustrated in FIG. 37.
[FIG. 38B] FIG. 38B is a schematic cross-sectional view of a step subsequent to FIG. 38A.
[FIG. 38C] FIG. 38C is a schematic cross-sectional view of a step subsequent to FIG. 38B.
[FIG. 38D] FIG. 38D is a schematic cross-sectional view of a step subsequent to FIG. 38C.
[FIG. 38E] FIG. 38E is a schematic cross-sectional view of a step subsequent to FIG. 38D.
[FIG. 39] FIG. 39 is a schematic view of an example of a cross-sectional configuration of main parts of an imaging device according to Modification Example 10 of the present disclosure.
[FIG. 40] FIG. 40 is an enlarged view for describing structures of the main parts of the imaging device illustrated in FIG. 39.
[FIG. 41A] FIG. 41A is a flowchart of an example of a manufacturing step of the main parts of the imaging device illustrated in FIG. 39.
[FIG. 41B] FIG. 41B is a schematic cross-sectional view of a step subsequent to FIG. 41A.
[FIG. 41C] FIG. 41C is a schematic cross-sectional view of a step subsequent to FIG. 41B.
[FIG. 41D] FIG. 41D is a schematic cross-sectional view of a step subsequent to FIG. 41C.
[FIG. 41E] FIG. 41E is a schematic cross-sectional view of a step subsequent to FIG. 41D.
[FIG. 42] FIG. 42 is a schematic view of another example of the cross-sectional configuration of the main parts of the imaging device according to Modification Example 10 of the present disclosure.
[FIG. 43] FIG. 43 is a schematic view of another example of the cross-sectional configuration of the main parts of the imaging device according to Modification Example 10 of the present disclosure.
[FIG. 44] FIG. 44 is a schematic view of an example of a planar configuration of an imaging device according to Modification Example 11 of the present disclosure.
[FIG. 45A] FIG. 45A is a flowchart of an example of a manufacturing step of main parts of the imaging device of the present disclosure.
[FIG. 45B] FIG. 45B is a schematic cross-sectional view of a step subsequent to FIG. 45A.
[FIG. 45C] FIG. 45C is a schematic cross-sectional view of a step subsequent to FIG. 45B.
[FIG. 45D] FIG. 45D is a schematic cross-sectional view of a step subsequent to FIG. 45C.
[FIG. 45E] FIG. 45E is a schematic cross-sectional view of a step subsequent to FIG. 45D.
[FIG. 45F] FIG. 45F is a schematic cross-sectional view of a step subsequent to FIG. 45E.
[FIG. 45G] FIG. 45G is a schematic cross-sectional view of a step subsequent to FIG. 45F.
[FIG. 45H] FIG. 45H is a schematic cross-sectional view of a step subsequent to FIG. 45G.
[FIG. 45I] FIG. 45I is a schematic cross-sectional view of a step subsequent to FIG. 45H.
[FIG. 45J] FIG. 45J is a schematic cross-sectional view of a step subsequent to FIG. 45I.
[FIG. 46] FIG. 46 is a schematic view of an example of a planar configuration of the imaging device according to Modification Example 11 of the present disclosure.
[FIG. 47] FIG. 47 is a schematic view of another example of the planar configuration of the imaging device according to Modification Example 11 of the present disclosure.
[FIG. 48A] FIG. 48A is a flowchart of an example of a manufacturing step of another example of the imaging device according to Modification Example 11 of the present disclosure.
[FIG. 48B] FIG. 48B is a schematic cross-sectional view of a step subsequent to FIG. 48A.
[FIG. 48C] FIG. 48C is a schematic cross-sectional view of a step subsequent to FIG. 48B.
[FIG. 49] FIG. 49 is a schematic view of a modification example of the planar configuration of the second substrate (semiconductor layer) illustrated in FIG. 8.
[FIG. 50] FIG. 50 is a schematic view of a planar configuration of main parts of the first wiring layer and the first substrate together with a pixel circuit illustrated in FIG. 49.
[FIG. 51] FIG. 51 is a schematic view of an example of a planar configuration of the second wiring layer together with the first wiring layer illustrated in FIG. 50.
[FIG. 52] FIG. 52 is a schematic view of an example of a planar configuration of the third wiring layer together with the second wiring layer illustrated in FIG. 51.
[FIG. 53] FIG. 53 is a schematic view of an example of a planar configuration of the fourth wiring layer together with the third wiring layer illustrated in FIG. 52.
[FIG. 54] FIG. 54 is a schematic view of a modification example of the planar configuration of the first substrate illustrated in FIG. 7A.
[FIG. 55] FIG. 55 is a schematic view of an example of a planar configuration of a second substrate (semiconductor layer) to be stacked on the first substrate illustrated in FIG. 54.
[FIG. 56] FIG. 56 is a schematic view of an example of a planar configuration of the first wiring layer together with a pixel circuit illustrated in FIG. 55.
[FIG. 57] FIG. 57 is a schematic view of an example of a planar configuration of the second wiring layer together with the first wiring layer illustrated in FIG. 56.
[FIG. 58] FIG. 58 is a schematic view of an example of a planar configuration of the third wiring layer together with the second wiring layer illustrated in FIG. 57.
[FIG. 59] FIG. 59 is a schematic view of an example of a planar configuration of the fourth wiring layer together with the third wiring layer illustrated in FIG. 58.
[FIG. 60] FIG. 60 is a schematic view of another example of the planar configuration of the first substrate illustrated in FIG. 54.
[FIG. 61] FIG. 61 is a schematic view of an example of a planar configuration of a second substrate (semiconductor layer) to be stacked on the first substrate illustrated in FIG. 60.
[FIG. 62] FIG. 62 is a schematic view of an example of a planar configuration of the first wiring layer together with a pixel circuit illustrated in FIG. 61.
[FIG. 63] FIG. 63 is a schematic view of an example of a planar configuration of the second wiring layer together with the first wiring layer illustrated in FIG. 62.
[FIG. 64] FIG. 64 is a schematic view of an example of a planar configuration of the third wiring layer together with the second wiring layer illustrated in FIG. 63.
[FIG. 65] FIG. 65 is a schematic view of an example of a planar configuration of the fourth wiring layer together with the third wiring layer illustrated in FIG. 64.
[FIG. 66] FIG. 66 is a schematic cross-sectional view of another example of the imaging device illustrated in FIG. 3.
[FIG. 67] FIG. 67 is a schematic view for describing a path of an input signal to the imaging device illustrated in FIG. 66.
[FIG. 68] FIG. 68 is a schematic view for describing a signal path of a pixel signal of the imaging device illustrated in FIG. 66.
[FIG. 69] FIG. 69 is a schematic cross-sectional view of another example of the imaging device illustrated in FIG. 6.
[FIG. 70] FIG. 70 illustrates another example of an equivalent circuit illustrated in FIG. 4.
[FIG. 71] FIG. 71 is a schematic plan view of another example of a pixel separation section illustrated in FIG. 7A and the like.
[FIG. 72] FIG. 72 is a schematic view of an example of a cross-sectional configuration of main parts of an imaging device according to Modification Example 19 of the present disclosure.
[FIG. 73] FIG. 73 is a schematic view of an example of a planar configuration of the imaging device illustrated in FIG. 72.
[FIG. 74A] FIG. 74A is a flowchart of an example of a manufacturing step of the main parts of the imaging device illustrated in FIG. 72.
[FIG. 74B] FIG. 74B is a schematic cross-sectional view of a step subsequent to FIG. 74A.
[FIG. 74C] FIG. 74C is a schematic cross-sectional view of a step subsequent to FIG. 74B.
[FIG. 74D] FIG. 74D is a schematic cross-sectional view of a step subsequent to FIG. 74C.
[FIG. 74E] FIG. 74E is a schematic cross-sectional view of a step subsequent to FIG. 74D.
[FIG. 74F] FIG. 74F is a schematic cross-sectional view of a step subsequent to FIG. 74E.
[FIG. 75A] FIG. 75A is a flowchart of another example of the manufacturing step of the main parts of the imaging device illustrated in FIG. 72.
[FIG. 75B] FIG. 75B is a schematic cross-sectional view of a step subsequent to FIG. 75A.
[FIG. 75C] FIG. 75C is a schematic cross-sectional view of a step subsequent to FIG. 75B.
[FIG. 75D] FIG. 75D is a schematic cross-sectional view of a step subsequent to FIG. 75C.
[FIG. 75E] FIG. 75E is a schematic cross-sectional view of a step subsequent to FIG. 75D.
[FIG. 75F] FIG. 75F is a schematic cross-sectional view of a step subsequent to FIG. 75E.
[FIG. 76] FIG. 76 is a schematic view of an example of a cross-sectional configuration of main parts of an imaging device according to Modification Example 20 of the present disclosure.
[FIG. 77] FIG. 77 is a diagram illustrating an example of an equivalent circuit of the imaging device illustrated in FIG. 76.
[FIG. 78A] FIG. 78A is a flowchart of an example of a manufacturing step of the main parts of the imaging device illustrated in FIG. 76.
[FIG. 78B] FIG. 78B is a schematic cross-sectional view of a step subsequent to FIG. 78A.
[FIG. 78C] FIG. 78C is a schematic cross-sectional view of a step subsequent to FIG. 78B.
[FIG. 78D] FIG. 78D is a schematic cross-sectional view of a step subsequent to FIG. 78C.
[FIG. 79] FIG. 79 is a schematic view of another example of the cross-sectional configuration of the main parts of the imaging device according to Modification Example 20 of the present disclosure.
[FIG. 80] FIG. 80 is a schematic view of another example of the cross-sectional configuration of the main parts of the imaging device according to Modification Example 20 of the present disclosure.
[FIG. 81] FIG. 81 is a schematic view of an example of a cross-sectional configuration of main parts of an imaging device according to Modification Example 21 of the present disclosure.
[FIG. 82] FIG. 82 is a schematic view of an example of a planar configuration of the imaging device illustrated in FIG. 81.
[FIG. 83A] FIG. 83A is a flowchart of an example of a manufacturing step of the main parts of the imaging device illustrated in FIG. 81.
[FIG. 83B] FIG. 83B is a schematic cross-sectional view of a step subsequent to FIG. 83A.
[FIG. 83C] FIG. 83C is a schematic cross-sectional view of a step subsequent to FIG. 83B.
[FIG. 83D] FIG. 83D is a schematic cross-sectional view of a step subsequent to FIG. 83C.
[FIG. 83E] FIG. 83E is a schematic cross-sectional view of a step subsequent to FIG. 83D.
[FIG. 84] FIG. 84 is a schematic view of another example of the cross-sectional configuration of the main parts of the imaging device according to Modification Example 21 of the present disclosure.
[FIG. 85] FIG. 85 is a schematic view of another example of the cross-sectional configuration of the main parts of the imaging device according to Modification Example 21 of the present disclosure.
[FIG. 86] FIG. 86 is a schematic view of another example of the planar configuration of the imaging device illustrated in FIG. 81.
[FIG. 87] FIG. 87 is a schematic view of another example of the cross-sectional configuration of the main parts of the imaging device according to Modification Example 21 of the present disclosure.
[FIG. 88] FIG. 88 is a schematic view of an example of a cross-sectional configuration of main parts of an imaging device according to Modification Example 22 of the present disclosure.
[FIG. 89] FIG. 89 is a diagram illustrating an example of an equivalent circuit of the imaging device illustrated in FIG. 88.
[FIG. 90A] FIG. 90A is a flowchart of an example of a manufacturing step of the main parts of the imaging device illustrated in FIG. 88.
[FIG. 90B] FIG. 90B is a schematic cross-sectional view of a step subsequent to FIG. 90A.
[FIG. 90C] FIG. 90C is a schematic cross-sectional view of a step subsequent to FIG. 90B.
[FIG. 90D] FIG. 90D is a schematic cross-sectional view of a step subsequent to FIG. 90C.
[FIG. 90E] FIG. 90E is a schematic cross-sectional view of a step subsequent to FIG. 90D.
[FIG. 90F] FIG. 90F is a schematic cross-sectional view of a step subsequent to FIG. 90E.
[FIG. 90G] FIG. 90G is a schematic cross-sectional view of a step subsequent to FIG. 90F.
[FIG. 91] FIG. 91 is a schematic view of another example of the cross-sectional configuration of the main parts of the imaging device according to Modification Example 22 of the present disclosure.
[FIG. 92] FIG. 92 is a diagram illustrating an example of an equivalent circuit of the imaging device illustrated in FIG. 91.
[FIG. 93] FIG. 93 is a schematic view of another example of the cross-sectional configuration of the main parts of the imaging device according to Modification Example 22 of the present disclosure.
[FIG. 94] FIG. 94 is a diagram illustrating an example of an equivalent circuit of the imaging device illustrated in FIG. 93.
[FIG. 95A] FIG. 95A is a flowchart of an example of a manufacturing step of the main parts of the imaging device illustrated in FIG. 93.
[FIG. 95B] FIG. 95B is a schematic cross-sectional view of a step subsequent to FIG. 95A.
[FIG. 95C] FIG. 95C is a schematic cross-sectional view of a step subsequent to FIG. 95B.
[FIG. 95D] FIG. 95D is a schematic cross-sectional view of a step subsequent to FIG. 95C.
[FIG. 95E] FIG. 95E is a schematic cross-sectional view of a step subsequent to FIG. 95D.
[FIG. 95F] FIG. 95F is a schematic cross-sectional view of a step subsequent to FIG. 95E.
[FIG. 95G] FIG. 95G is a schematic cross-sectional view of a step subsequent to FIG. 95F.
[FIG. 96] FIG. 96 is a schematic view of another example of the cross-sectional configuration of the main parts of the imaging device according to Modification Example 22 of the present disclosure.
[FIG. 97] FIG. 97 is a schematic view of another example of the cross-sectional configuration of the main parts of the imaging device according to Modification Example 22 of the present disclosure.
[FIG. 98] FIG. 98 is a schematic view of another example of the cross-sectional configuration of the main parts of the imaging device according to Modification Example 22 of the present disclosure.
[FIG. 99] FIG. 99 illustrates an example of an outline configuration of an imaging system including the imaging device according to any of the embodiments described above and the modification examples thereof.
[FIG. 100] FIG. 100 illustrates an example of an imaging procedure in the imaging system illustrated in FIG. 88.
[FIG. 101] FIG. 101 is a block diagram depicting an example of schematic configuration of a vehicle control system.
[FIG. 102] FIG. 102 is a diagram of assistance in explaining an example of installation positions of an outside-vehicle information detecting section and an imaging section.
[FIG. 103] FIG. 103 is a view depicting an example of a schematic configuration of an endoscopic surgery system.
[FIG. 104] FIG. 104 is a block diagram depicting an example of a functional configuration of a camera head and a camera control unit (CCU).

### Modes for Carrying Out the Invention

In the following, description is given in detail of embodiments of the present disclosure with reference to the drawings. The following description is merely a specific example of the present disclosure, and the present disclosure should not be limited to the following aspects. Moreover, the present disclosure is not limited to arrangements, dimensions, dimensional ratios, and the like of each component illustrated in the drawings. It is to be noted that the description is given in the following order.
1. First Embodiment (Example 1 of an imaging device which has a stacked structure of three substrates and in which a floating diffusion and an amplification transistor are directly coupled to each other by a through-wiring line)
2. Modification Examples
   2-1. Modification Example 1 (Another example of a configuration on a side of a first substrate)
   2-2. Modification Example 2 (Another example 1 of a configuration of a pixel transistor)
   2-3. Modification Example 3 (Another example 2 of a configuration of a pixel transistor)
   2-4. Modification Example 4 (Another example of a method for coupling a floating diffusion and an amplification transistor to each other)
   2-5. Modification Example 5 (Another example of a method for coupling a floating diffusion and an amplification transistor to each other)
   2-6. Modification Example 6 (Another example of a structure of a through-wiring line coupling a floating diffusion and an amplification transistor to each other)
   2-7. Modification Example 7 (Another example of a method for coupling transistors inside a pixel circuit)
   2-8. Modification Example 8 (An example of a method of manufacturing a transistor having a Fin structure)
3. Second Embodiment (Example 2 of an imaging device which has a stacked structure of three substrates and in which a floating diffusion and an amplification transistor are directly coupled to each other by a through-wiring line)
4. Modification Examples
   4-1. Modification Example 9 (Another example 1 of a structure of an amplification transistor)
   4-2. Modification Example 10 (Another example 2 of a structure of an amplification transistor)
   4-3. Modification Example 11 (Another example 3 of a structure of an amplification transistor)
5. Modification Example 12 (Example 1 of planar configuration)
6. Modification example 13 (Example 2 of planar configuration)
7. Modification Example 14 (Example 3 of planar configuration)
8. Modification Example 15 (An example of including a contact section between substrates in a middle part of a pixel array section)
9. Modification Example 16 (An example of including a planar transfer transistor)
10. Modification Example 17 (An example in which one pixel is coupled to one pixel circuit)
11. Modification Example 18 (A configuration example of a pixel separation section)
12. Modification Example 19 (Another example of a method for coupling a floating diffusion and an amplification transistor to each other)
13. Modification Example 20 (An example of directly coupling a floating diffusion and a reset transistor to each other by a through-wiring line)
14. Modification Example 21 (An example of electrically coupling transistors of the same potential using a polysilicon wiring line)
15. Modification Example 22 (An example in which a plurality of transistors included in a pixel circuit are created separately in two semiconductor layers to be stacked on each other)
16. Application Example (Imaging System)
17. Practical Application Examples

### <1. First Embodiment>

### [Functional Configuration of Imaging Device 1]

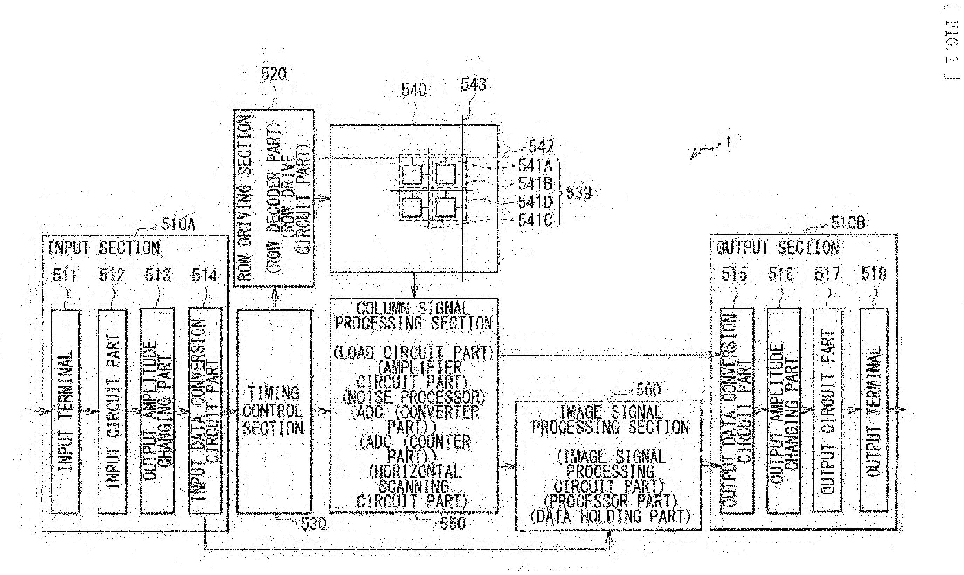

FIG. 1 is a block diagram illustrating an example of a functional configuration of an imaging device (an imaging device 1) according to a first embodiment of the present disclosure.

The imaging device 1 in FIG. 1 includes, for example, an input section 510A, a row driving section 520, a timing control section 530, a pixel array section 540, a column signal processing section 550, an image signal processing section 560, and an output section 510B.

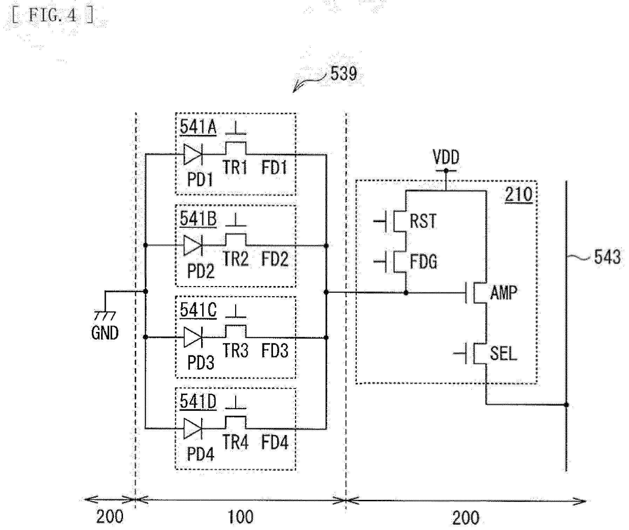

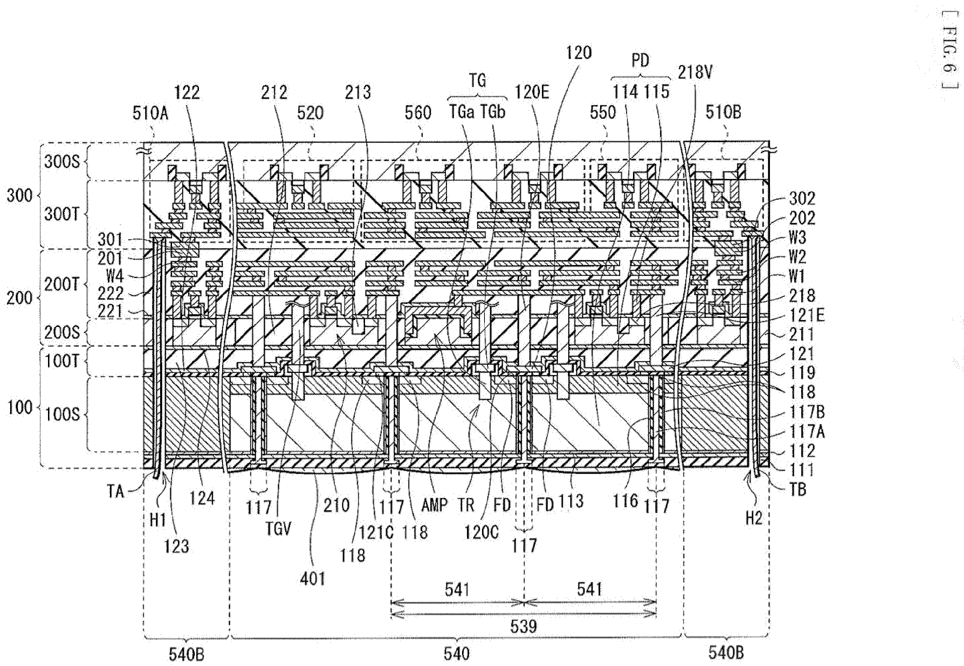

In the pixel array section 540, pixels 541 are repeatedly arranged in an array. More specifically, pixel sharing units 539 each including a plurality of pixels are repeating units, and are repeatedly arranged in an array in a row direction and a column direction. It is to be noted that, in the present specification, for the sake of convenience, the row direction and the column direction orthogonal to the row direction are sometimes referred to as an "H direction" and a "V direction", respectively. In an example in FIG. 1, one pixel sharing unit 539 includes four pixels (pixels 541A, 541B, 541C, and 541D). The pixels 541A, 541B, 541C, and 541D each include a photodiode PD (illustrated in FIG. 6 and the like described later). The pixel sharing unit 539 is a unit sharing one pixel circuit (a pixel circuit 210 in FIG. 4 described later). In other words, one pixel circuit (the pixel circuit 210 described later) is included for every four pixels (the pixels 541A, 541B, 541C, and 541D). The pixel circuit is driven in a time division manner to sequentially read pixel signals of the respective pixels 541A, 541B, 541C, and 541D. The pixels 541A, 541B, 541C, and 541D are arranged in two rows by two columns, for example. The pixel array section 540 includes a plurality of row drive signal lines 542 and a plurality of vertical signal lines (column readout lines) 543 together with the pixels 541A, 541B, 541C, and 541D. The row drive signal lines 542 drive the pixels 541 that are included in the plurality of pixel sharing units 539 and arranged in the row direction in the pixel array section 540. The row drive signal lines 542 drive each of pixels arranged in the row direction in the pixel sharing units 539. As described in detail later with reference to FIG. 4, a plurality of transistors is provided in the pixel sharing unit 539. In order to drive each of the plurality of transistors, a plurality of row drive signal lines 542 is coupled to one pixel sharing unit 539. The pixel sharing units 539 are coupled to the vertical signal lines (column readout lines) 543. The pixel signals are read from the respective pixels 541A, 541B, 541C, and 541D included in the pixel sharing units 539 through the vertical signal lines (column readout lines) 543.

The row driving section 520 includes, for example, a row address control part that determines the position of a row for driving pixels, that is, a row decoder part, and a row drive circuit part that generates a signal for driving the pixels 541A, 541B, 541C, and 541D.

The column signal processing section 550 is coupled to, for example, the vertical signal lines 543, and includes a load circuit part that forms a source follower circuit with the pixels 541A, 541B, 541C, and 541D (the pixel sharing unit 539). The column signal processing section 550 may include an amplifier circuit part that amplifies a signal read from the pixel sharing unit 539 through the vertical signal line 543. The column signal processing section 550 may include a noise processor. The noise processor removes, for example, a noise level of a system from a signal read as a result of photoelectric conversion from the pixel sharing unit 539.

The column signal processing section 550 includes, for example, an analog-to-digital converter (ADC). The analog-to-digital converter converts a signal read from the pixel sharing unit 539 or an analog signal having been subjected to noise processing described above into a digital signal. The ADC includes, for example, a comparator part and a counter part. The comparator part compares an analog signal as a conversion target with a reference signal as a comparison target. The counter part measures time until inverting a comparison result in the comparator part. The column signal processing section 550 may include a horizontal scanning circuit part that controls scanning of readout columns.

The timing control section 530 supplies a signal that controls atiming to the row driving section 520 and the column signal processing section 550 on the basis of a reference clock signal and a timing control signal inputted to the device.

The image signal processing section 560 is a circuit that performs various types of signal processing on data obtained as a result of photoelectric conversion, that is, data obtained as a result of an imaging operation in the imaging device 1. The image signal processing section 560 includes, for example, an image signal processing circuit part and a data holding part. The image signal processing section 560 may include a processor part.

One example of the signal processing to be executed in the image signal processing section 560 is tone curve correction processing in which gray scales are increased in a case where AD-converted imaging data is data obtained by shooting a dark subject, and gray scales are decreased in a case where the AD-converted imaging data is data obtained by shooting a bright subject. In this case, it is desirable that characteristic data of tone curves about which tone curve is to be used to correct gray scales of imaging data be stored in advance in a data holding part of the image signal processing section 560.

The input section 510A inputs, for example, the reference clock signal, the timing control signal, characteristic data, and the like described above from outside the device to the imaging device 1. Examples of the timing control signal include a vertical synchronization signal, a horizontal synchronization signal, and the like. The characteristic data is to be stored in the data holding part of the image signal processing section 560, for example. The input section 510A includes, for example, an input terminal 511, an input circuit part 512, an input amplitude changing part 513, an input data conversion circuit part 514, and a power supply part (unillustrated).

The input terminal 511 is an external terminal for inputting data. The input circuit part 512 takes a signal inputted to the input terminal 511 into the imaging device 1. The input amplitude changing part 513 changes amplitude of the signal taken by the input circuit part 512 into amplitude easy to be used inside the imaging device 1. The input data conversion circuit part 514 changes the order of data columns of input data. The input data conversion circuit part 514 includes, for example, a serial-parallel conversion circuit. The serial-parallel conversion circuit converts a serial signal received as input data into a parallel signal. It is to be noted that in the input section 510A, the input amplitude changing part 513 and the input data conversion circuit part 514 may be omitted. The power supply part supplies power that is set to various types of voltages necessary inside the imaging device 1, with use of power supplied from outside to the imaging device 1.

When the imaging device 1 is coupled to an external memory device, a memory interface circuit that receives data from the external memory device may be provided in the input section 510A. Examples of the external memory device include a flash memory, an SRAM, a DRAM, and the like.

The output section 510B outputs image data to the outside of the device. Examples of the image data include image data captured by the imaging device 1, image data having been subjected to signal processing by the image signal processing section 560, and the like. The output section 510B includes, for example, an output data conversion circuit part 515, an output amplitude changing part 516, an output circuit part 517, and an output terminal 518.

The output data conversion circuit part 515 includes, for example, a parallel-serial conversion circuit. The output data conversion circuit part 515 converts a parallel signal used inside the imaging device 1 into a serial signal. The output amplitude changing part 516 changes amplitude of a signal used inside the imaging device 1. The signal having changed amplitude is easily used in an external device coupled to the outside of the imaging device 1. The output circuit part 517 is a circuit that outputs data from inside the imaging device 1 to the outside of the device, and the output circuit part 517 drives a wiring line outside the imaging deice 1 coupled to the output terminal 518. At the output terminal 518, data is outputted from the imaging device 1 to the outside of the device. In the output section 510B, the output data conversion circuit part 515 and the output amplitude changing part 516 may be omitted.

When the imaging device 1 is coupled to an external memory device, the output section 510B may include a memory interface circuit that outputs data to the external memory device. Examples of the external memory device include a flash memory, an SRAM, a DRAM, and the like.

### [Outline Configuration of Imaging Device 1]

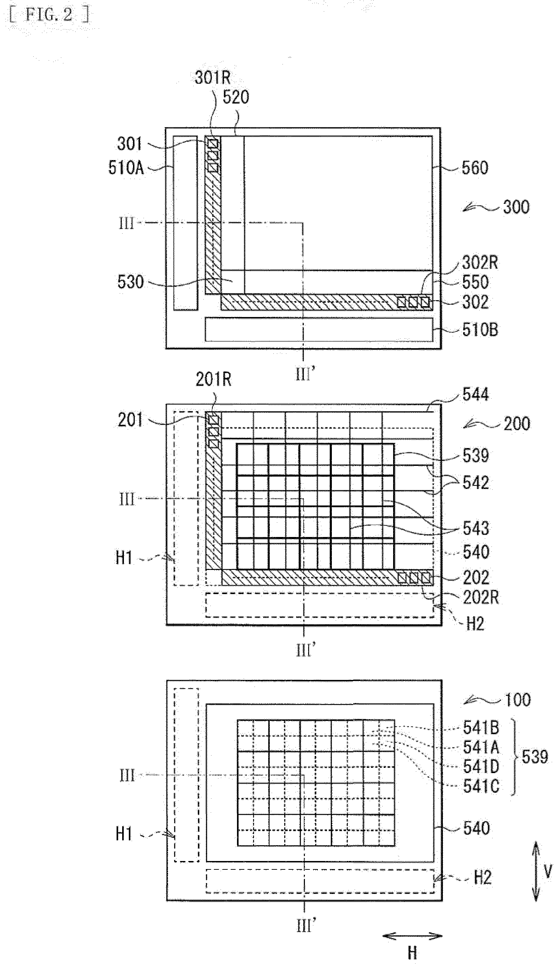

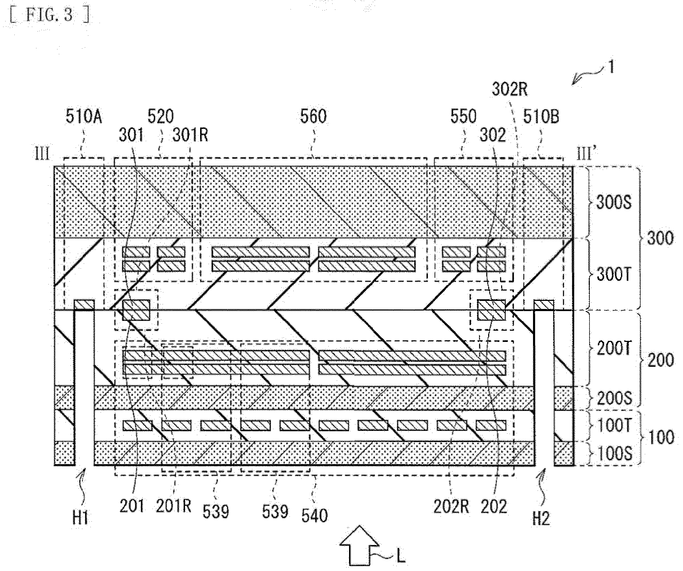

FIGs. 2 and 3 each illustrate an example of an outline configuration of the imaging device 1. The imaging device 1 includes three substrates (a first substrate 100, a second substrate 200, and a third substrate 300). FIG. 2 schematically illustrates a planar configuration of each of the first substrate 100, the second substrate 200, and the third substrate 300, and FIG. 3 schematically illustrates a cross-sectional configuration of the first substrate 100, the second substrate 200, and the third substrate 300 that are stacked on each other. FIG. 3 corresponds to a cross-sectional configuration taken along a line III-III' illustrated in FIG. 2. The imaging device 1 is a three-dimensionally structured imaging device in which the three substrates (the first substrate 100, the second substrate 200, and the third substrate 300) are attached together. The first substrate 100 includes a semiconductor layer 100S and a wiring layer 100T. The second substrate 200 includes a semiconductor layer 200S and a wiring layer 200T. The third substrate 300 includes a semiconductor layer 300S and a wiring layer 300T. Here, for the sake of convenience, a combination of a wiring line included in each of the first substrate 100, the second substrate 200, and the third substrate 300 and its surrounding interlayer insulating film is referred to as a wiring layer (100T, 200T, or 300T) provided in each substrate (each of the first substrate 100, the second substrate 200, and the third substrate 300). The first substrate 100, the second substrate 200, and the third substrate 300 are stacked in this order, and the semiconductor layer 100S, the wiring layer 100T, the semiconductor layer 200S, the wiring layer 200T, the wiring layer 300T, and the semiconductor layer 300S are disposed in this order along a stacking direction. Specific configurations of the first substrate 100, the second substrate 200, and the third substrate 300 are described later. An arrow illustrated in FIG. 3 indicates an incident direction of light L onto the imaging device 1. In the present specification, for the sake of convenience, in the following cross-sectional views, light incident side in the imaging device 1 is sometimes referred to as "bottom", "lower side", or "below", and side opposite to the light incident side is sometimes referred to as "top", "upper side", or "above". In addition, in the present specification, for the sake of convenience, in a substrate including a semiconductor layer and a wiring layer, side of the wiring layer is sometimes referred to as a front surface, and side of the semiconductor layer is sometimes referred to as a back surface. It is to be noted that references in the specification are not limited to those described above. The imaging device 1 is, for example, a back-illuminated imaging device in which light enters from back surface side of the first substrate 100 including a photodiode.

The pixel array section 540 and the pixel sharing units 539 included in the pixel array section 540 are both configured with use of both the first substrate 100 and the second substrate 200. The first substrate 100 includes a plurality of pixels 541A, 541B, 541C, and 541D included in the pixel sharing units 539. Each of the pixels 541 includes a photodiode (photodiode PD described later) and a transfer transistor (transfer transistor TR described later). The second substrate 200 includes pixel circuits (pixel circuits 210 described later) included in the pixel sharing units 539. The pixel circuit reads the pixel signal transferred from the photodiode of each of the pixels 541A, 541B, 541C, and 541D through a transfer transistor, or resets the photodiode. The second substrate 200 includes, in addition to such pixel circuits, a plurality of row drive signal lines 542 extending in the row direction and a plurality of vertical signal lines 543 extending in the column direction. The second substrate 200 further includes a power supply line 544 (a power supply line VDD described later and the like) extending in the row direction. The third substrate 300 includes, for example, the input section 5 10A, the row driving section 520, the timing control section 530, the column signal processing section 550, the image signal processing section 560, and the output section 510B. The row driving section 520 is provided in, for example, a region partially overlapping the pixel array section 540 in a stacking direction of the first substrate 100, the second substrate 200, and the third substrate 300 (hereinafter simply referred to as a stacking direction). More specifically, the row driving section 520 is provided in a region overlapping the vicinity of an end portion in an H direction of the pixel array section 540 in the stacking direction (FIG. 2). The column signal processing section 550 is provided in, for example, a region partially overlapping the pixel array section 540 in the stacking direction. More specifically, the column signal processing section 550 is provided in a region overlapping the vicinity of an end portion in a V direction of the pixel array section 540 in the stacking direction (FIG. 2). Although illustration is omitted, the input section 510A and the output section 510B may be disposed in a portion other than the third substrate 300, and may be disposed in the second substrate 200, for example. Alternatively, the input section 510A and the output section 510B may be provided on the back surface (light incident surface) side of the first substrate 100. It is to be noted that the pixel circuit provided in the second substrate 200 described above is also referred to as a pixel transistor circuit, a pixel transistor group, a pixel transistor, a pixel readout circuit, or a readout circuit, as another designation. In the present specification, the designation of "pixel circuit" is used.

The first substrate 100 and the second substrate 200 are electrically coupled to each other by, for example, a through-electrode (through-electrodes 120E and 121E in FIG. 6 described later). The second substrate 200 and the third substrate 300 are electrically coupled to each other through, for example, contact sections 201, 202, 301, and 302. The second substrate 200 is provided with the contact sections 201 and 202, and the third substrate 300 is provided with the contact sections 301 and 302. The contact section 201 of the second substrate 200 is in contact with the contact section 301 of the third substrate 300, and the contact section 202 of the second substrate 200 is in contact with the contact section 302 of the third substrate 300. The second substrate 200 includes a contact region 201R provided with a plurality of contact sections 201 and a contact region 202R provided with a plurality of contact sections 202. The third substrate 300 includes a contact region 301R provided with a plurality of contact sections 301 and a contact region 302R provided with a plurality of contact sections 302. The contact regions 201R and 301R are provided in the stacking direction between the pixel array section 540 and the row driving section 520 (FIG. 3). In other words, the contact regions 201R and 301R are provided in, for example, a region where the row driving section 520 (the third substrate 300) and the pixel array section 540 (the second substrate 200) are overlapped on each other in the stacking direction, or a region close to the region. The contact regions 201R and 301R are disposed in an end portion in the H direction of such a region, for example (FIG. 2). In the third substrate 300, the contact region 301R is provided, for example, in a portion of the row driving section 520, specifically at a position overlapped on an end portion in the H direction of the row driving section 520 (FIGs. 2 and 3). The contact sections 201 and 301 couple, for example, the row driving section 520 provided in the third substrate 300 and the row drive signal line 542 provided in the second substrate 200 to each other. The contact sections 201 and 301 may couple, for example, the input section 510A provided in the third substrate 300 to the power supply line 544 and a reference potential line (a reference potential line VSS described later). The contact regions 202R and 302R are provided in the stacking direction between the pixel array section 540 and the column signal processing section 550 (FIG. 3). In other words, the contact regions 202R and 302R are provided in, for example, a region overlapped on the column signal processing section 550 (the third substrate 300) and the pixel array section 540 (the second substrate 200) in the stacking direction, or a region close to the region. The contact regions 202R and 302R are disposed in an end portion in the V direction of such a region (FIG. 2). In the third substrate 300, the contact region 302R is provided in, for example, a portion of the column signal processing section 550, specifically at a position overlapped on an end portion in the V direction of the column signal processing section 550 (FIGs. 2 and 3). The contact sections 202 and 302 couple, for example, a pixel signal outputted from each of the plurality of pixel sharing units 539 included in the pixel array section 540 (a signal corresponding to the amount of electric charge generated as a result of photoelectric conversion by the photodiode) to the column signal processing section 550 provided in the third substrate 300. The pixel signal is transmitted from the second substrate 200 to the third substrate 300.

FIG. 3 is an example of a cross-sectional view of the imaging device 1 as described above. The first substrate 100, the second substrate 200, and the third substrate 300 are electrically coupled to each other through the wiring layers 100T, 200T, and 300T. For example, the imaging device 1 includes an electrical coupling section that electrically couples the second substrate 200 and the third substrate 300 to each other. Specifically, the contact sections 201, 202, 301, and 302 are each formed with use of an electrode formed by an electrically-conductive material. The electrically-conductive material is formed by, for example, a metal material such as copper (Cu), aluminum (Al), and gold (Au). The contact regions 201R, 202R, 301R, and 302R electrically couple the second substrate and the third substrate to each other by directly bonding wiring lines formed as electrodes, for example, which makes it possible to input and/or output signals to and from the second substrate 200 and the third substrate 300.

It is possible to provide, at a desired position, the electrical coupling section that electrically couples the second substrate 200 and the third substrate 300 to each other. For example, as described as the contact regions 201R, 202R, 301R, and 302R in FIG. 3, the electrical coupling section may be provided in a region overlapped on the pixel array section 540 in the stacking direction. In addition, the electrical coupling section may be provided in a region not overlapped on the pixel array section 540 in the stacking direction. Specifically, the electrical coupling section may be provided in a region overlapped in the stacking direction on a peripheral part disposed outside the pixel array section 540.

The first substrate 100 and the second substrate 200 are provided with a coupling hole sections H1 and H2, for example. The coupling hole sections H1 and H2 penetrate the first substrate 100 and the second substrate 200 (FIG. 3). The coupling hole sections H1 and H2 are provided outside the pixel array section 540 (or a portion overlapped on the pixel array section 540) (FIG. 2). For example, the coupling hole section H1 is disposed in the H direction outside the pixel array section 540, and the coupling hole section H2 is disposed in the V direction outside the pixel array section 540. For example, the coupling hole section H1 reaches the input section 510A provided in the third substrate 300, and the coupling hole section H2 reaches the output section 510B provided in the third substrate 300. The coupling hole sections H1 and H2 may be hollows, or may at least partially include an electrically-conductive material. For example, there is a configuration in which a bonding wire is coupled to an electrode formed as the input section 510A and/or the output section 510B. Alternatively, there is a configuration in which the electrode formed as the input section 510A and/or the output section 510B and the electrically-conductive material provided in the coupling hole sections H1 and H2 are coupled to each other. The electrically-conductive material provided in the coupling hole sections H1 and H2 may be embedded in a portion or the entirety of the coupling hole sections H1 and H2, or the electrically-conductive material may be formed on a sidewall of each of the coupling hole sections H1 and H2.

It is to be noted that FIG. 3 illustrates a structure in which the third substrate 300 is provided with the input section 510A and the output section 510B, but this is not limitative. For example, transmitting a signal of the third substrate 300 to the second substrate 200 through the wiring layers 200T and 300T makes it possible to provide the input section 510A and/or the output section 510B in the second substrate 200. Likewise, transmitting a signal of the second substrate 200 to the first substrate 100 through the wiring layers 100T and 200T makes it possible to provide the input section 510A and/or the output section 510B in the first substrate 100.

FIG. 4 is an equivalent circuit diagram illustrating an example of a configuration of the pixel sharing unit 539. The pixel sharing unit 539 includes a plurality of pixels 541 (FIG. 4 illustrates four pixels 541, that is, the pixels 541A, 541B, 541C, and 541D), one pixel circuit 210 coupled to the plurality of pixels 541, and the vertical signal line 543 coupled to the pixel circuit 210. The pixel circuit 210 includes, for example, four transistors, specifically, an amplification transistor AMP, a selection transistor SEL, a reset transistor RST, and an FD conversion gain switching transistor FDG. As described above, the pixel sharing unit 539 drives one pixel circuit 210 in a time division manner to sequentially output pixel signals of the four pixels 541 (the pixels 541A, 541B, 541C, and 541D) included in the pixel sharing unit 539 to the vertical signal line 543. One pixel circuit 210 is coupled to the plurality of pixels 541, and a mode in which the pixel signals of the plurality of pixels 541 are outputted by one pixel circuit 210 in a time division manner refers to "one pixel circuit 210 is shared by the plurality of pixels 541".

The pixels 541A, 541B, 541C, and 541D include components common to each other. Hereinafter, in orderto distinguish components ofthe pixels 541A, 541B, 541C, and 541D from one another, an identification number 1 is assigned at the end of a symbol of the component of the pixel 541A, an identification number 2 is assigned at the end of a symbol of the component of the pixel 541B, an identification number 3 is assigned at the end of a symbol of the component of the pixel 541C, and an identification number 4 is assigned at the end of a symbol of the component of the pixel 541D. In a case where the components of the pixels 541A, 541B, 541C, and 541D do not need to be distinguished from one another, the identification number at the end of the symbol of the component of each of the pixels 541A, 541B, 541C, and 541D is omitted.

The pixels 541A, 541B, 541C, and 541D each include, for example, the photodiode PD, the transfer transistor TR electrically coupled to the photodiode PD, and a floating diffusion FD electrically coupled to the transfer transistor TR. In the photodiode PD (PD1, PD2, PD3, and PD4), a cathode is electrically coupled to a source of the transfer transistor TR, and an anode is electrically coupled to a reference potential line (e.g., a ground). The photodiode PD photoelectrically converts incident light, and generates electric charge corresponding to the amount of received light. The transfer transistor TR (transfer transistors TR1, TR2, TR3, and TR4) is, for example, an n-type CMOS (Complementary Metal Oxide Semiconductor) transistor. In the transfer transistor TR, a drain is electrically coupled to the floating diffusion FD, and a gate is electrically coupled to a drive signal line. The drive signal line is some of the plurality of row drive signal lines 542 (see FIG. 1) coupled to one pixel sharing unit 539. The transfer transistor TR transfers electric charge generated by the photodiode PD to the floating diffusion FD. The floating diffusion FD (floating diffusions FD1, FD2, FD3, and FD4) is an n-type diffusion layer region formed in a p-type semiconductor layer. The floating diffusion FD is an electric charge holding means that temporarily holds electric charge transferred from the photodiode PD, as well as an electric charge-voltage conversion means that generates a voltage corresponding to the amount of the electric charge.

The four floating diffusions FD (the floating diffusions FD1, FD2, FD3, and FD4) included in one pixel sharing unit 539 are electrically coupled to one another, and are electrically coupled to a gate of the amplification transistor AMP and a source of the FD conversion gain switching transistor FDG. A drain of the FD conversion gain switching transistor FDG is coupled to a source of the reset transistor RST, and a gate of the FD conversion gain switching transistor FDG is coupled to a drive signal line. The drive signal line is some of the plurality of row drive signal lines 542 coupled to the one pixel sharing unit 539. A drain of the reset transistor RST is coupled to the power supply line VDD, and a gate of the reset transistor RST is coupled to a drive signal line. The drive signal line is some of the plurality of row drive signal lines 542 coupled to the one pixel sharing unit 539. A gate of the amplification transistor AMP is coupled to the floating diffusion FD, a drain of the amplification transistor AMP is coupled to the power supply line VDD, and a source of the amplification transistor AMP is coupled to a drain of the selection transistor SEL. A source of the selection transistor SEL is coupled to the vertical signal line 543, and a gate of the selection transistor SEL is coupled to a drive signal line. The drive signal line is some of the plurality of row drive signal lines 542 coupled to the one pixel sharing unit 539.

When the transfer transistor TR is brought into an ON state, the transfer transistor TR transfers electric charge of the photodiode PD to the floating diffusion FD. The gate (transfer gate TG) of the transfer transistor TR includes, for example, a so-called vertical electrode, and is provided to extend from a front surface of a semiconductor layer (semiconductor layer 100S in FIG. 6 described later) to a depth reaching the PD, as illustrated in FIG. 6 described later. The reset transistor RST resets the potential of the floating diffusion FD to a predetermined potential. When the reset transistor RST is brought into an ON state, the potential of the floating diffusion FD is reset to the potential of the power supply line VDD. The selection transistor SEL controls an output timing of the pixel signal from the pixel circuit 210. The amplification transistor AMP generates, as the pixel signal, a signal of a voltage corresponding to the level of electric charge held by the floating diffusion FD. The amplification transistor AMP is coupled to the vertical signal line 543 through the selection transistor SEL. The amplification transistor AMP configures a source follower together with a load circuit part (see FIG. 1) coupled to the vertical signal line 543 in the column signal processing section 550. When the selection transistor SEL is brought into an ON state, the amplification transistor AMP outputs the voltage of the floating diffusion FD to the column signal processing section 550 through the vertical signal line 543. The reset transistor RST, the amplification transistor AMP, and the selection transistor SEL are, for example, N-type CMOS transistors.

The FD conversion gain switching transistor FDG is used in changing a gain of electric charge-voltage conversion in the floating diffusion FD. In general, a pixel signal is small when shooting in a dark place. In performing electric charge-voltage conversion on the basis of Q = CV, larger capacity of the floating diffusion FD (FD capacity C) causes the value V to be smaller upon conversion to a voltage at the amplification transistor AMP. Meanwhile, the pixel signal becomes large in a bright place; it is therefore not possible, for the floating diffusion FD, to receive the electric charge of the photodiode PD unless the FD capacity C is large. Further, the FD capacity C needs to be large to allow the value V not to be too large (in other words, to be small) upon the conversion to a voltage at the amplification transistor AMP. Taking these into account, when the FD conversion gain switching transistor FDG is 0047n, a gate capacity for the FD conversion gain switching transistor FDG is increased, thus causing the entire FD capacity C to be large. Meanwhile, when the FD conversion gain switching transistor FDG is turned off, the entire FD capacity C becomes small. In this manner, performing ON/OFF switching of the FD conversion gain switching transistor FDG enables the FD capacity C to be variable, thus making it possible to switch conversion efficiency. The FD conversion gain switching transistor FDG is, for example, an N-type CMOS transistor.

It is to be noted that a configuration is also possible in which the FD conversion gain switching transistor FDG is not provided. At this time, the pixel circuit 210 includes, for example, three transistors, that is, the amplification transistor AMP, the selection transistor SEL, and the reset transistor RST. The pixel circuit 210 includes, for example, at least one of the amplification transistor AMP, the selection transistor SEL, the reset transistor RST, the FD conversion gain switching transistor FDG, or the like.

The selection transistor SEL may be provided between the power supply line VDD and the amplification transistor AMP. In this case, the drain of the reset transistor RST is electrically coupled to the power supply line VDD and the drain of the selection transistor SEL. The source of the selection transistor SEL is electrically coupled to the drain of the amplification transistor AMP, and the gate of the selection transistor SEL is electrically coupled to the row drive signal line 542 (see FIG. 1). The source (an output end of the pixel circuit 210) of the amplification transistor AMP is electrically coupled to the vertical signal line 543, and the gate of the amplification transistor AMP is electrically coupled to the source of the reset transistor RST. It is to be noted that, although illustration is omitted, the number of pixels 541 sharing one pixel circuit 210 may be other than four. For example, two or eight pixels 541 may share one pixel circuit 210.

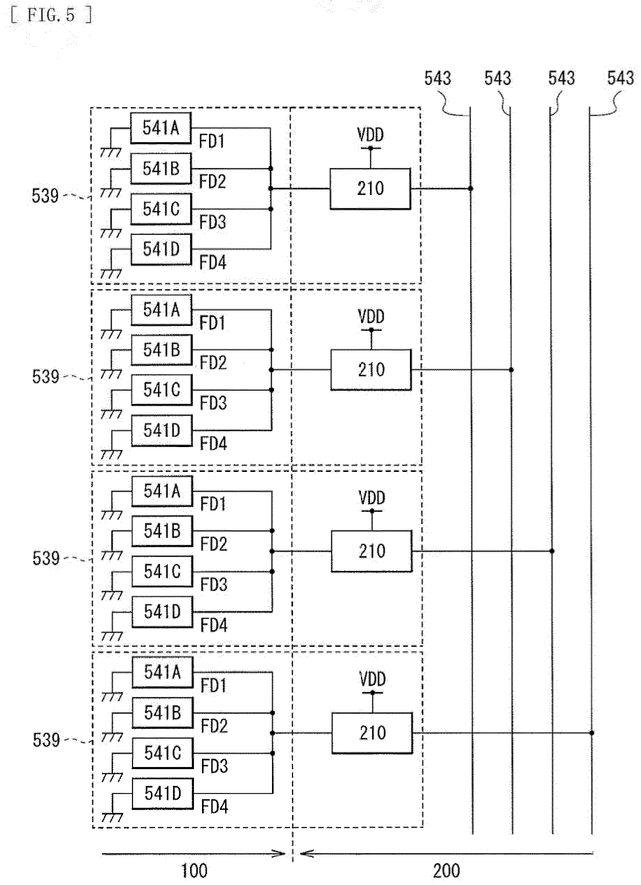

FIG. 5 illustrates an example of a coupling mode between a plurality of pixel sharing units 539 and the vertical signal lines 543. For example, four pixel sharing units 539 arranged in the column direction are divided into four groups, and the vertical signal line 543 is coupled to each of the four groups. For ease of explanation, FIG. 5 illustrates an example in which each of the four groups include one pixel sharing unit 539; however, each of the four groups may include a plurality of pixel sharing units 539. As described above, in the imaging device 1, the plurality of pixel sharing units 539 arranged in the column direction may be divided into groups including one or a plurality of pixel sharing units 539. For example, the vertical signal line 543 and the column signal processing section 550 are coupled to each of the groups, which makes it possible to simultaneously read the pixel signals from the respective groups. Alternatively, in the imaging device 1, one vertical signal line 543 may be coupled to the plurality of pixel sharing units 539 arranged in the column direction. At this time, the pixel signals are sequentially read from the plurality of pixel sharing units 539 coupled to the one vertical signal line 543 in a time division manner.

### [Specific Configuration of Imaging Device 1]

FIG. 6 illustrates an example of a cross-sectional configuration in a vertical direction with respect to a main surface of the first substrate 100, the second substrate 200, and the third substrate 300 of the imaging device 1. FIG. 6 schematically illustrates a positional relationship of components for ease of understanding, and may be different from an actual cross-section. In the imaging device 1, the first substrate 100, the second substrate 200, and the third substrate 300 are stacked in this order. The imaging device 1 further includes a light-receiving lens 401 on back surface side (light incident surface side) of the first substrate 100. A color filter layer (unillustrated) may be provided between the light-receiving lens 401 and the first substrate 100. The light-receiving lens 401 is provided for each of the pixels 541A, 541B, 541C, and 541D, for example. The imaging device 1 is, for example, a back-illuminated imaging device. The imaging device 1 includes the pixel array section 540 disposed in a middle part and a peripheral part 540B disposed outside the pixel array section 540.

The first substrate 100 includes an insulating film 111, a fixed charge film 112, the semiconductor layer 100S, and the wiring layer 100T in order from side of the light-receiving lens 401. The semiconductor layer 100S includes, for example, a silicon substrate. The semiconductor layer 100S includes, for example, a p-well layer 115 in a portion of the front surface (a surface on side of the wiring layer 100T) and its vicinity, and includes an n-type semiconductor region 114 in a region other than the p-well layer 115 (a region deeper than the p-well layer 115). For example, the n-type semiconductor region 114 and the p-well layer 115 are included in the pn-junction photodiode PD. The p-well layer 115 is a p-type semiconductor region.

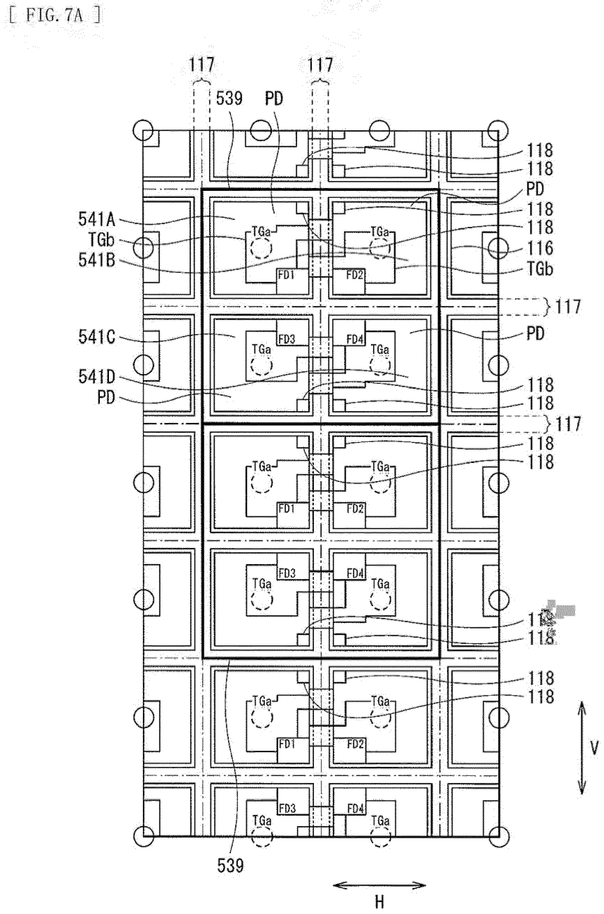

FIG. 7A illustrates an example of a planar configuration of the first substrate 100. FIG. 7A mainly illustrates a planar configuration of a pixel separation section 117, the photodiode PD, the floating diffusion FD, a VSS contact region 118, and the transfer transistor TR of the first substrate 100. Description is given of the configuration of the first substrate 100 with use of FIG. 7A together with FIG. 6.

The floating diffusion FD and the VSS contact region 118 are provided in the vicinity of the front surface of the semiconductor layer 100S. The floating diffusion FD includes an n-type semiconductor region provided in the p-well layer 115. The floating diffusions FD (the floating diffusions FD1, FD2, FD3, and FD4) of the pixels 541A, 541B, 541C, and 541D are provided close to each other in a middle part of the pixel sharing unit 539, for example (FIG. 7A). As described in detail later, the four floating diffusions (floating diffusions FD1, FD2, FD3, and FD4) included in the pixel sharing unit 539 are electrically coupled to each other through an electrical coupling means (a pad section 120 described later) in the first substrate (more specifically, inside the wiring layer 100T). Further, the floating diffusions FD are coupled from the first substrate 100 to the second substrate 200 (more specifically, from the wiring layer 100T to the wiring layer 200T) through an electrical means (a through-electrode 120E described later). In the second substrate 200 (more specifically, inside the wiring layer 200T), the floating diffusions FD are electrically coupled to the gate of the amplification transistor AMP and the source of the FD conversion gain switching transistor FDG by the electrical means.

The VSS contact region 118 is a region electrically coupled to the reference potential line VSS, and is disposed apart from the floating diffusion FD. For example, in the pixels 541A, 541B, 541C, and 541D, the floating diffusion FD is disposed at one end in the V direction of each pixel, and the VSS contact region 118 is disposed at another end (FIG. 7A). The VSS contact region 118 includes, for example, a p-type semiconductor region. The VSS contact region 118 is coupled to a ground potential and a fixed potential, for example. Thus, a reference potential is supplied to the semiconductor layer 100S.

The first substrate 100 includes the transfer transistor TR together with the photodiode PD, the floating diffusion FD, and the VSS contact region 118. The photodiode PD, the floating diffusion FD, the VSS contact region 118, and the transfer transistor TR are provided in each of the pixels 541A, 541B, 541C, and 541D. The transfer transistor TR is provided on front surface side (side opposite to the light incident surface side, side of the second substrate 200) of the semiconductor layer 100S. The transfer transistor TR includes the transfer gate TG. The transfer gate TG includes, for example, a horizontal portion TGb opposed to the front surface of the semiconductor layer 100S, and a vertical portion TGa provided inside the semiconductor layer 100S. The vertical portion TGa extends in a thickness direction of the semiconductor layer 100S. The vertical portion TGa has one end in contact with the horizontal portion TGb, and another end provided inside the n-type semiconductor region 114. The transfer transistor TR is configured using such a vertical transistor, which hinders occurrence of a failure in transferring the pixel signal, thus making it possible to enhance readout efficiency of the pixel signal.

The horizontal portion TGb of the transfer gate TG extends from a position opposed to the vertical portion TGa toward, for example, the middle part of the pixel sharing unit 539 in the H direction (FIG. 7A). This makes it possible to bring the position in the H direction of a through-electrode (a through-electrode TGV described later) reaching the transfer gate TG close to the position in the H direction of a through-electrode (through-electrodes 120E and 121E described later) coupled to the floating diffusion FD and the VSS contact region 118. For example, the plurality of pixel sharing units 539 provided in the first substrate 100 have the same configuration as each other (FIG. 7A).

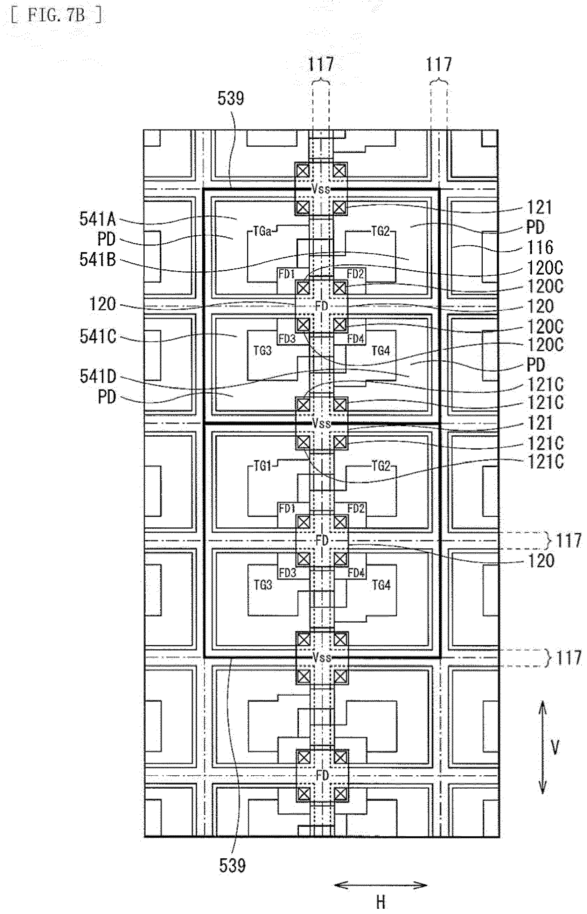

The semiconductor layer 100S includes the pixel separation section 117 that separates the pixels 541A, 541B, 541C, and 541D from each other. The pixel separation section 117 is formed to extend in a direction normal to the semiconductor layer 100S (a direction perpendicular to the front surface of the semiconductor layer 100S). The pixel separation section 117 is provided to partition the pixels 541A, 541B, 541C, and 541D from each other, and has, for example, a planar grid shape (FIGs. 7A and 7B). The pixel separation section 117 electrically and optically separates, for example, the pixels 541A, 541B, 541C, and 541D from each other. The pixel separation section 117 includes, for example, a light-blocking film 117A and an insulating film 117B. For example, tungsten (W) or the like is used for the light-blocking film 117A. The insulating film 117B is provided between the light-blocking film 117A and the p-well layer 115 or the n-type semiconductor region 114. The insulating film 117B includes, for example, silicon oxide (SiO). The pixel separation section 117 has, for example, a FTI (Full Trench Isolation) structure, and penetrates the semiconductor layer 100S. Although not illustrated, the pixel separation section 117 is not limited to the FTI structure that penetrates the semiconductor layer 100S. For example, the pixel separation section 117 may have a DTI (Deep Trench Isolation) structure that does not penetrate the semiconductor layer 100S. The pixel separation section 117 extends in the direction normal to the semiconductor layer 100S, and is formed in a portion of a region of the semiconductor layer 100S.

The semiconductor layer 100S includes, for example, a first pinning region 113 and a second pinning region 116. The first pinning region 113 is provided close to the back surface of the semiconductor layer 100S, and is disposed between the n-type semiconductor region 114 and the fixed charge film 112. The second pinning region 116 is provided on the side surface of the pixel separation section 117, specifically, between the pixel separation section 117 and the p-well layer 115 or the n-type semiconductor region 114. The first pinning region 113 and the second pinning region 116 each include, for example, a p-type semiconductor region.

The fixed charge film 112 having negative fixed electric charge is provided between the semiconductor layer 100S and the insulating film 111. The first pinning region 113 of a hole accumulation layer is formed at an interface on side of a light-receiving surface (back surface) of the semiconductor layer 100S by an electric field induced by the fixed charge film 112. This suppresses generation of a dark current resulting from an interface state on the side of the light-receiving surface of the semiconductor layer 100S. The fixed charge film 112 is formed using, for example, an insulating film having negative fixed electric charge. Examples of a material of the insulating film having negative fixed electric charge include hafnium oxide, zirconium oxide, aluminum oxide, titanium oxide, and tantalum oxide.

The light-blocking film 117A is provided between the fixed charge film 112 and the insulating film 111. The light-blocking film 117A may be provided continuously to the light-blocking film 117A included in the pixel separation section 117. The light-blocking film 117A between the fixed charge film 112 and the insulating film 111 is selectively provided at a position opposed to the pixel separation section 117 in the semiconductor layer 100S, for example. The insulating film 111 is provided to cover the light-blocking film 117A. The insulating film 111 includes, for example, silicon oxide.

The wiring layer 100T provided between the semiconductor layer 100S and the second substrate 200 includes an interlayer insulating film 119, pad sections 120 and 121, a passivation film 122, an interlayer insulating film 123, and a bonding film 124 in this order from side of the semiconductor layer 100S. The horizontal portion TGb of the transfer gate TG is provided in the wiring layer 100T, for example. The interlayer insulating film 119 is provided throughout the front surface of the semiconductor layer 100S, and is in contact with the semiconductor layer 100S. The interlayer insulating film 119 includes, for example, a silicon oxide film. It is to be noted that the configuration of the wiring layer 100T is not limited to the configuration described above, and it is sufficient for the wiring layer 100T to have a configuration including a wiring line and an insulating film.

FIG. 7B illustrates configurations of the pad sections 120 and 121 together with the planar configuration illustrated in FIG. 7A. The pad sections 120 and 121 are provided in a selective region on the interlayer insulating film 119. The pad section 120 couples the floating diffusions FD (the floating diffusions FD1, FD2, FD3, and FD4) of the pixels 541A, 541B, 541C, and 541D to each other. The pad section 120 is disposed for each pixel sharing unit 539 in the middle part of the pixel sharing unit 539 in a plan view (FIG. 7B). The pad section 120 is provided to straddle the pixel separation section 117, and is disposed to be superimposed at least partially on each of the floating diffusions FD1, FD2, FD3, and FD4 (FIGs. 6 and 7B). Specifically, the pad section 120 is formed in a region overlapping at least a portion of each of the plurality of floating diffusions FD (the floating diffusions FD1, FD2, FD3, and FD4) sharing the pixel circuit 210 and at least a portion of the pixel separation section 117 formed between the plurality of photodiodes PD (the photodiodes PD1, PD2, PD3, and PD4) sharing the pixel circuit 210 in a direction perpendicular to the front surface of the semiconductor layer 100S. The interlayer insulating film 119 includes a coupling via 120C for electrically coupling the pad section 120 and the floating diffusions FD1, FD2, FD3, and FD4 to each other. The coupling via 120C is provided in each of the pixels 541A, 541B, 541C, and 541D. For example, a portion of the pad section120 is embedded in the coupling via 120C, thereby electrically coupling the pad section 120 and the floating diffusions FD1, FD2, FD3, and FD4 to each other.

The pad section 121 couples a plurality of VSS contact regions 118 to each other. For example, the VSS contact region 118 provided in the pixels 541C and 541D of one of the pixel sharing units 539 adjacent to each other in the V direction, and the VSS contact region 118 provided in the pixels 541A and 541B of another one of the pixel sharing units 539 are electrically coupled to each other by the pad section 121. The pad section 121 is provided to straddle the pixel separation section 117, for example, and is disposed to be superimposed at least partially on each of the four VSS contact regions 118. Specifically, the pad section 121 is formed in a region overlapping at least a portion of each of the plurality of VSS contact regions 118 and at least a portion of the pixel separation section 117 formed between the plurality of VSS contact regions 118 in a direction perpendicular to the front surface of the semiconductor layer 100S. The interlayer insulating film 119 includes a coupling via 121C for electrically coupling the pad section 121 and the VSS contact region 118 to each other. The coupling via 121C is provided in each of the pixels 541A, 541B, 541C, and 541D. For example, a portion of the pad section 121 is embedded in the coupling via 121C, thereby electrically coupling the pad section 121 and the VSS contact region 118 to each other. For example, the pad sections 120 and 121 of each of the plurality of pixel sharing units 539 arranged in the V direction are disposed at substantially the same position in the H direction (FIG. 7B).

Providing the pad section 120 makes it possible to reduce the number of wiring lines for coupling from each of the floating diffusions FD to the pixel circuit 210 (e.g., the gate electrode of the amplification transistor AMP) in the entirety of a chip. Likewise, providing the pad section 121 makes it possible to reduce the number of wiring lines that supply a potential to each of the VSS contact regions 118 in the entirety of the chip. This makes it possible to achieve a decrease in the area of the entire chip, suppression of electrical interference between wiring lines in a miniaturized pixel, cost reduction by reduction in the number of components, and/or the like.

It is possible to provide the pad sections 120 and 121 at desired positions of the first substrate 100 and the second substrate 200. Specifically, it is possible to provide the pad sections 120 and 121 in one of the wiring layer 100T or an insulating region 212 of the semiconductor layer 200S. In a case where the pad sections 120 and 121 are provided in the wiring layer 100T, the pad sections 120 and 121 may be in direct contact with the semiconductor layer 100S. Specifically, the pad sections 120 and 121 may have a configuration that is directly coupled to at least a portion of each of the floating diffusions FD and/or the VSS contact regions 118. In addition, a configuration may be adopted in which the coupling vias 120C and 121C are provided from each of the floating diffusions FD and/or the VSS contact regions 118 coupled to the pad sections 120 and 121, and the pad sections 120 and 121 are provided at desired positions of the wiring layer 100T and the insulating region 212 of the semiconductor layer 200S.

In particular, in a case where the pad sections 120 and 121 are provided in the wiring layer 100T, it is possible to reduce the number of wiring lines coupled to the floating diffusions FD and/or the VSS contact regions 118 in the insulating region 212 of the semiconductor layer 200S. This makes it possible to reduce the area of the insulating region 212, for forming a through-wiring line for coupling the floating diffusions FD to the pixel circuit 210, of the second substrate 200 forming the pixel circuit 210. This consequently makes it possible to secure a large area of the second substrate 200 forming the pixel circuit 210. Securing the area of the pixel circuit 210 makes it possible to form a large pixel transistor, and contribute to an enhancement in image quality resulting from noise reduction and the like.

In particular, in a case where the pixel separation section 117 uses a FTI structure, the floating diffusions FD and/or the VSS contact regions 118 are preferably provided in the respective pixels 541; therefore, using the configurations of the pad sections 120 and 121 makes it possible to significantly reduce the number of wiring lines that couple the first substrate 100 and the second substrate 200 to each other.

In addition, as illustrated in FIG. 7B, for example, the pad section 120 to which the plurality of floating diffusions FD is coupled and the pad section 121 to which the plurality of VSS contact regions 118 is coupled are alternately linearly arranged in the V direction. In addition, the pad sections 120 and 121 are formed at positions surrounded by a plurality of photodiodes PD, a plurality of transfer gates TG, and a plurality of floating diffusions FD. This makes it possible to freely dispose an element other than the floating diffusions FD and the VSS contact regions 118 in the first substrate 100 that forms a plurality of elements, and enhance efficiency of a layout of the entire chip. In addition, symmetry in a layout of elements formed in each of the pixel sharing units 539 is secured, which makes it possible to suppress dispersion in characteristics of the pixels 541.

The pad sections 120 and 121 include, for example, polysilicon (Poly Si), more specifically, doped polysilicon doped with impurities. The pad sections 120 and 121 preferably include an electrically-conductive material having high heat resistance such as polysilicon, tungsten (W), titanium (Ti), and titanium nitride (TiN). This makes it possible to form the pixel circuit 210 after attaching the semiconductor layer 200S of the second substrate 200 to the first substrate 100. A reason for this is described below. It is to be noted that, in the following description, a method of forming the pixel circuit 210 after attaching the first substrate 100 and the semiconductor layer 200S of the second substrate 200 is referred to as a first manufacturing method.

Here, a method may be conceivable in which the pixel circuit 210 is formed in the second substrate 200, and thereafter the pixel circuit 210 is attached to the first substrate 100 (which is hereinafter referred to as a second manufacturing method). In the second manufacturing method, an electrode for electrical coupling is formed in advance on each of the front surface of the first substrate 100 (the front surface of the wiring layer 100T) and the front surface of the second substrate 200 (the front surface of the wiring layer 200T). When the first substrate 100 and the second substrate 200 are attached together, the electrodes for electrical coupling formed on the front surface of the first substrate 100 and the front surface of the second substrate 200 are brought into contact with each other simultaneously with this. Thus, electrical coupling is formed between a wiring line included in the first substrate 100 and a wiring line included in the second substrate 200. Accordingly, the imaging device 1 is configured with use of the second manufacturing method, which makes it possible to manufacture the imaging device 1 with use of, for example, appropriate processes corresponding to the configuration of the first substrate 100 and the second substrates 200, and manufacture an imaging device having high quality and high performance.

In such a second manufacturing method, upon attaching the first substrate 100 and the second substrate 200 together, an error in alignment may be caused by a manufacturing apparatus for attaching. In addition, the first substrate 100 and the second substrate 200 each have, for example, a diameter of about several tens cm, and upon attaching the first substrate 100 and the second substrate 200 together, expansion and contraction of the substrate may occur in a microscopic region of each part of the first substrate 100 and the second substrate 200. The expansion and contraction of the substrate result from a slight deviation of a timing when the substrates come into contact with each other. An error may occur at the positions of the electrodes for electrical coupling formed on the front surface of the first substrate 100 and the front surface of the second substrate 200 due to such expansion and contraction of the first substrate 100 and the second substrate 200. In the second manufacturing method, it is preferable that the electrodes of the first substrate 100 and the second substrate 200 be in contact with each other even when such an error occurs. Specifically, at least one, preferably both of the electrodes of the first substrate 100 and the second substrate 200 are made large in consideration of the error described above. Accordingly, when the second manufacturing method is used, for example, the size (the size in a substrate plane direction) of the electrode formed on the front surface of the first substrate 100 or the second substrate 200 becomes larger than the size of an internal electrode extending in the thickness direction from the inside to the front surface of the first substrate 100 or the second substrate 200.

Meanwhile, the pad sections 120 and 121 include an electrically-conductive material having heat resistance, which makes it possible to use the first manufacturing method described above. In the first manufacturing method, after the first substrate 100 including the photodiode PD, the transfer transistor TR, and the like is formed, the first substrate 100 and the second substrate 200 (a semiconductor layer 2000S) are attached together. At this time, the second substrate 200 is in a state in which a pattern such as an active element and a wiring layer included in the pixel circuit 210 is not yet formed. The second substrate 200 is in a state before forming the pattern; therefore, even when an error occurs in an attaching position upon attaching the first substrate 100 and the second substrate 200 together, an error in alignment between a pattern of the first substrate 100 and the pattern of the second substrate 200 may not be caused by this attaching error. One reason for this is that the pattern of the second substrate 200 is formed after attaching the first substrate 100 and the second substrate 200 together. It is to be noted that, upon forming the pattern on the second substrate, for example, in an exposure apparatus for formation of the pattern, the pattern is formed to be aligned with the pattern formed in the first substrate. For this reason, the error in the attaching position between the first substrate 100 and the second substrate 200 is not an issue in manufacturing of the imaging device 1 in the first manufacturing method. For a similar reason, an error resulting from expansion and contraction of the substrate caused in the second manufacturing method is not an issue in manufacturing of the imaging device 1 as well in the first manufacturing method.

In the first manufacturing method, the active element is formed on the second substrate 200 in such a manner after attaching the first substrate 100 and the second substrate 200 (the semiconductor layer 200S) together. Thereafter, the through-electrodes 120E and 121E and the through-electrode TGV (FIG. 6) are formed. In the formation of the through-electrodes 120E, 121E, and TGV, for example, a pattern of a through-electrode is formed from above the second substrate 200 with use of reduction-projection exposure by an exposure apparatus. The reduction-projection exposure is used; therefore, even if an error occurs in alignment between the second substrate 200 and the exposure apparatus, magnitude of the error in the second substrate 200 is only a fraction (the inverse number of reduction-projection exposure magnification) of the error in the second manufacturing method described above. Accordingly, the imaging device 1 is configured with use of the first manufacturing method, which facilitates alignment between elements formed in each of the first substrate 100 and the second substrate 200, and makes it possible to manufacture an imaging device having high quality and high performance.

The imaging device 1 manufactured with use of such a first manufacturing method has characteristics different from those of an imaging device manufactured by the second manufacturing method. Specifically, in the imaging device 1 manufactured by the first manufacturing method, for example, the through-electrodes 120E, 121E, and TGV each have a substantially constant thickness (size in the substrate plane direction) from the second substrate 200 to the first substrate 100. Alternatively, when the through-electrodes 120E, 121E, and TGV each have a tapered shape, they have a tapered shape having a constant slope. In the imaging device 1 including such through-electrodes 120E, 121E, and TGV, the pixels 541 are easily miniaturized.

Here, when the imaging device 1 is manufactured by the first manufacturing method, the active element is formed in the second substrate 200 after attaching the first substrate 100 and the second substrate 200 (the semiconductor layer 200S) together; therefore, heating treatment necessary for formation of the active element also affects the first substrate 100. Accordingly, as described above, the pad sections 120 and 121 provided in the first substrate 100 preferably use an electrically-conductive material having higher heat resistance. For example, the pad sections 120 and 121 preferably use a material having a higher melting point (that is, higher heat resistance) than that of at least a portion of a wiring material included in the wiring layer 200T of the second substrate 200. For example, the pad sections 120 and 121 use an electrically-conductive material having high heat resistance such as doped polysilicon, tungsten, titanium, or titanium nitride. This makes it possible to manufacture the imaging device 1 with use of the first manufacturing method described above.

The passivation film 122 is provided throughout the entire front surface of the semiconductor layer 100S to cover the pad sections 120 and 121, for example, (FIG. 6). The passivation film 122 includes, for example, a silicon nitride (SiN) film. The interlayer insulating film 123 covers the pad sections 120 and 121 with the passivation film 122 interposed therebetween. The interlayer insulating film 123 is provided throughout the entire front surface of the semiconductor layer 100S, for example. The interlayer insulating film 123 includes, for example, a silicon oxide (SiO) film. The bonding film 124 is provided at a bonding surface between the first substrate 100 (specifically, the wiring layer 100T) and the second substrate 200. That is, the bonding film 124 is in contact with the second substrate 200. The bonding film 124 is provided throughout the entire main surface of the first substrate 100. The bonding film 124 includes, for example, a silicon nitride film or a silicon oxide film.

The light-receiving lens 401 is opposed to the semiconductor layer 100S with the fixed charge film 112 and the insulating film 111 interposed therebetween, for example (FIG. 6). The light-receiving lens 401 is provided at a position opposed to the photodiode PD of each of the pixels 541A, 541B, 541C, and 541D, for example.

The second substrate 200 includes the semiconductor layer 200S and the wiring layer 200T in order from side of the first substrate 100. The semiconductor layer 200S includes, for example, a silicon substrate. In the semiconductor layer 200S, a well region 211 is provided in the thickness direction. The well region 211 is, for example, a p-type semiconductor region. In the second substrate 200, the pixel circuit 210 disposed for each of the pixel sharing units 539 is provided. The pixel circuit 210 is provided on side of the front surface (side of the wiring layer 200T) of the semiconductor layer 200S, for example. In the imaging device 1, the second substrate 200 is attached to the first substrate 100 to allow the side of back surface (the side of the semiconductor layer 200S) of the second substrate 200 to be opposed to the side of the front surface (the side of the wiring layer 100T) of the first substrate 100. That is, the second substrate 200 is attached face-to-back to the first substrate 100.

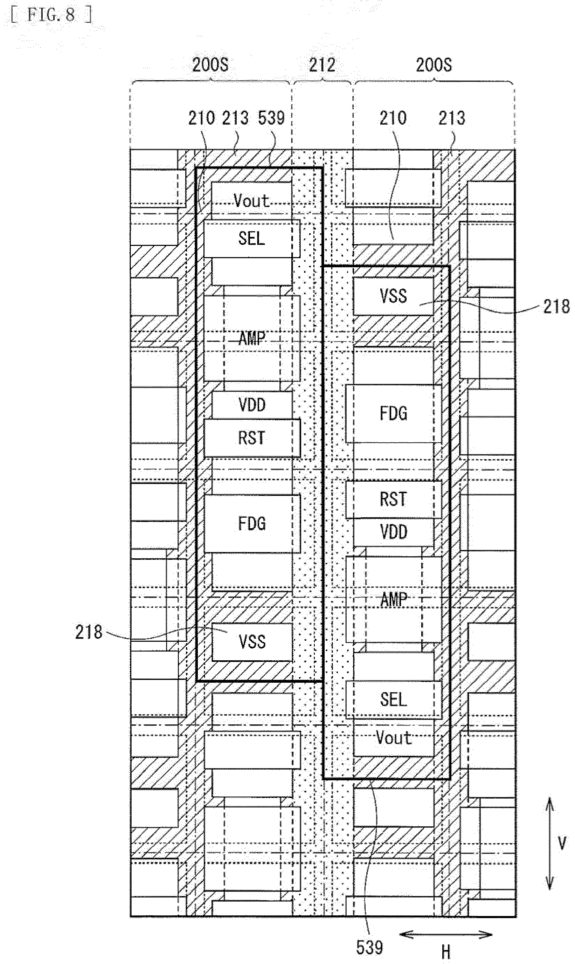

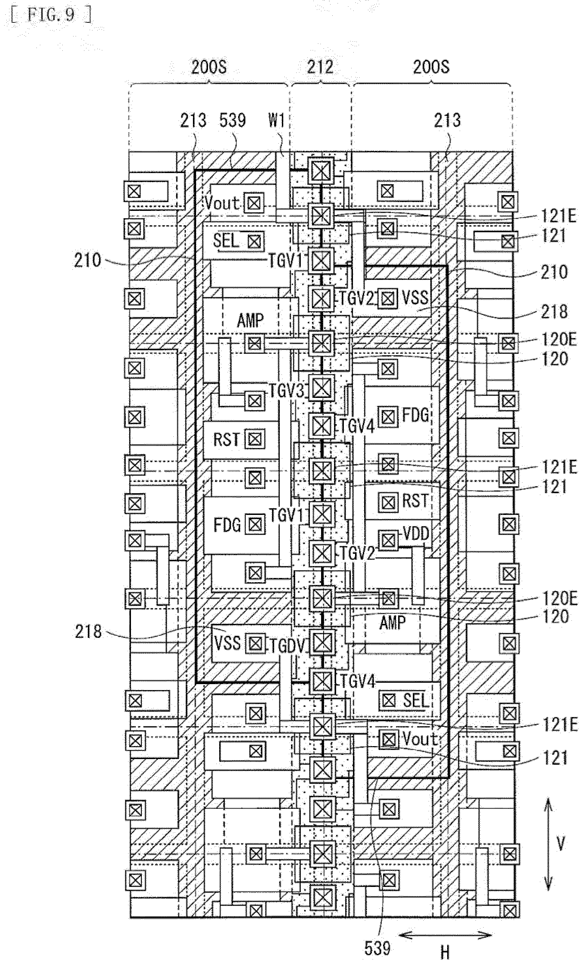

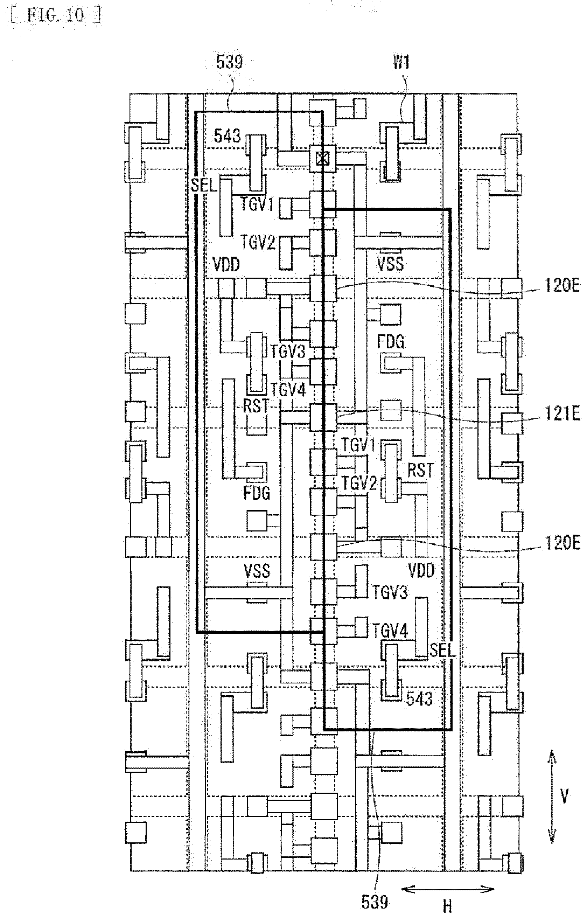

FIGs. 8 and 9 to 12 each schematically illustrate an example of a planar configuration of the second substrate 200. FIG. 8 illustrates a configuration of the pixel circuit 210 provided close to the front surface of the semiconductor layer 200S. FIG. 9 schematically illustrates a configuration of each of the wiring layer 200T (specifically, a first wiring layer W1 described later), the semiconductor layer 200S coupled to the wiring layer 200T, and the first substrate 100. FIGs. 10 to 12 each illustrate an example of a planar configuration of the wiring layer 200T. Description is given below of the configuration of the second substrate 200 with use of FIGs. 8 and 9 to 12 together with FIG. 6. In FIGs. 8 and 9, the contour of the photodiode PD (a boundary between the pixel separation section 117 and the photodiode PD) is indicated by a broken line, and a boundary between the semiconductor layer 200S in a portion overlapping the gate electrode of each of the transistors included in the pixel circuit 210 and an element separation region 213 or the insulating region 212 is indicated by a dotted line. In a portion overlapping the gate electrode of the amplification transistor AMP, a boundary between the semiconductor layer 200S and the element separation region 213 and a boundary between the element separation region 213 and the insulating region 212 are provided in one channel width direction.

The second substrate 200 includes the insulating region 212 that divides the semiconductor layer 200S, and the element separation region 213 that is provided in a portion in the thickness direction of the semiconductor layer 200S (FIG. 6). For example, in the insulating region 212 provided between two pixel circuits 210 adjacent to each other in the H direction, the through-electrodes 120E and 121E of two pixel sharing units 539 and the through-electrodes TGV (through-electrodes TGV1, TGV2, TGV3, and TGV4) coupled to the two pixel circuits 210 are disposed (FIG. 9).

The insulating region 212 has substantially the same thickness as the thickness of the semiconductor layer 200S (FIG. 6). The semiconductor layer 200S is divided by the insulating region 212. The through-electrodes 120E and 121E and the through-electrodes TGV are disposed in the insulating region 212. The insulating region 212 includes, for example, silicon oxide.

The through-electrodes 120E and 121E are provided to penetrate the insulating region 212 in the thickness direction. Upper ends of the through-electrodes 120E and 121E are coupled to wiring lines (the first wiring layer W1, a second wiring layer W2, a third wiring layer W3, and a fourth wiring layer W4 that are described later) of the wiring layer 200T. The through-electrodes 120E and 121E are provided to penetrate the insulating region 212, the bonding film 124, the interlayer insulating film 123, and the passivation film 122, and lower ends thereof are coupled to the pad sections 120 and 121 (FIG. 6). The through-electrode 120E electrically couples the pad section 120 and the pixel circuit 210 to each other. That is, the floating diffusion FD of the first substrate 100 is electrically coupled to the pixel circuit 210 of the second substrate 200 by the through-electrode 120E. The through-electrode 121E electrically couples the pad section 121 and the reference potential line VSS of the wiring layer 200T to each other. That is, the VSS contact region 118 of the first substrate 100 is electrically coupled to the reference potential line VSS of the second substrate 200 by the through-electrode 121E.

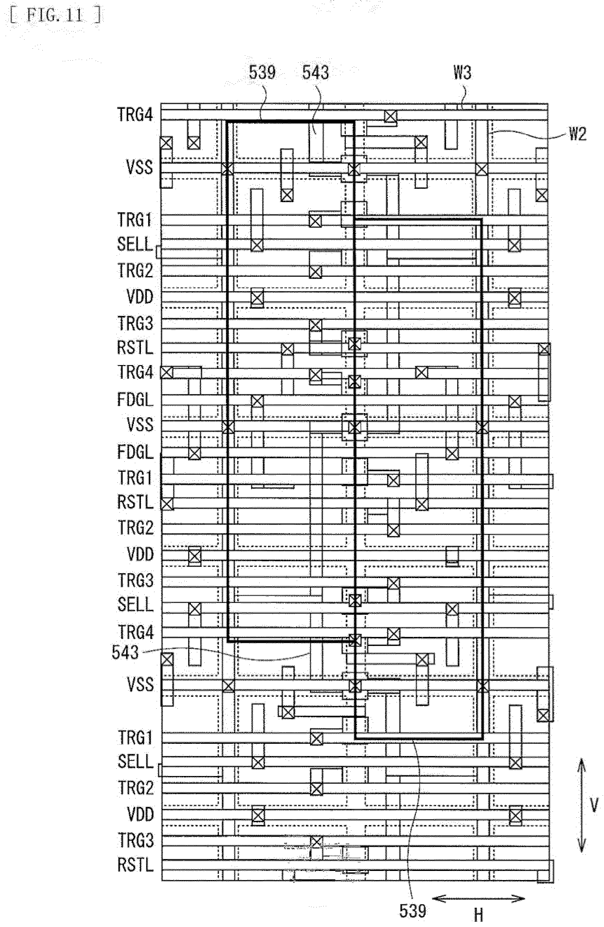

The through-electrode TGV is provided to penetrate the insulating region 212 in the thickness direction. An upper end of the through-electrode TGV is coupled to a wiring line of the wiring layer 200T. The through-electrode TGV is provided to penetrate the insulating region 212, the bonding film 124, the interlayer insulating film 123, the passivation film 122, and the interlayer insulating film 119, and a lower end thereof is coupled to the transfer gate TG (FIG. 6). Such a through-electrode TGV electrically couples the transfer gates TG (transfer gates TG1, TG2, TG3, and TG4) of the pixels 541A, 541B, 541C, and 541D and wiring lines (portions of the row drive signal line 542, specifically wiring lines TRG1, TRG2, TRG3, and TRG4 in FIG. 11 described later) of the wiring layer 200T to each other. That is, the transfer gates TG of the first substrate 100 are electrically coupled to the wiring lines TRG of the second substrate 200 by the through-electrode TGV to transmit a drive signal to each of the transfer transistors TR (transfer transistors TR1, TR2, TR3, and TR4).

The insulating region 212 is a region for insulating the through-electrodes 120E and 121E and the through-electrode TGV for electrically coupling the first substrate 100 and the second substrate 200 to each other from the semiconductor layer 200S. For example, in the insulating region 212 provided between two pixel circuits 210 (the pixel sharing units 539) adjacent to each other in the H direction, the through-electrodes 120E and 121E and the through-electrodes TGV (the through-electrodes TGV1, TGV2, TGV3, and TGV4) that are coupled to the two pixel circuits 210 are disposed. The insulating region 212 is provided to extend in the V direction, for example (FIGs. 8 and 9). Here, the disposition of the horizontal portion TGb of the transfer gate TG is devised, thereby disposing the position in the H direction of the through-electrode TGV closer to the positions in the H direction of the through-electrodes 120E and 121E, as compared with the position of the vertical portion TGa (FIGs. 7A and 9). For example, the through-electrode TGV is disposed at substantially the same position in the H direction as the through-electrodes 120E and 120E. This makes it possible to collectively provide the through-electrodes 120E and 121E and the through-electrode TGV in the insulating region 212 that extends in the V direction. As another arrangement example, it may be conceivable that the horizontal portion TGb is provided only in a region superimposed on the vertical portion TGa. In this case, the through-electrode TGV is formed substantially directly above the vertical portion TGa, and the through-electrode TGV is disposed in a substantially middle part in the H direction and the Y direction of each of the pixels 541, for example. At this time, the position in the H direction of the through-electrode TGV is significantly deviated from the positions in the H direction of the through-electrodes 120E and 121E. For example, the insulating region 212 is provided around the through-electrode TGV and the through-electrodes 120E and 121E to electrically insulate them from the semiconductor layer 200S close to them. In a case where the position in the H direction of the through-electrode TGV and the positions in the H direction of the through-electrodes 120E and 121E are greatly separated from each other, it is necessary to independently provide the insulating region 212 around each of the through-electrodes 120E, 121E, and TGV. Accordingly, the semiconductor layer 200S is finely divided. In contrast, a layout in which the through-electrodes 120E and 121E and the through-electrode TGV are collectively disposed in the insulating region 212 that extends in the V direction makes it possible to increase the size in the H direction of the semiconductor layer 200S. This makes it possible to secure a large area of a semiconductor element formation region in the semiconductor layer 200S. Accordingly, it is possible to increase the size of the amplification transistor AMP and reduce noise, for example.

As described with reference to FIG. 4, the pixel sharing unit 539 electrically couples together the floating diffusions FD provided in the respective pixels 541, and has a structure in which the plurality of pixels 541 share one pixel circuit 210. In addition, the electrical coupling between the floating diffusions FD is made by the pad section 120 provided in the first substrate 100 (FIGs. 6 and 7B). The electrical coupling section (the pad section 120) provided in the first substrate 100 and the pixel circuit 210 provided in the second substrate 200 are electrically coupled to each other via one through-electrode 120E. It may also be conceivable, as an alternative structure example, that an electrical coupling section between the floating diffusions FD is provided in the second substrate 200. In this case, the pixel sharing unit 539 includes four through-electrodes coupled respectively to the floating diffusions FD1, FD2, FD3, and FD4. Accordingly, in the second substrate 200, the number of the through-electrodes penetrating the semiconductor layer 200S is increased, and the insulating region 212 insulating the periphery of the through-electrodes is made larger. In contrast, it is possible for the structure of the first substrate 100 including the pad section 120 (FIGs. 6 and 7B) to reduce the number of the through-electrodes and to make the insulating region 212 smaller. Thus, it is possible to secure a large area of a semiconductor element formation region in the semiconductor layer 200S. This makes it possible, for example, to increase the size of the amplification transistor AMP, and thus to suppress the noise.

The element separation region 213 is provided on front surface side of the semiconductor layer 200S. The element separation region 213 has an STI (Shallow Trench Isolation) structure. In the element separation region 213, the semiconductor layer 200S is engraved in the thickness direction (a direction perpendicular to the main surface of the second substrate 200), and an insulating film is embedded in the engraved part. The insulating film includes, for example, silicon oxide. The element separation region 213 performs element separation between a plurality of transistors included in the pixel circuit 210 in accordance with the layout of the pixel circuit 210. The semiconductor layer 200S (specifically, the well region 211) extends below the element separation region 213 (a deep part of the semiconductor layer 200S).

Here, description is given, with reference to FIGs. 7A, 7B, and 8, of a difference between a contour shape (a contour shape in the substrate plane direction) of the pixel sharing unit 539 in the first substrate 100 and a contour shape of the pixel sharing unit 539 in the second substrate 200.

In the imaging device 1, the pixel sharing units 539 are provided across both the first substrate 100 and the second substrate 200. For example, the contour shape of the pixel sharing unit 539 provided in the first substrate 100 and the contour shape of the pixel sharing unit 539 provided in the second substrate 200 are different from each other.

In FIGs. 7A and 7B, a contour line of each of the pixels 541A, 541B, 541C, and 541D is indicated by an alternate long and short dashed line, and a contour line of the pixel sharing unit 539 is indicated by a thick line. For example, the pixel sharing unit 539 of the first substrate 100 includes two pixels 541 (the pixels 541A and 541B) arranged adjacent to each other in the H direction and two pixels 541 (the pixels 541C and 541D) arranged adjacent to each other in the V direction. That is, the pixel sharing unit 539 of the first substrate 100 includes four adjacent pixels 541 in two rows by two columns, and the pixel sharing unit 539 of the first substrate 100 has a substantially square contour shape. In the pixel array section 540, such pixel sharing units 539 are arranged adjacent to each other with two-pixel pitches (pitches corresponding to two pixels 541) in the H direction and two-pixel pitches (pitches corresponding to two pixels 541) in the V direction.

In FIGs. 8 and 9, the contour line of each ofthe pixels 541A, 541B, 541C, and 541D is indicated by an alternate long and short dashed line, and a contour line of the pixel sharing unit 539 is indicated by a thick line. For example, the contour shape of the pixel sharing unit 539 of the second substrate 200 is smaller in the H direction than that of the pixel sharing unit 539 of the first substrate 100, and is larger in the V direction than that of the pixel sharing unit 539 of the first substrate 100. For example, the pixel sharing unit 539 of the second substrate 200 is formed to have a size (a region) corresponding to one pixel in the H direction, and is formed to have a size corresponding to four pixels in the V direction. That is, the pixel sharing unit 539 of the second substrate 200 is formed to have a size corresponding to adjacent pixels arranged in one row by four columns, and the pixel sharing unit 539 of the second substrate 200 has a substantially rectangular contour shape.

For example, in each of the pixel circuits 210, the selection transistor SEL, the amplification transistor AMP, the reset transistor RST, and the FD conversion gain switching transistor FDG are arranged in this order side by side in the V direction (FIG. 8). The contour shape of each of the pixel circuits 210 is a substantially rectangular shape as described above, which makes it possible to arrange four transistors (the selection transistor SEL, the amplification transistor AMP, the reset transistor RST, and the FD conversion gain switching transistor FDG) side by side in one direction (the V direction in FIG. 8). This makes it possible to share the drain of the amplification transistor AMP and the drain of the reset transistor RST in one diffusion region (a diffusion region coupled to the power supply line VDD). For example, it is possible to provide the formation region of each of the pixel circuits 210 having a substantially square shape. In this case, two transistors are disposed in one direction, which makes it difficult to share the drain of the amplification transistor AMP and the drain of the reset transistor RST in one diffusion region. Accordingly, providing the formation region of the pixel circuit 210 having a substantially rectangular shape makes it easier to dispose four transistors close to each other, and makes it possible to downsize the formation region of the pixel circuit 210. That is, it is possible to miniaturize the pixels. In addition, in a case where it is unnecessary to make the formation region of the pixel circuit 210 smaller, the formation region of the amplification transistor AMP is made larger, which makes it possible to suppress the noise.

For example, in addition to the selection transistor SEL, the amplification transistor AMP, the reset transistor RST, and the FD conversion gain switching transistor FDG, a VSS contact region 218 coupled to the reference potential line VSS is provided close to the front surface of the semiconductor layer 200S. The VSS contact region 218 includes, for example, a p-type semiconductor region. The VSS contact region 218 is electrically coupled to the VSS contact region 118 of the first substrate 100 (the semiconductor layer 100S) through a wiring line ofthe wiring layer 200T and the through-electrode 121E. The VSS contact region 218 is provided at a position adjacent to the source of the FD conversion gain switching transistor FDG with the element separation region 213 interposed therebetween, for example (FIG. 8).

Next, description is given, with reference to FIGs. 7B and 8, of a positional relationship between the pixel sharing unit 539 provided in the first substrate 100 and the pixel sharing unit 539 provided in the second substrate 200. For example, one (e.g., on upper side of the sheet of FIG. 7B) pixel sharing unit 539 of two pixel sharing units 539 arranged in the V direction of the first substrate 100 is coupled to one (e.g., on left side of the sheet of FIG. 8) pixel sharing unit 539 of two pixel sharing units 539 arranged in the H direction of the second substrate 200. For example, the other (e.g., on lower side of the sheet of FIG. 7B) pixel sharing unit 539 of the two pixel sharing units 539 arranged in the V direction of the first substrate 100 is coupled to the other (e.g., on right side of the sheet of FIG. 8) pixel sharing unit 539 of the two pixel sharing units 539 arranged in the H direction of the second substrate 200.

For example, in the two pixel sharing units 539 arranged in the H direction of the second substrate 200, an internal layout (arrangement of transistors and the like) of the one pixel sharing unit 539 is substantially equal to a layout obtained by inverting an internal layout of the other pixel sharing unit 539 in the V direction and the H direction. Effects achieved by this layout are described below.

In the two pixel sharing units 539 arranged in the V direction of the first substrate 100, each of the pad sections 120 is disposed in a middle part of the contour shape of the pixel sharing unit 539, that is, a middle part in the V direction and the H direction of the pixel sharing unit 539 (FIG. 7B). Meanwhile, the pixel sharing unit 539 of the second substrate 200 has a substantially rectangular contour shape that is long in the V direction as described above; therefore, for example, the amplification transistor AMP coupled to the pad section 120 is disposed at a position deviated from the middle in the V direction of the pixel sharing unit 539 toward an upper part of the sheet. For example, in a case where internal layouts of the two pixel sharing units 539 arranged in the H direction of the second substrate 200 are the same, a distance between the amplification transistor AMP of the one pixel sharing unit 539 and the pad section 120 (e.g., the pad section120 of the pixel sharing unit 539 on upper side of the sheet of FIG. 7B) is relatively short. However, a distance between the amplification transistor AMP of the other pixel sharing unit 539 and the pad section 120 (e.g., the pad section120 of the pixel sharing unit 539 on lower side of the sheet of FIG. 7B) is long. Accordingly, an area of a wiring line necessary for coupling between the amplification transistor AMP and the pad section 120 is increased, which may possibly complicate a wiring layout of the pixel sharing unit 539. There is a possibility that this may affect miniaturization of the imaging device 1.

In contrast, internal layouts of the two pixel sharing units 539 arranged in the H direction of the second substrate 200 are inverted in at least the V direction, which makes it possible to shorten distances between the amplification transistors AMP of both the two pixel sharing units 539 and the pad section 120. Accordingly, as compared with a configuration in which the internal layouts of the two pixel sharing units 539 arranged in the H direction of the second substrate 200 are the same, miniaturization of the imaging device 1 is easily executed. It is to be noted that a planar layout of each of the plurality of pixel sharing units 539 of the second substrate 200 is bilaterally symmetrical in a range illustrated in FIG. 8; however, a layout including a layout of the first wiring layer W1 illustrated in FIG. 9 described later is bilaterally asymmetrical.

In addition, the internal layouts of the two pixel sharing units 539 arranged in the H direction of the second substrate 200 are preferably inverted to each other also in the H direction. A reason for this is described below. As illustrated in FIG. 9, the two pixel sharing units 539 arranged in the H direction of the second substrate 200 are each coupled to the pad sections 120 and 121 of the first substrate 100. For example, the pad sections 120 and 121 are disposed in a middle part in the H direction (between the two pixel sharing units 539 arranged in the H direction) of the two pixel sharing units 539 arranged in the H direction of the second substrate 200. Accordingly, the internal layouts of the two pixel sharing units 539 arranged in the H direction of the second substrate 200 are inverted to each other also in the H direction, which makes it possible to decrease distances between each of the plurality of pixel sharing units 539 of the second substrate 200 and the pad sections 120 and 121. That is, this further facilitates the miniaturization of the imaging device 1.

In addition, the position of the contour line of the pixel sharing unit 539 of the second substrate 200 may not be aligned with the position of a contour line of one of the pixel sharing units 539 of the first substrate 100. For example, in one (e.g., left side of the sheet of FIG. 9) pixel sharing unit 539 of the two pixel sharing units 539 arranged in the H direction of the second substrate 200, one (e.g., upper side of the sheet of FIG. 9) contour line in the V direction is disposed outside one contour line in the V direction of a corresponding pixel sharing unit 539 (e.g., on upper side of the sheet of FIG. 7B) of the first substrate 100. In addition, in the other (e.g., on right side of the sheet of FIG. 9) pixel sharing unit 539 of the two pixel sharing units 539 arranged in the H direction of the second substrate 200, the other (e.g., the lower side of the sheet of FIG. 9) contour line in the V direction is disposed outside the other contour line in the V direction of a corresponding pixel sharing unit 539 (e.g., on the lower side of the sheet of FIG. 7B) of the first substrate 100. Disposing the pixel sharing units 539 of the second substrate 200 and the pixel sharing units 539 of the first substrate 100 each other in this manner makes it possible to shorten a distance between the amplification transistor AMP and the pad section 120. This facilitates the miniaturization of the imaging device 1.

In addition, the positions of contour lines of the plurality of pixel sharing units 539 of the second substrate 200 may not be aligned. For example, the two pixel sharing units 539 arranged in the H direction of the second substrate 200 are disposed to allow the positions of the contour lines in the V direction to be deviated. This makes it possible to shorten the distance between the amplification transistor AMP and the pad section 120. Thus, the miniaturization of the imaging device 1 is facilitated.

Description is given, with reference to FIGs. 7B and 9, of repeated arrangement of the pixel sharing units 539 in the pixel array section 540. The pixel sharing unit 539 of the first substrate 100 has a size corresponding to two pixels 541 in the H direction and a size corresponding to two pixels 541 in the V direction (FIG. 7B). For example, in the pixel array section 540 of the first substrate 100, the pixel sharing units 539 having a size corresponding to the four pixels 541 are repeatedly arranged adjacent to each other with two-pixel pitches (pitches corresponding to two pixels 541) in the H direction and two-pixel pitches (pitches corresponding to two pixels 541) in the V direction. Alternatively, in the pixel array section 540 of the first substrate 100, a pair of pixel sharing units 539 that are two pixel sharing units 539 adjacent to each other in the V direction may be provided. In the pixel array section 540 of the first substrate 100, for example, the pair of pixel sharing units 539 are repeatedly arranged adjacent to each other with two-pixel pitches (pitches corresponding to two pixels 541) in the H direction and four-pixel pitches (pitches corresponding to four pixels 541) in the V direction. The pixel sharing unit 539 of the second substrate 200 has a size corresponding to one pixel 541 in the H direction and a size corresponding to four pixels 541 in the V direction (FIG. 9). For example, in the pixel array section 540 of the second substrate 200, a pair of pixel sharing units 539 including two pixel sharing units 539 having a size corresponding to the four pixels 541 are provided. The pixel sharing units 539 are disposed adjacent to each other in the H direction and are disposed to be deviated in the V direction. In the pixel array section 540 of the second substrate 200, for example, the pair of pixel sharing units 539 are repeatedly arranged adjacent to each other without space with two-pixel pitches (pitches corresponding to two pixels 541) in the H direction and four-pixel pitches (pitches corresponding to four pixels 541) in the V direction. Such repeated arrangement of the pixel sharing units 539 makes it possible to arrange the pixel sharing units 539 without space. Thus, the miniaturization of the imaging device 1 is facilitated.

The wiring layer 200T includes, for example, a passivation film 221, an interlayer insulating film 222, and a plurality of wiring lines (the first wiring layer W1, the second wiring layer W2, the third wiring layer W3, and the fourth wiring layer W4). The passivation film 221 is, for example, in contact with the front surface of the semiconductor layer 200S, and covers the entire front surface of the semiconductor layer 200S. The passivation film 221 covers the respective gate electrodes of the selection transistor SEL, the amplification transistor AMP, the reset transistor RST, and the FD conversion gain switching transistor FDG. The interlayer insulating film 222 is provided between the passivation film 221 and the third substrate 300. The plurality of wiring lines (the first wiring layer W1, the second wiring layer W2, the third wiring layer W3, and the fourth wiring layer W4) are separated by the interlayer insulating film 222. The interlayer insulating film 222 includes, for example, silicon oxide.

In the wiring layer 200T, for example, the first wiring layer W1, the second wiring layer W2, the third wiring layer W3, the fourth wiring layer W4, and the contact sections 201 and 202 are provided in this order from side of the semiconductor layer 200S, and are insulated from each other by the interlayer insulating film 222. The interlayer insulating film 222 includes a plurality of coupling sections that couples the first wiring layer W1, the second wiring layer W2, the third wiring layer W3, or the fourth wiring layer W4 and a layer therebelow to each other. The coupling sections are portions in which an electrically-conductive material is embedded in a coupling hole provided in the interlayer insulating film 222. For example, the interlayer insulating film 222 includes a coupling section 218V that couples the first wiring layer W1 and the VSS contact region 218 of the semiconductor layer 200S to each other. For example, the hole diameter of such a coupling section that couples elements of the second substrate 200 to each other differs from hole diameters of the through-electrodes 120E and 121E and the through-electrode TGV. Specifically, the hole diameter of the coupling hole that couples the elements of the second substrate 200 to each other is preferably smaller than the hole diameters of the through-electrodes 120E and 121E and the through-electrode TGV. A reason for this is described below. The depth of the coupling section (such as the coupling section 218V) provided in the wiring layer 200T is smaller than the depths of the through-electrodes 120E and 121E and the through-electrode TGV. Accordingly, in the coupling section, the electrically-conductive material is able to be embedded in the coupling hole more easily than the through-electrodes 120E and 121E and the through-electrode TGV. Making the hole diameter of the coupling section smaller than the hole diameters of the through-electrodes 120E and 121E and the through-electrode TGV facilitates the miniaturization of the imaging device 1.

For example, the through-electrode 120E, and the gate of the amplification transistor AMP and the source of the FD conversion gain switching transistor FDG (specifically, a coupling hole reaching the source of the FD conversion gain switching transistor FDG) are coupled to each other by the first wiring layer W1. The first wiring layer W1 couples, for example, the through-electrode 121E and the coupling section 218V to each other, which causes the VSS contact region 218 of the semiconductor layer 200S and the VSS contact region1 18 of the semiconductor layer 100S to be electrically coupled to each other.

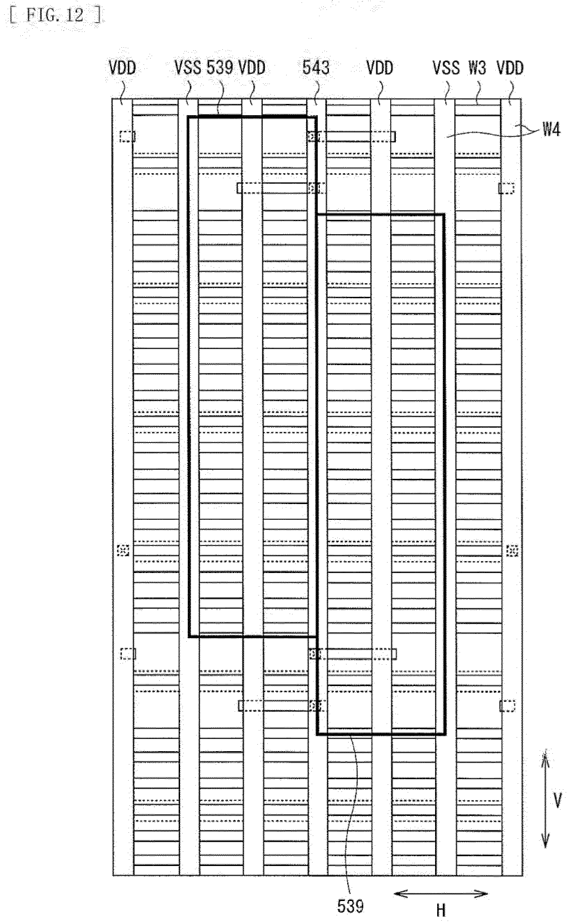

Next, description is given of the planar configuration of the wiring layer 200T with reference to FIGs. 10 to 12. FIG. 10 illustrates an example of a planar configuration of the first wiring layer W1 and the second wiring layer W2. FIG. 11 illustrate an example of a planar configuration of the second wiring layer W2 and the third wiring layer W3. FIG. 12 illustrates an example of a planar configuration of the third wiring layer W3 and the fourth wiring layer W4.

For example, the third wiring layer W3 includes wiring lines TRG1, TRG2, TRG3, and TRG4, SELL, RSTL, and FDGL that extend in the H direction (the row direction) (FIG. 11). These wiring lines correspond to the plurality of row drive signal lines 542 described with reference to FIG. 4. The wiring lines TRG1, TRG2, TRG3, and TRG4 respectively transmit drive signals to the transfer gates TG1, TG2, TG3, and TG4. The wiring lines TRG1, TRG2, TRG3, and TRG4 are respectively coupled to the transfer gates TG1, TG2, TG3, and TG4 through the second wiring layer W2, the first wiring layer W1, and the through-electrode 120E. The wiring line SELL transmits a drive signal to the gate of the selection transistor SEL, the wiring line RSTL transmits a drive signal to the gate of the reset transistor RST, and the wiring line FDGL transmits a drive signal to the gate of the FD conversion gain switching transistor FDG. The wiring lines SELL, RSTL, and FDGL are respectively coupled to the gates of the selection transistor SEL, the reset transistor RST, and the FD conversion gain switching transistor FDG through the second wiring layer W2, the first wiring layer W1, and the coupling section.

For example, the fourth wiring layer W4 includes the power supply line VDD, the reference potential line VSS, and the vertical signal line 543 that extend in the V direction (the column direction) (FIG. 12). The power supply line VDD is coupled to the drain of the amplification transistor AMP and the drain of the reset transistor RST through the third wiring layer W3, the second wiring layer W2, the first wiring layer W1, and the coupling section. The reference potential line VSS is coupled to the VSS contact region 218 through the third wiring layer W3, the second wiring layer W2, the first wiring layer W1, and the coupling section 218V. In addition, the reference potential line VSS is coupled to the VSS contact region 118 of the first substrate 100 through the third wiring layer W3, the second wiring layer W2, the first wiring layer W1, the through-electrode 121E, and the pad section 121. The vertical signal line 543 is coupled to the source (Vout) of the selection transistor SEL through the third wiring layer W3, the second wiring layer W2, the first wiring layer W1, and the coupling section.

The contact sections 201 and 202 may be provided at positions overlapping the pixel array section 540 in a plan view (e.g., FIG. 3), or may be provided in the peripheral part 540B outside the pixel array section 540 (e.g., FIG. 6). The contact sections 201 and 202 are provided on the front surface (a surface on side of the wiring layer 200T) of the second substrate 200. The contact sections 201 and 202 include, for example, a metal such as Cu (copper) and A1 (aluminum). The contact sections 201 and 202 are exposed to the front surface (a surface on side of the third substrate 300) of the wiring layer 200T. The contact sections 201 and 202 are used for electrical coupling between the second substrate 200 and the third substrate 300 and attaching between the second substrate 200 and the third substrate 300.

FIG. 6 illustrates an example in which a peripheral circuit is provided in the peripheral part 540B of the second substrate 200. The peripheral circuit may include a portion of the row driving section 520 or a portion of the column signal processing section 550. In addition, as illustrated in FIG. 3, a peripheral circuit may not be disposed in the peripheral part 540B of the second substrate 200, and the coupling hole sections H1 and H2 may be disposed close to the pixel array section 540.

The pixel transistors (the amplification transistor AMP, the selection transistor SEL, the reset transistor RST, and the FD conversion gain switching transistor FDG) included in the pixel circuit 210 preferably has a three-dimensional structure such as a Fin type, for example, in which a channel region has an irregular structure (e.g., Fin-FET (Field-Effect Transistor), Tri-Gate FET, or double-gate FET). In particular, allowing the amplification transistor AMP to have a three-dimensional structure increases the magnitude of an effective gate width, thus making it possible to suppress the noise.

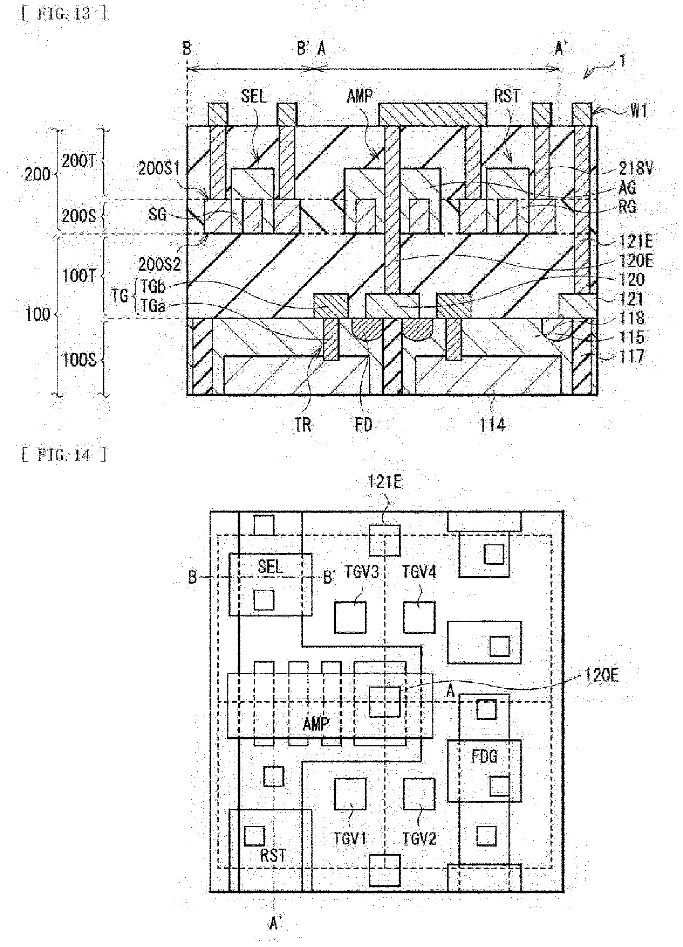

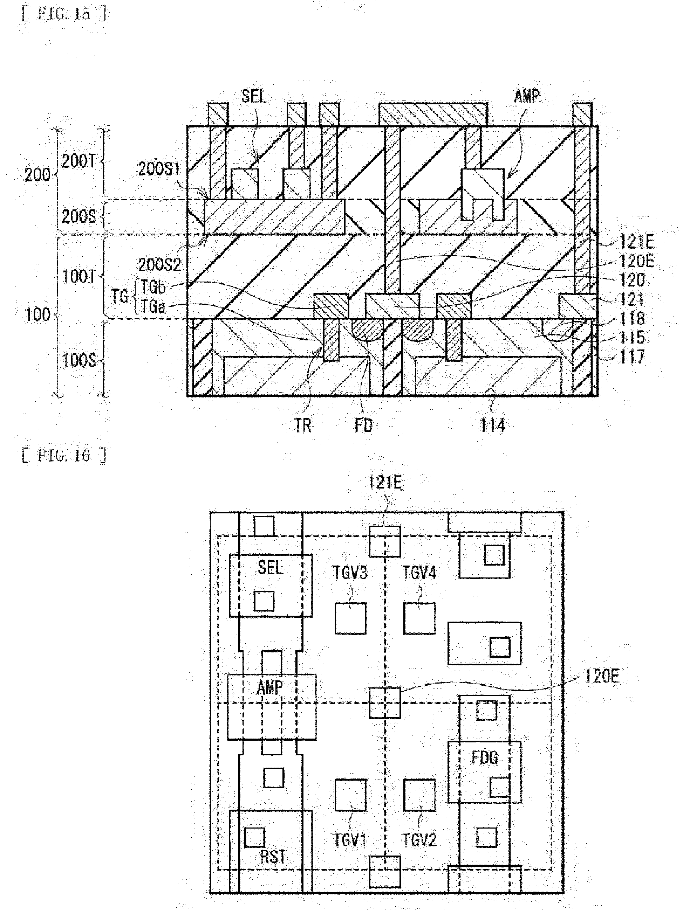

FIG. 13 schematically illustrates an example of a cross-sectional configuration of the first substrate 100 and the second substrate 200 in a case where Fin-type FD-SOI (Fully Depletion SOI) is adopted as the pixel transistor included in the pixel circuit 210. FIG. 14 illustrates an example of a layout of the pixel circuit 210 in the second substrate 200 in a case where the pixel transistor is allowed to have a three-dimensional structure. It is to be noted that FIG. 13 illustrates, in a simplified manner, a cross-section taken along lines A-A' and B-B' illustrated in FIG. 14. FIG. 15 illustrates, as a comparative example, a mode in which, as described above, the through-electrode 120E penetrates the insulating region 212 to electrically couple the pad section 120 and a gate AG of the amplification transistor AMP to each other through another wiring line such as the first wiring layer W1, in a manner to correspond to the cross-sectional view illustrated in FIG. 13. FIG. 16 illustrates a layout of a pixel circuit in the second substrate 200 in a case of having the cross-sectional structure illustrated in FIG. 15.

In the imaging device 1 illustrated in FIG. 13, the gate of the pixel transistor penetrates from a front surface (a surface 200S1) of the semiconductor layer 200S to a back surface (a surface 200S2) thereof. In particular, in a case where the amplification transistor AMP has such a structure, it is possible to directly couple the pad section 120 and the amplification transistor AMP to each other using the through-electrode 120E, as illustrated in FIGs. 13 and 14. Specifically, for example, the amplification transistor AMP, of the pixel transistors arranged in parallel in the V direction as illustrated in FIG. 8, is allowed to extend to the middle part of the pixel sharing unit 539 in the V direction and the H direction as illustrated in FIG. 14 and to extend above the pad section 120, thereby allowing the through-electrode 120E to penetrate the gate AG of the amplification transistor AMP.

This eliminates the need for the insulating region 212 that electrically insulates the periphery of the through-electrode 120E. That is, it is possible to further reduce an area of the insulating region 212, among the second substrate 200 forming the pixel circuit 210, for formation of a through-wiring line coupling the floating diffusion FD and the pixel circuit 210 to each other. Thus, it is possible to secure an even larger area of the second substrate 200 for formation of the pixel circuit 210. Securing the even larger area of the pixel circuit 210 as described above makes it possible to form an even larger pixel transistor.

In addition, in this structure, the floating diffusion FD and the amplification transistor AMP are directly coupled to each other by the through-electrode 120E. Therefore, as illustrated in FIG. 15, it is possible to shorten a wiring line length between the floating diffusion FD and the amplification transistor AMP, as compared with the case where the floating diffusion FD and the amplification transistor AMP are electrically coupled to each other through the first wiring layer W1 or the like in addition to the through-electrode 120E. Accordingly, it is possible to reduce a wiring capacity as compared with the wiring structure illustrated in FIG. 15, thus making it possible to improve conversion efficiency. In addition, it is possible to reduce the noise.

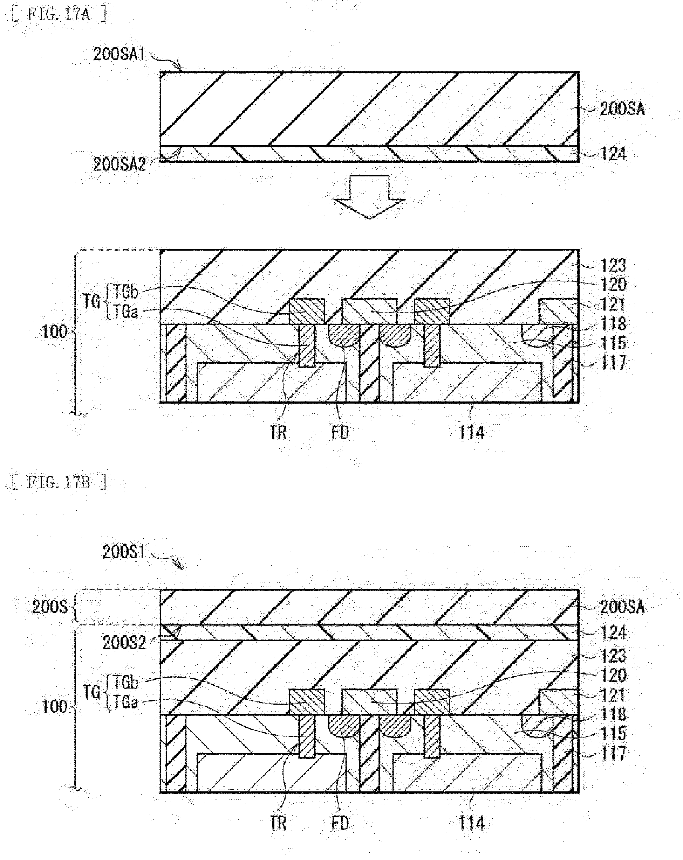

The wiring structure illustrated in FIGs. 13 and 14 may be manufactured, for example, as follows. FIGs. 17A to 17D each illustrate an example of a manufacturing step.

First, as illustrated in 17A, the wiring layer 100T is formed on the semiconductor layer 100S, and the bonding film 124 is formed on a back surface (a surface 200SA2) of a silicon substrate 200SA. Subsequently, as illustrated in FIG. 17B, the silicon substrate 200SA is attached to the wiring layer 100T with the bonding film 124 interposed therebetween, and then the silicon substrate 200SA is thinned to form the semiconductor layer 200S having a predetermined film thickness. Here, the predetermined film thickness is a film thickness required for formation of the pixel circuit 210. Specifically, the film thickness of the semiconductor layer 200S is a height (e.g., several tens of nm to several hundreds of nm) of the Fin-type pixel transistor.

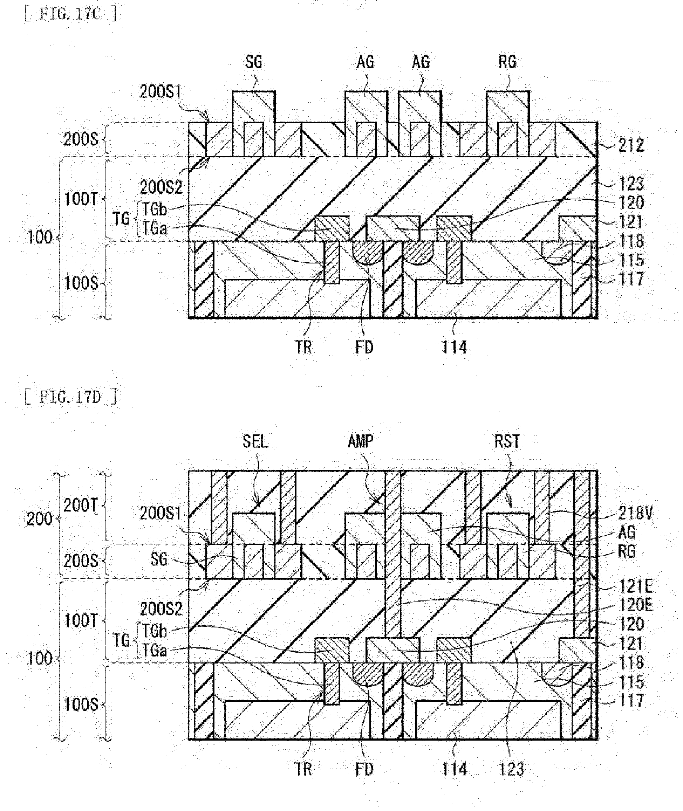

Next, as illustrated in FIG. 17C, the semiconductor layer 200S is appropriately separated to form the pixel circuit 210 including the amplification transistor AMP or the like. Subsequently, as illustrated in FIG. 17D, the passivation film 221 (unillustrated) and the interlayer insulating film 222 are formed, and the through-electrodes 120E and 121E and the coupling section 218V are formed, followed by planarization of the front surface using, for example, CMP or the like. Thereafter, the first wiring layer W1, the second wiring layer W2, the third wiring layer W3, the fourth wiring layer W4, and the like are formed to form the wiring layer 200T. In this manner, the imaging device illustrated in FIG. 13 is manufactured.

The third substrate 300 includes, for example, the wiring layer 300T and the semiconductor layer 300S in this order from the side of the second substrate 200. For example, the front surface of the semiconductor layer 300S is provided on the side of the second substrate 200. The semiconductor layer 300S includes a silicon substrate. A circuit is provided in a portion on front surface side of the semiconductor layer 300S. Specifically, for example, at least a portion of the input section 510A, the row driving section 520, the timing control section 530, the column signal processing section 550, the image signal processing section 560, and the output section 510B is provided in the portion on the front surface side of the semiconductor layer 300S. The wiring layer 300T provided between the semiconductor layer 300S and the second substrate 200 includes, for example, an interlayer insulating film, a plurality of wiring layers separated by the interlayer insulating film, and the contact sections 301 and 302. The contact sections 301 and 302 are exposed to the front surface (a surface on the side of the second substrate 200) of the wiring layer 300T. The contact section 301 is coupled to the contact section 201 of the second substrate 200, and the contact section 302 is coupled to the contact section 202 of the second substrate 200. The contact sections 301 and 302 are electrically coupled to a circuit (e.g., at least one of the input section 510A, the row driving section 520, the timing control section 530, the column signal processing section 550, the image signal processing section 560, or the output section 510B) formed in the semiconductor layer 300S. The contact sections 301 and 302 include, for example, a metal such as Cu (copper) and aluminum (Al). For example, an external terminal TA is coupled to the input section 510A through the coupling hole section H1, and an external terminal TB is coupled to the output section 510B through the coupling hole section H2.

Here, description is given of characteristics of the imaging device 1.

In general, an imaging device includes a photodiode and a pixel circuit as main components. Here, when the area of the photodiode is increased, electric charge resulting from photoelectric conversion is increased, which consequently makes it possible to improve a signal-to-noise ratio (S/N ratio) of a pixel signal, thereby enabling the imaging device to output more favorable image data (image information). Meanwhile, when the size of the transistor included in the pixel circuit (specifically, the size of the amplification transistor) is increased, noise generated in the pixel circuit is reduced, which consequently makes it possible to improve an S/N ratio of an imaging signal, thereby allowing the imaging device to output more favorable image data (image information).

However, in an imaging device in which the photodiode and the pixel circuit are provided in the same semiconductor substrate, it is conceivable that, when the area of the photodiode is increased within a limited area of the semiconductor substrate, the size of the transistor included in the pixel circuit is decreased. In addition, it is conceivable that, when the size of the transistor included in the pixel circuit is increased, the area of the photodiode is decreased.

In order to solve these issues, for example, the imaging device 1 according to the present embodiment uses a structure in which a plurality of pixels 541 share one pixel circuit 210, and the shared pixel circuit 210 is disposed to be superimposed on the photodiode PD. This makes it possible to make the area of the photodiode PD within the limited area of the semiconductor substrate as large as possible and make the size of the transistor included in the pixel circuit 210 as large as possible. This makes it possible to improve the S/N ratio of the pixel signal, thereby allowing the imaging device 1 to output more favorable image data (image information).

In achieving the structure in which a plurality of pixels 541 shares one pixel circuit 210 and the pixel circuit 210 is disposed to be superimposed on the photodiode PD, a plurality of wiring lines extends, which couples from the floating diffusion FD of each of the plurality of pixels 541 to one pixel circuit 210. In order to secure a large area of the semiconductor layer 200S that forms the pixel circuit 210, for example, it is possible to form a coupling wiring line that couples the plurality of extending wiring lines to each other to combine them into one. Likewise, for a plurality of wiring lines extending from the VSS contact region 118, it is possible to form a coupling wiring line that couples the plurality of extending wiring lines to each other to combine them into one.

For example, it is conceivable that, when a coupling wiring line that couples the plurality of wiring lines extending from the floating diffusion FD of each of the plurality of pixels 541 to each other is formed in the semiconductor layer 200S that forms the pixel circuit 210, an area where the transistors included in the pixel circuit 210 are to be formed is decreased. Likewise, it is conceivable that, when a coupling wiring line that couples the plurality of wiring lines extending from the VSS contact region 118 of each of the plurality of pixels 541 to each other to combine them into one is formed in the semiconductor layer 200S that forms the pixel circuit 210, an area where the transistors included in the pixel circuit 210 are to be formed is decreased.

In order to solve these issues, for example, the imaging device 1 according to the present embodiment is able to have a structure in which a plurality of pixels 541 share one pixel circuit 210, and the shared pixel circuit 210 is disposed to be superimposed on the photodiode PD, as well as a structure in which a coupling wiring line that couples the respective floating diffusions FD of the plurality of pixels 541 to each other to combine them into one and a coupling wiring line that couples the VSS contact regions 118 included in the respective pixels 541 to each other to combine them into one are included in the first substrate 100.

Here, when the second manufacturing method described above is used as a manufacturing method for providing, in the first substrate 100, the coupling wiring line that couples the respective floating diffusions FD of the plurality of pixels 541 to each other to combine them into one and the coupling wiring line that couples the respective VSS contact regions 118 of the plurality of pixels 541 to each other to combine them into one, it is possible to perform manufacturing with use of appropriate processes corresponding to the respective configurations of the first substrate 100 and the second substrate 200 and manufacture an imaging device having high quality and high performance. In addition, it is possible to form the coupling wiring lines of the first substrate 100 and the second substrate 200 by an easy process. Specifically, in a case where the second manufacturing method described above is used, an electrode coupled to the floating diffusion FD and an electrode coupled to the VSS contact region 118 are provided on each of the front surface of the first substrate 100 and the front surface of the second substrate 200 that form an attaching boundary surface between the first substrate 100 and the second substrate 200. Further, sizes of the electrodes formed on the front surfaces of the two substrates are preferably made large to cause the electrodes formed on the front surfaces of the two substrates to be in contact with each other even when positional displacement occurs between the electrodes provided on the front surfaces of the two substrates upon attaching the first substrate 100 and the second substrate 200 together. In this case, it is considered difficult to dispose the electrode described above in the limited area of each pixel included in the imaging device 1.

In order to solve an issue in that a large electrode is necessary on the attaching boundary surface between the first substrate 100 and the second substrate 200, for example, in the imaging device 1 according to the present embodiment, it is possible to use the first manufacturing method described above as a manufacturing method in which a plurality of pixels 541 share one pixel circuit 210 and the shared pixel circuit 210 is disposed to be superimposed on the photodiode PD. This makes it possible to facilitate alignment of elements formed in each of the first substrate 100 and the second substrate 200 and to manufacture an imaging device having high quality and high performance. Further, it is possible to have a unique structure formed by using the manufacturing method. That is, a structure in which the semiconductor layer 100S and the wiring layer 100T of the first substrate 100, and the semiconductor layer 200S and the wiring layer 200T of the second substrate 200 are stacked in this order, in other words, a structure in which the first substrate 100 and the second substrate 200 are stacked face-to-back is included, and the through-electrodes 120E and 121E are included that penetrate the semiconductor layer 200S and the wiring layer 100T of the first substrate 100 from the front surface side of the semiconductor layer 200S of the second substrate 200 to reach the front surface of the semiconductor layer 100S of the first substrate 100.

When, in a structure in which a coupling wiring line that couples the respective floating diffusions FD of the plurality of pixels 541 to each other to combine them into one and a coupling wiring line that couples the respective VSS contact regions 118 of the plurality of pixels 541 to each other to combine them into one are provided in the first substrate 100, this structure and the second substrate 200 are stacked with use of the first manufacturing method to form the pixel circuit 210 in the second substrate 200, there is a possibility that heating treatment necessary to form an active element included in the pixel circuit 210 may affect the coupling wiring line described above formed in the first substrate 100.

Therefore, in order to solve an issue in that heating treatment for forming the active element described above affects the coupling wiring line described above, in the imaging device 1 according to the present embodiment, it is desirable that an electrically-conductive material having high heat resistance be used for the coupling wiring line that couples the respective floating diffusions FD of the plurality of pixels 541 to each other to combine them into one and the coupling wiring line that couples the respective VSS contact regions 118 of the plurality of pixels 541 to each other to combine them into one. Specifically, as the electrically-conductive material having high heat resistance, it is possible to use a material having a higher melting point than that of at least a portion of a wiring material included in the wiring layer 200T of the second substrate 200.

As described above, for example, the imaging device 1 according to the present embodiment has (1) the structure in which the first substrate 100 and the second substrate 200 are stacked face-to-back (specifically, the structure in which the semiconductor layer 100S and the wiring layer 100T of the first substrate 100 and the semiconductor layer 200S and the wiring layer 200T of the second substrate 200 are stacked in this order), (2) the structure in which the through-electrodes 120E and 121E are provided that penetrate the semiconductor layer 200S and the wiring layer 100T of the first substrate 100 from the front surface side of the semiconductor layer 200S of the second substrate 200 to reach the front surface of the semiconductor layer 100S of the first substrate 100, and (3) the structure in which the coupling wiring line that couples the respective floating diffusions FD included in the plurality of pixels 541 to each other to combine them into one and the coupling wiring line that couples the respective VSS contact regions 118 included in the plurality of pixels 541 are formed with use of an electrically-conductive material having high heat resistance, which makes it possible to provide, in the first substrate 100, a coupling wiring line that couples the respective floating diffusions FD included in the plurality of pixels 541 to each other to combine them into one and a coupling wiring line that couples the respective VSS contact regions 118 included in the plurality of pixels 541 to each other to combine them into one, without providing a large electrode at an interface between the first substrate 100 and the second substrate 200.

### [Operation of Imaging Device 1]

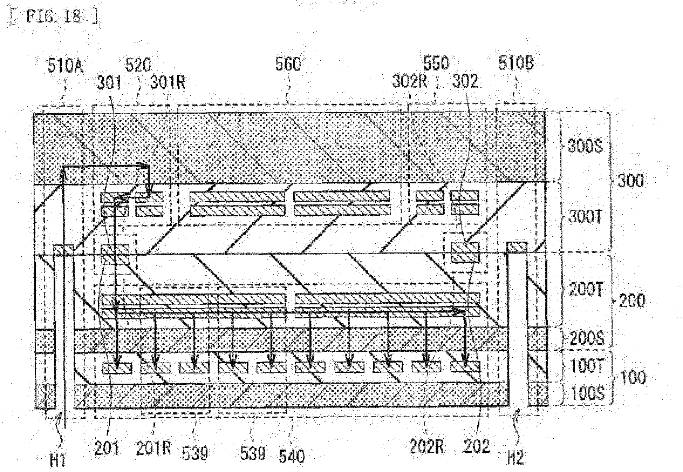

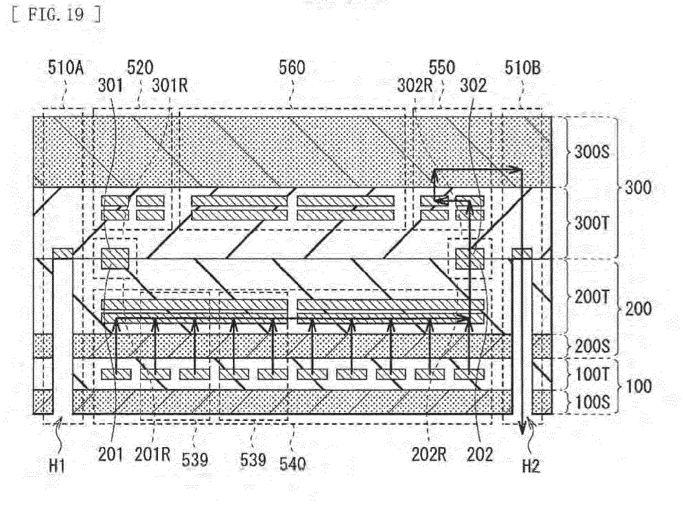

Next, description is given of an operation of the imaging device 1 with use of FIGs. 18 and 19. FIGs. 18 and 19 correspond to FIG. 3 with an arrow indicating a path of each signal. FIG. 18 illustrates an input signal to be inputted from outside to the imaging device 1 and paths of a power supply potential and a reference potential indicated by arrows. FIG. 19 illustrates a signal path of a pixel signal to be outputted from the imaging device 1 to the outside indicated by an arrow. For example, the input signal (e.g., a pixel clock and a synchronization signal) inputted to the imaging device 1 through the input section 510A is transmitted to the row driving section 520 of the third substrate 300, and a row drive signal is formed in the row driving section 520. The row drive signal is transmitted to the second substrate 200 through the contact sections 301 and 201. Further, the row drive signal reaches each of the pixel sharing units 539 of the pixel array section 540 through the row drive signal line 542 in the wiring layer 200T. A drive signal other than the transfer gate TG of the row drive signal having reached the pixel sharing unit 539 of the second substrate 200 is inputted to the pixel circuit 210 to drive each of the transistors included in the pixel circuit 210. A drive signal of the transfer gate TG is inputted to the transfer gates TG1, TG2, TG3, and TG4 of the first substrate 100 through the through-electrode TGV to drive the pixels 541A, 541B, 541C, and 541D (FIG. 18). In addition, the power supply potential and the reference potential supplied from outside of the imaging device 1 to the input section 510A (the input terminal 511) of the third substrate 300 are transmitted to the second substrate 200 through the contact sections 301 and 201 to be supplied to the pixel circuit 210 of each of the pixel sharing units 539 through a wiring line in the wiring layer 200T. Further, the reference potential is also supplied to the pixels 541A, 541B, 541C, and 541D of the first substrate 100 through the through-electrode 121E. Meanwhile, the pixel signal photoelectrically converted in the pixels 541A, 541B, 541C, and 541D of the first substrate 100 is transmitted to the pixel circuit 210 of the second substrate 200 for each pixel sharing unit 539 through the through-electrode 120E. A pixel signal based on the pixel signal is transmitted from the pixel circuit 210 to the third substrate 300 through the vertical signal line 543 and the contact sections 202 and 302. The pixel signal is processed in the column signal processing section 550 and the image signal processing section 560 of the third substrate 300, and then outputted to the outside through the output section 510B.

### [Effects]

In the present embodiment, the pixel transistor included in the pixel circuit 210 is allowed to have a three-dimensional structure, and the floating diffusion FD provided in the first substrate 100 and the pixel circuit 210 (specifically, the gate AG of the amplification transistor AMP) provided in the second substrate 200 are directly coupled to each other by the through-electrode 120E. This reduces the area for formation of the insulating region 212 formed in a plane of the semiconductor layer 200S, thus securing the area of the second substrate 200 in which the pixel circuit 210 is formed.

The CMOS image sensor (CIS) includes a light-receiving sensor section and a pixel circuit section including a source follower circuit. Although the cell size has been reduced year by year thanks to technological advances, a certain region for formation of the pixel circuit section is required, and thus it is difficult to achieve miniaturization. For this reason, as described above, an imaging element of a three-dimensional structure is being developed in which the light-receiving sensor section and the source follower circuit are formed in different substrates and the substrates are stacked on each other.

Incidentally, in the above-described imaging element of the three-dimensional structure, the respective substrates (corresponding to the first substrate 100 and the second substrate 200 in the present embodiment) in which the light-receiving sensor section and the source follower circuit are formed are electrically coupled to each other through a through-wiring line and a wiring line, etc. formed in a horizontal direction with respect to a main surface of the substrate in which the source follower circuit is formed. In this case, the periphery of the through-wiring line needs to be electrically insulated, and therefore the substrate in which the source follower circuit is formed requires an insulating region. Thus, a region where an element can be actually disposed is limited.

In contrast, in the present embodiment, the Fin-type FD-SOI is adopted as the pixel transistor included in the pixel circuit 210, and the floating diffusion FD (specifically, the pad section 120 formed in a region overlapping at least some of the plurality of floating diffusions FD1, FD2, FD3, and FD4 sharing the pixel circuit 210) provided in the first substrate 100 and the pixel circuit 210 (specifically, the gate AG of the amplification transistor AMP) are directly coupled to each other by the through-electrode 120E.

As described above, in the present embodiment, the area of the insulating region 212 formed in the plane of the semiconductor layer 200S is reduced to secure the area of the semiconductor layer 200S for formation of the pixel circuit 210. That is, it is possible to improve area efficiency of the pixel transistor included in the pixel circuit 210 in the second substrate 200.

In addition, in the present embodiment, the floating diffusion FD and the amplification transistor AMP are directly coupled to each other by the through-electrode 120E, thus making it possible to shorten the wiring line length, as compared with the case of coupling through the first wiring layer W1 and the coupling section 218V in addition to the through-electrode 120E, for example, as illustrated in FIG. 15. Therefore, it is possible to reduce the wiring capacity and thus to improve conversion efficiency. In addition, it is possible to reduce the noise.

Hereinafter, description is given of Modification Examples (Modification Examples 1 to 8) according to the first embodiment, a second embodiment, Modification Examples (Modification Examples 9 to 11) according to the second embodiment, and Modification Examples (Modification Examples 12 to 18) according to the first and second embodiments and Modification Examples 1 to 11. In the following, components similar to those of the foregoing first embodiment are denoted by the same reference numerals, and the descriptions thereof are omitted as appropriate.

### <2. Modification Examples>

### (2-1. Modification Example 1)

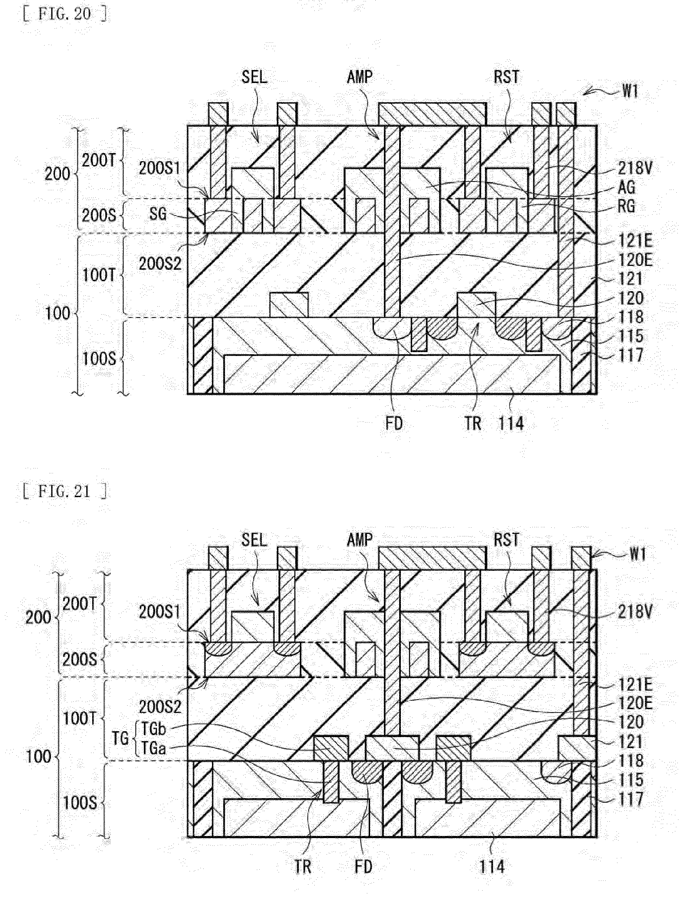

FIG. 20 schematically illustrates another example of the cross-sectional configuration of the main parts of the imaging device 1 according to the foregoing first embodiment, that is, the cross-sectional configuration of the first substrate 100 and the second substrate 200. In the foregoing first embodiment, the plurality of pixels 541 (e.g., the pixels 541A, 541B, 541C, and 541D) share one pixel circuit 210. However, as illustrated in FIG. 20, the present technology is also applicable to a structure in which one pixel circuit 210 is formed for one pixel 541, thus making it possible to achieve effects similar to those of the foregoing first embodiment.

### (2-2. Modification Example 2)

FIG. 21 schematically illustrates another example of the cross-sectional configuration of the main parts of the imaging device 1 according to the foregoing first embodiment, that is, the cross-sectional configuration of the first substrate 100 and the second substrate 200. In the foregoing first embodiment, the amplification transistor AMP, the selection transistor SEL, the reset transistor RST, and the FD conversion gain switching transistor FDG included in the pixel circuit 210 are exemplified as the Fin-type FD-SOI (Fully Depletion SOI). However, the pixel transistor other than the amplification transistor AMP may have a planar structure, for example, as illustrated in FIG. 21.

### (2-3. Modification Example 3)

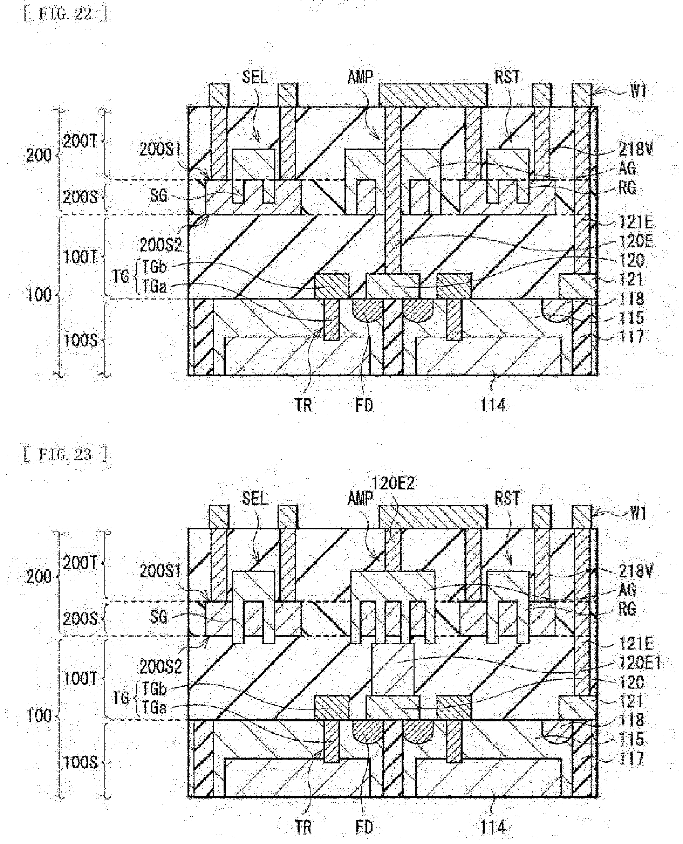

FIG. 22 schematically illustrates another example of the cross-sectional configuration of the main parts of the imaging device 1 according to the foregoing first embodiment, that is, the cross-sectional configuration of the first substrate 100 and the second substrate 200. In the foregoing first embodiment, the example is given in which all of the gates of the amplification transistor AMP, the selection transistor SEL, the reset transistor RST, and the FD conversion gain switching transistor FDG included in the pixel circuit 210 penetrate the semiconductor layer 200S. However, the gates of the pixel transistors other than the amplification transistor AMP may not penetrate the semiconductor layer 200S, as illustrated in FIG. 22.

### (2-4. Modification Example 4)

FIG. 23 schematically illustrates another example of the cross-sectional configuration of the main parts of the imaging device 1 according to the foregoing first embodiment, that is, the cross-sectional configuration of the first substrate 100 and the second substrate 200. In the foregoing first embodiment, the example is given in which the gate AG of the amplification transistor AMP and the source of the reset transistor RST, for example, are coupled to each other by the through-electrode 120E that couples the pad section 120 and the gate AG of the amplification transistor AMP to each other and further penetrates the gate AG to come into contact with the first wiring layer W1. However, this is not limitative.

Specifically, the coupling between the pad section 120 and the gate AG of the amplification transistor AMP and the coupling between the gate AG of the amplification transistor AMP and the first wiring layer W1 may be separated for coupling. In the present modification example, as illustrated in FIG. 23, the pad section 120 and the gate AG of the amplification transistor AMP are coupled to each other by a through-electrode 120E1, and the gate AG of the amplification transistor AMP and the first wiring layer W1 are coupled to each other by a through-electrode 120E2. This enables the pad section 120 and the gate AG of the amplification transistor AMP to be coupled to each other more securely, as compared with the structure illustrated in FIG. 13.

In addition, in the present modification example, at least an end portion of the gate AG of the amplification transistor AMP penetrating the semiconductor layer 200S protrudes toward the first substrate 100 from the surface 200S2 of the semiconductor layer 200S. This makes it possible to prevent contact between the through-electrode 120E1 and the semiconductor layer 200S.

### (2-5. Modification Example 5)

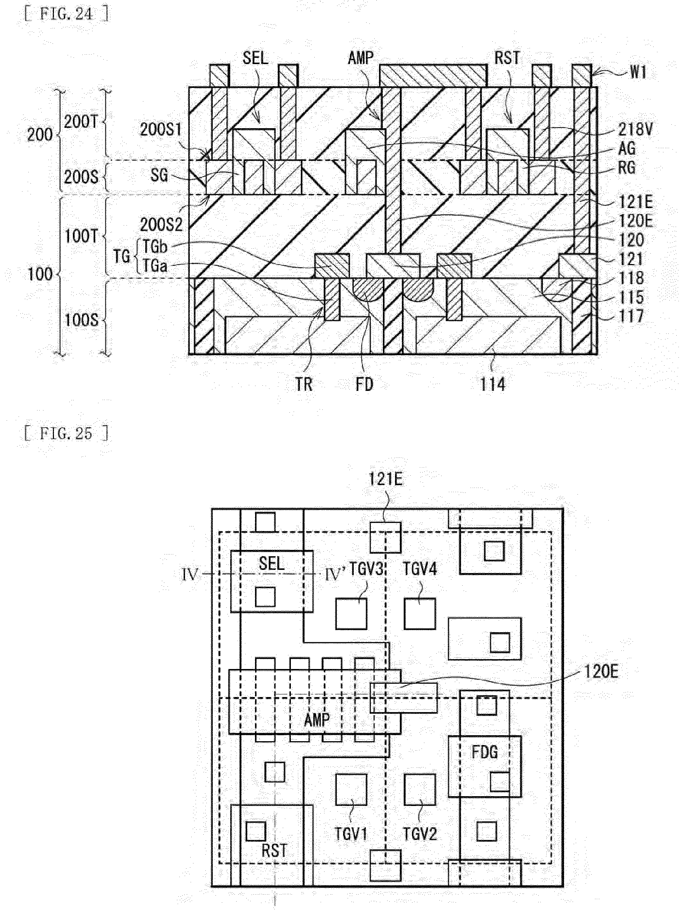

FIG. 24 schematically illustrates another example of the cross-sectional configuration of the main parts of the imaging device 1 according to the foregoing first embodiment, that is, the cross-sectional configuration of the first substrate 100 and the second substrate 200. FIG. 25 schematically illustrates a planar configuration of the second substrate 200 of the imaging device 1 illustrated in FIG. 24. In the foregoing first embodiment, the example is given in which the coupling between the pad section 120 and the amplification transistor AMP is performed by the through-electrode 120E penetrating the gate AG of the amplification transistor AMP. However, the through-electrode 120E need not necessarily penetrate the gate AG of the amplification transistor AMP. For example, as illustrated in FIG. 24, the through-electrode 120E may come into contact with a side surface of the gate AG of the amplification transistor AMP to thereby couple the pad section 120 and the amplification transistor AMP to each other. This facilitates working processes of the through-electrode 120E, as compared with the structure illustrated in FIG. 13.

It is to be noted that, in this case, the through-electrode 120E portion coupling the gate AG of the amplification transistor AMP and the first wiring layer W1 to each other is preferably formed to allow a portion of the through-electrode 120E to span a top surface of the gate AG of the amplification transistor AMP, as illustrated in FIG. 24. This makes it possible to securely couple the through-electrode 120E and the gate AG of the amplification transistor AMP to each other.

### (2-6. Modification Example 6)

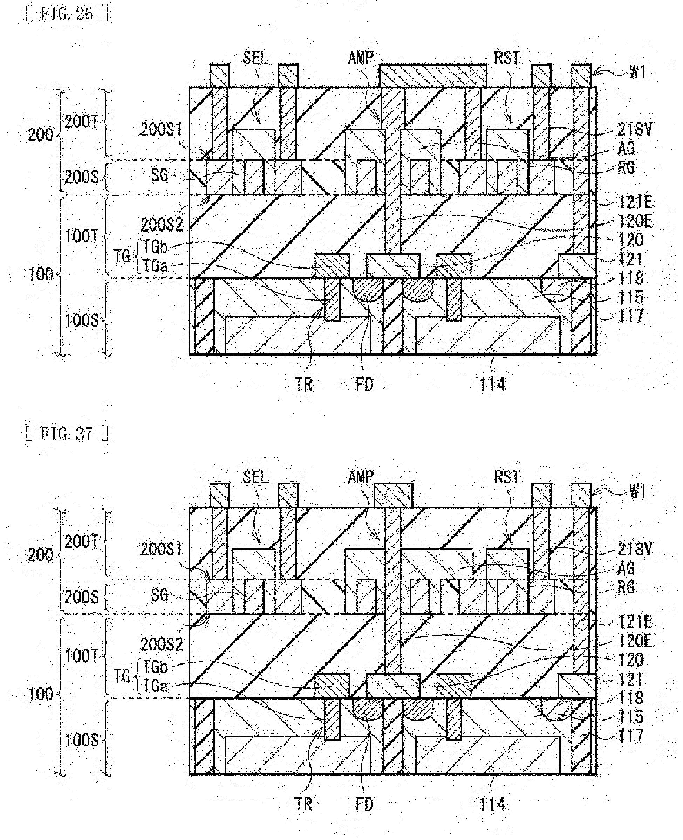

FIG. 26 schematically illustrates another example of the cross-sectional configuration of the main parts of the imaging device 1 according to the foregoing first embodiment, that is, the cross-sectional configuration of the first substrate 100 and the second substrate 200. In the foregoing first embodiment, the example is given in which the through-electrode 120E has a single width (single diameter). However, as illustrated in FIG. 26, the through-electrode 120E portion formed between the first wiring layer W1 and the gate AG of the amplification transistor AMP may be formed to have a larger width. Specifically, the through-electrode 120E portion may be formed to be larger than an interval between Fin-Fin of the amplification transistor AMP. This makes it possible to securely couple the through-electrode 120E and the gate AG of the amplification transistor AMP to each other.

### (2-7. Modification Example 7)

FIG. 27 schematically illustrates another example of the cross-sectional configuration of the main parts of the imaging device 1 according to the foregoing first embodiment, that is, the cross-sectional configuration of the first substrate 100 and the second substrate 200. In the foregoing first embodiment, the example is given in which the gate AG of the amplification transistor AMP and the source of the reset transistor RST are coupled to each other through the through-electrode 120E, the first wiring layer W1, and the coupling section 218V. However, this is not limitative.

For example, as illustrated in FIG. 27, the gate AG of the amplification transistor AMP may be extended in the horizontal direction to allow the gate AG of the amplification transistor AMP and the source of the reset transistor RST to be directly coupled to each other. This makes it possible to shorten the wiring line length between the amplification transistor AMP and the reset transistor RST. Therefore, it is possible to further reduce the wiring capacity, as compared with the structure illustrated in FIG. 13, and thus to further improve conversion efficiency. In addition, it is possible to further reduce the noise.

### (2-8. Modification Example 8)

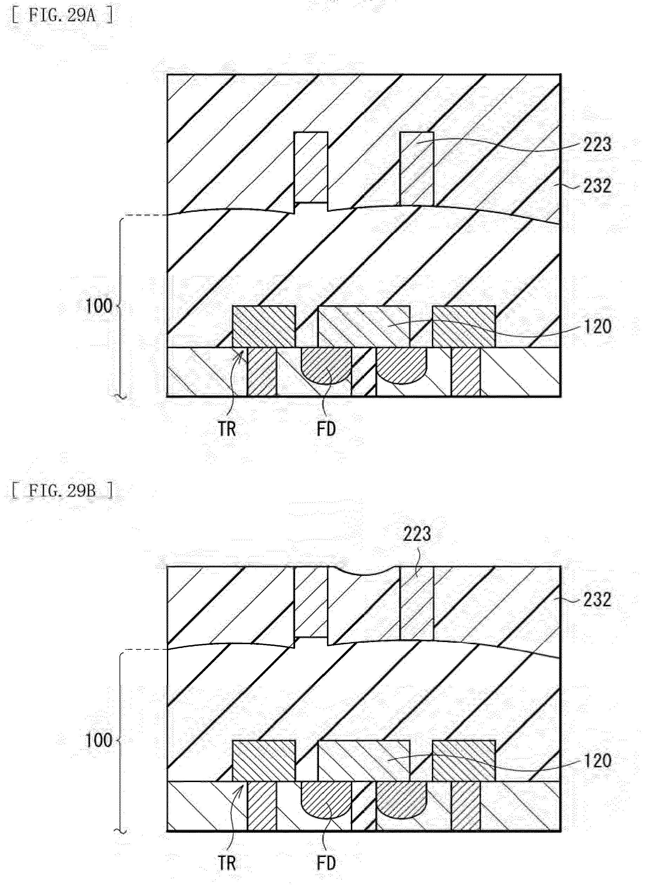

FIG. 29A to 29D each illustrate an example of a manufacturing step of the pixel transistor provided in the second substrate 200 described in the foregoing first embodiment.

In the foregoing first embodiment, the example is given, in FIG. 13, in which the gate (e.g., the gate AG) of the pixel transistor including the amplification transistor AMP penetrates the semiconductor layer 200S. However, in order to reduce the noise in such an amplification transistor AMP, it is desirable that the heights of the fins be substantially uniform.

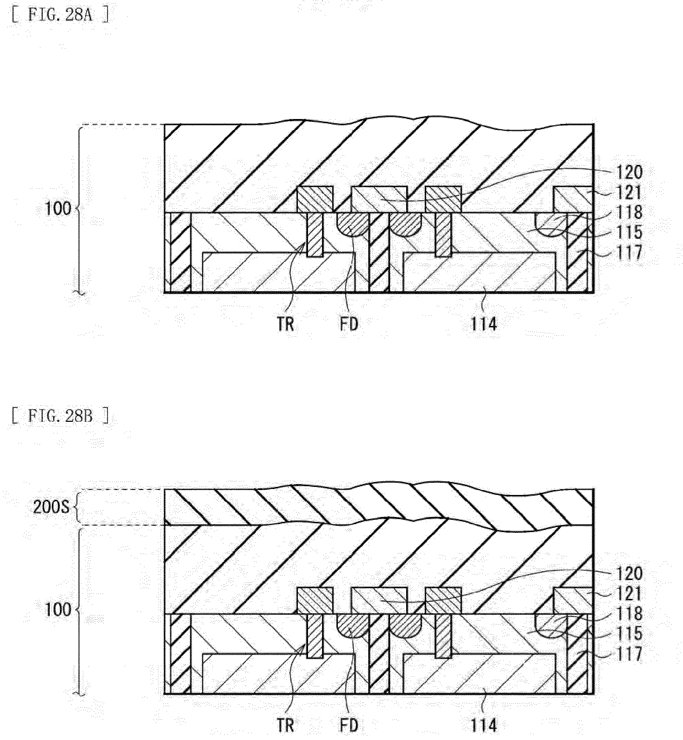

However, in the method of forming the pixel circuit 210 after attaching the first substrate 100 and the semiconductor layer 200S of the second substrate 200 together as in the first manufacturing method described above, irregularities may possibly be generated (see, e.g., FIG. 28A) on the front surface of the interlayer insulating film 123 due to influences of the horizontal portion TGb of the transfer gate TG and the pad sections 120 and 121 formed on the semiconductor layer 100S included in the first substrate 100. Thus, irregularities may possibly be formed also on the front surface (the surface 200S1) of the semiconductor layer 200S after thinning (see, e.g., FIG. 28B). In a case where the fins of the amplification transistor AMP are worked in such a state, dispersion occurs in the heights of the fins, thus causing the noise. Therefore, in general, the following methods are used to solve the dispersion in the heights of the fins.

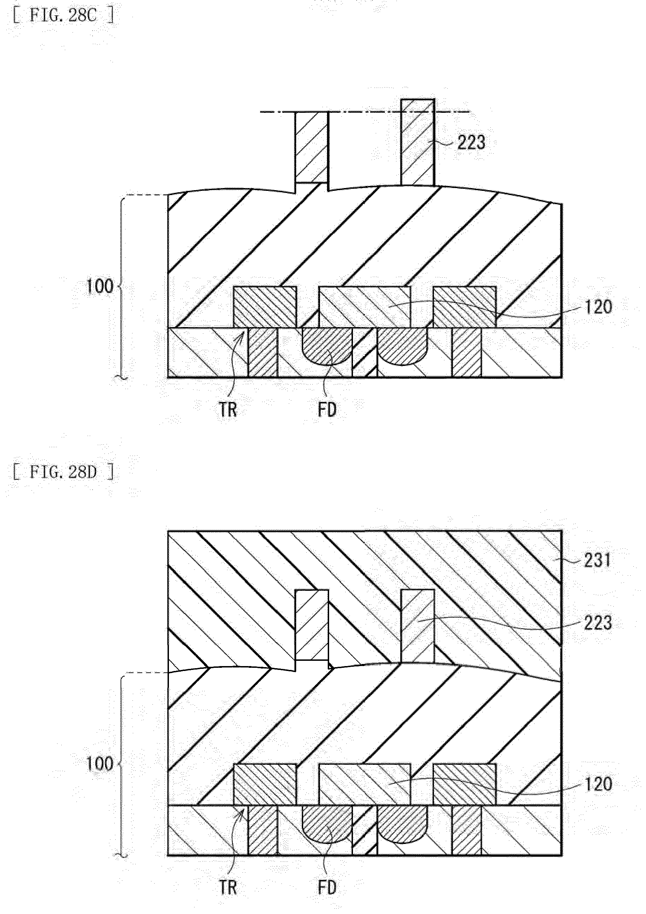

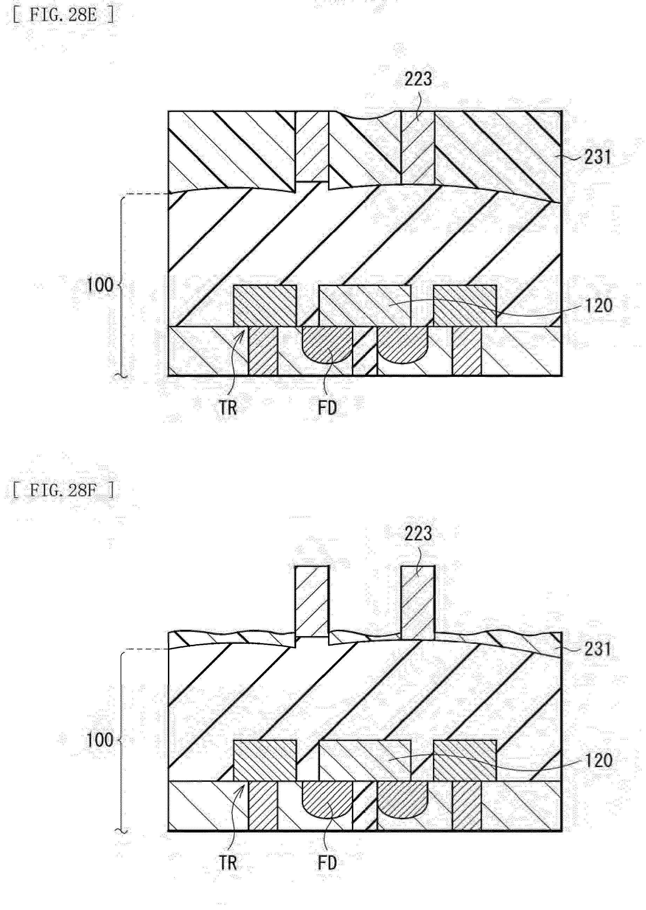

First, for example, dry etching is used to separate the semiconductor layer 200S for formation of a fin 223 as illustrated in FIG. 28C, and then an oxide film 231, for example, is used for backfill as illustrated in FIG. 28D. Thereafter, CMP, for example, is used to planarize the front surfaces of the oxide film 231 and the fin 223, in heights, as illustrated in FIG. 28E, and then dry etching is used again to etch the oxide film 231 again to a predetermined depth as illustrated in FIG. 28F. However, it is difficult for this manufacturing method to sufficiently reduce the dispersion in the heights of the fins 223 exposed from the oxide film 231 due to the dispersion in the planarization by CMP or the dispersion in the etching depths.

In contrast, in the present modification example, the fin 223 is first backfilled with, for example, an ultraviolet (UV) light-absorbing film (a light-absorbing film 232). Examples of a material of the light-absorbing film 232 include silicon oxide (SiN). Hereinafter, description is given, with reference to FIGs. 29A to 29D, of an example of a manufacturing step of the pixel transistor of the present modification example.

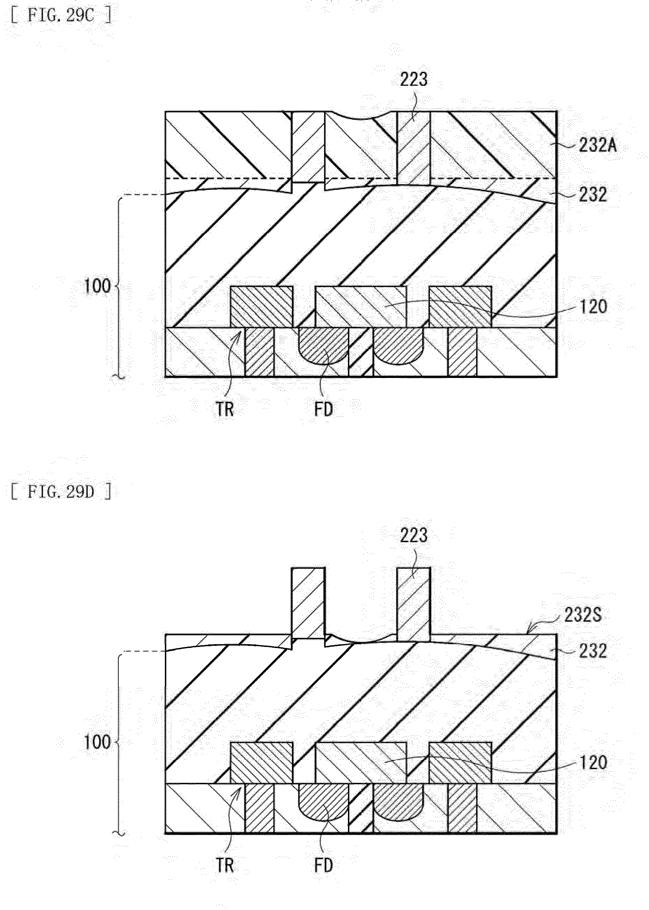

First, as illustrated in FIG. 29A, the fin 223 is embedded by the light-absorbing film 232. Next, as illustrated in FIG. 29B, for example, CMP is used to planarize the front surfaces of the light-absorbing film 232 and the fin 223, in heights. Subsequently, as illustrated in FIG. 29C, for example, UV light is irradiated to cut the bonding of the light-absorbing film 232 and form a layer 232A having a fast etching rate inside the light-absorbing film 232, and then etching is performed. As illustrated in FIG. 29D, this allows an etched surface having a flat front surface (a surface 232S) to be formed on the light-absorbing film 232. Thus, it is possible to further reduce the dispersion in the heights of the fins 223 exposed from the light-absorbing film 232 by etching, as compared with the manufacturing method described above.

In addition, the penetration length of UV light entering the light-absorbing film 232 may be changed by intensity of UV light to be irradiated. Therefore, changing the intensity of the UV light depending on the shape of the front surface of the light-absorbing film 232 to eliminate the dispersion in the planarization by CMP makes it possible to further reduce the dispersion in the heights of the fins 223 exposed from the light-absorbing film 232.

It is to be noted that the light-absorbing film 232 is not limited to the film absorbing the UV light; it is sufficient for the light-absorbing film 232 to be any film as long as the film absorbs a predetermined wavelength. Examples of other materials of the light-absorbing film 232 include silicon oxynitride, aluminum oxide, hafnium oxide, and zirconium oxide. The light to be irradiated on the light-absorbing film 232 may be light other than the UV light; however, it is preferable to use light of a short wavelength in consideration of light energy and the influence of diffracted light.

In addition, the present technology is also applicable, for example, to the manufacture of the pixel transistors in which the fins 223 are not independent of each other, such as the selection transistor SEL and the reset transistor RST illustrated in FIG. 22.

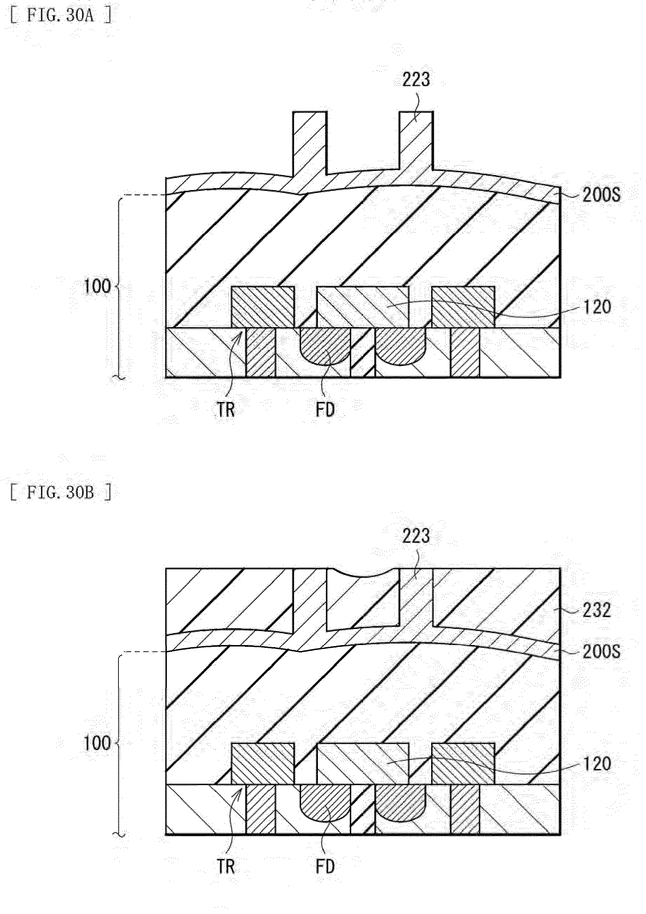

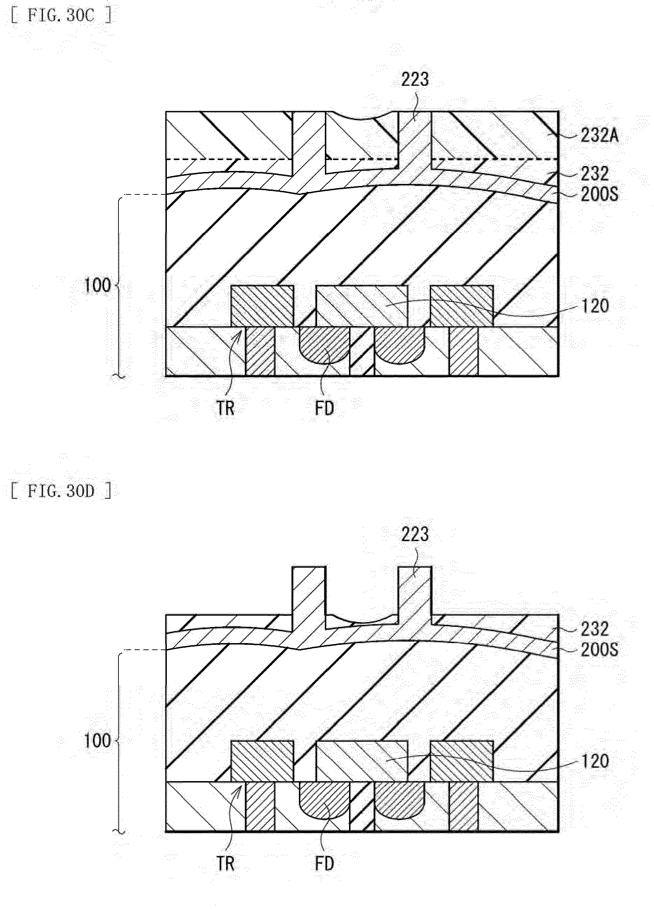

FIGs. 30A to 30D each illustrate an example of a manufacturing method of pixel transistors in which the fins 223 are not independent of each other. After forming the fins 223 which are continuous to each other while leaving a portion of the semiconductor layer 200S as illustrated in FIG. 30A, the light-absorbing film 232 is formed on the semiconductor layer 200S to embed the fins 223 and planarize the front surfaces of the light-absorbing film 232 and the fins 223, in heights, as illustrated in FIG. 30B. Subsequently, as illustrated in FIG. 30C, for example, UV light is irradiated to form the layer 232A having a fast etching rate inside the light-absorbing film 232, and then etching is performed. As illustrated in FIG. 30D, this reduces the dispersion in the heights of the fins 223 exposed from the light-absorbing film 232.

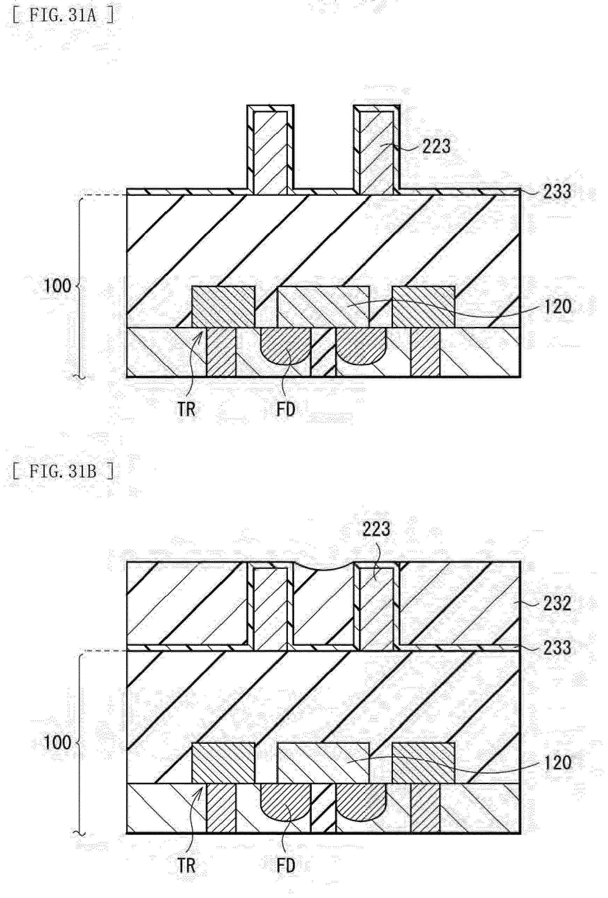

FIGs. 31A to 31D each illustrate another example of the manufacturing step of the pixel transistor provided in the second substrate 200 of the present modification example. A light-absorbing film 232 having a higher absorption coefficient than that of the light-absorbing film 232 may be formed in advance on the front surface of the fin 223.

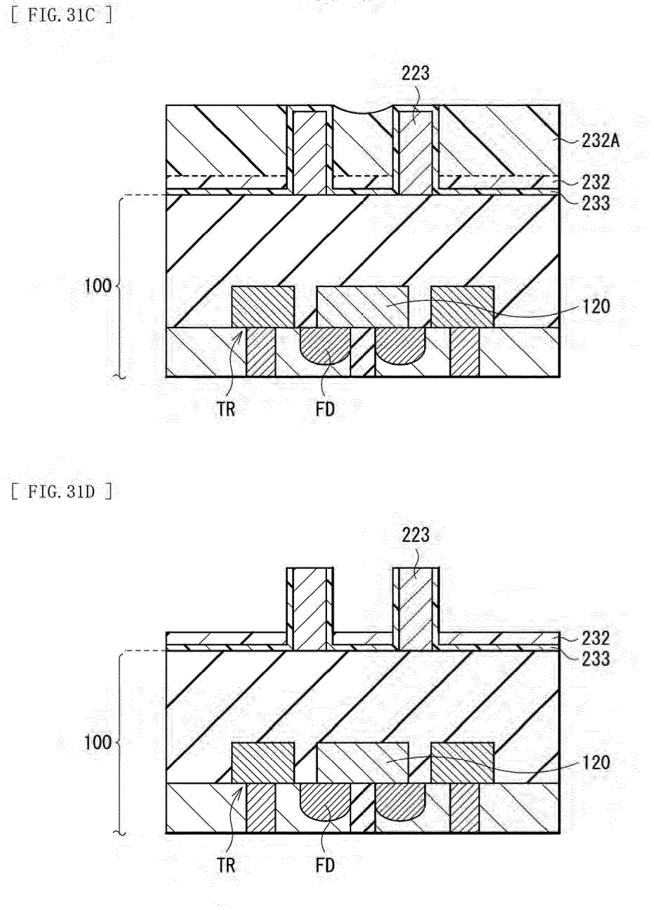

First, as illustrated in FIG. 31A, the light-absorbing film 232 is formed on the front surface of the fin 223 and on the first substrate 100. Next, as illustrated in FIG. 31B, the light-absorbing film 232 is formed in a manner similar to those described above to embed the fin 223, and then the front surfaces of the light-absorbing film 232 and the fin 223 are planarized. Subsequently, as illustrated in FIG. 31C, UV light is irradiated to form the layer 232A having a fast etching rate inside the light-absorbing film 232. Thereafter, etching is performed as illustrated in FIG. 31D. In this manner, forming the light-absorbing film 232 having a higher absorption coefficient than that of the light-absorbing film 232 on the front surface of the fin 223 makes it possible to reduce formation of defect caused by irradiation of the UV light on the fin 223.

### <3.Second Embodiment>

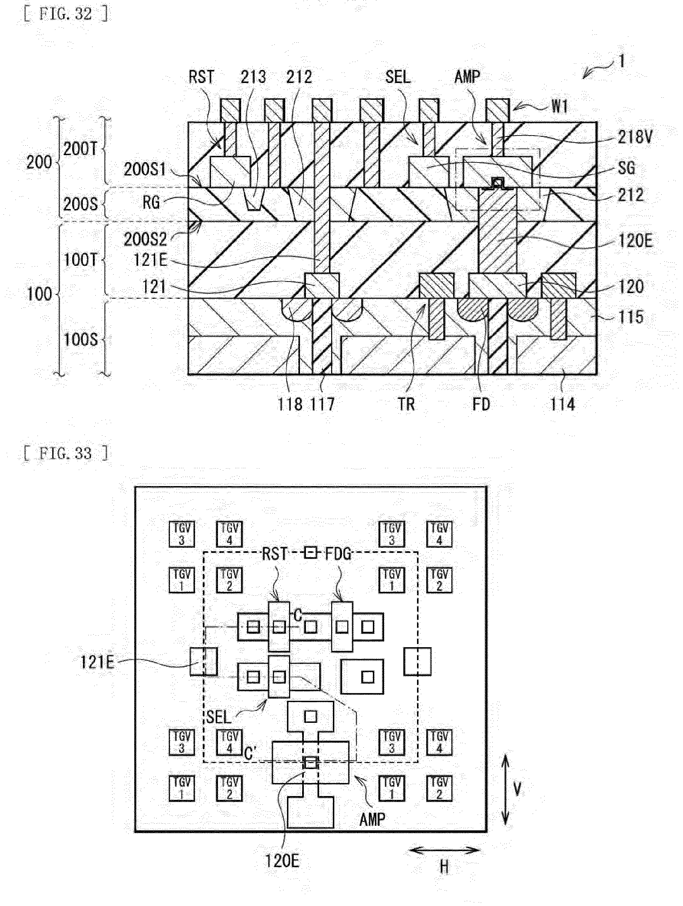

FIG. 32 schematically illustrates an example of a cross-sectional configuration of the first substrate 100 and the second substrate 200 as main parts of the imaging device 1 according to a second embodiment of the present disclosure. FIG. 33 schematically illustrates a planar configuration of the second substrate 200 in the imaging device 1 illustrated in FIG. 32. It is to be noted that FIG. 32 illustrates, in a simplified manner, a cross-section taken along a line C-C' illustrated in FIG. 33. In the foregoing first embodiment, the example is given in which the Fin-type FD-SOI (Fully Depletion SOI) is adopted as the amplification transistor AMP directly coupled to the pad section 120 by the through-electrode 120E (see, e.g., FIG. 13). However, the amplification transistor AMP may have another three-dimensional structure. Description is given in detail, in the present embodiment, of a case where the amplification transistor AMP has a GAA (Gate All Around) structure.

### [Configuration of Amplification Transistor AMP]

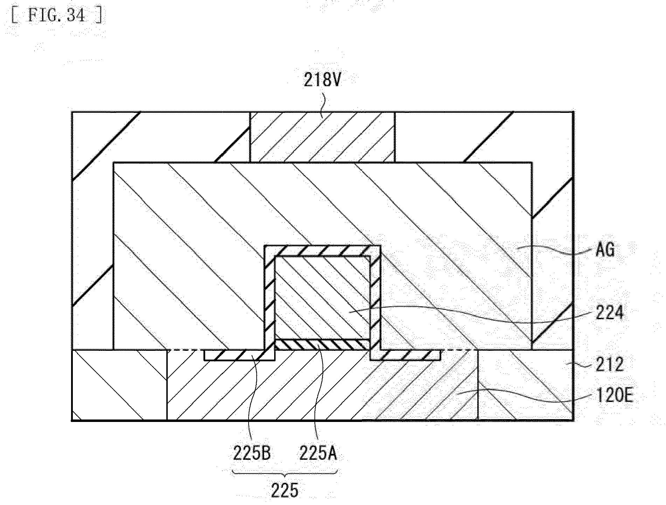

FIG. 34 is an enlarged view of the amplification transistor AMP in an alternate long and short dashed line illustrated in FIG. 32. The amplification transistor AMP has a GAA structure in which the gate AG is provided continuously around a channel 224. In the amplification transistor AMP of the present embodiment, a portion of a gate insulating film 225 that electrically insulates the gate AG and the channel 224 from each other is formed to be wider than the width of the channel 224. Specifically, the gate insulating film 225 provided on a surface (undersurface) of the channel 224 opposed to the pad section 120, of the gate insulating film 225 provided around the channel 224 extending in the V direction, is formed to be wider than the width of the channel 224 in the H direction. More particularly, the gate insulating film 225 extending outward beyond the undersurface of the channel 224 extends closer to the first substrate 100 at a position one step lower than the gate insulating film 225 provided on the undersurface of the channel 224. In addition, the through-electrode 120E is coupled to the gate AG in a manner similar to the foregoing first embodiment. In the present embodiment, the through-electrode 120E serves also as the gate AG of the amplification transistor AMP formed below the channel 224.

### [Method of Manufacturing Amplification Transistor AMP]

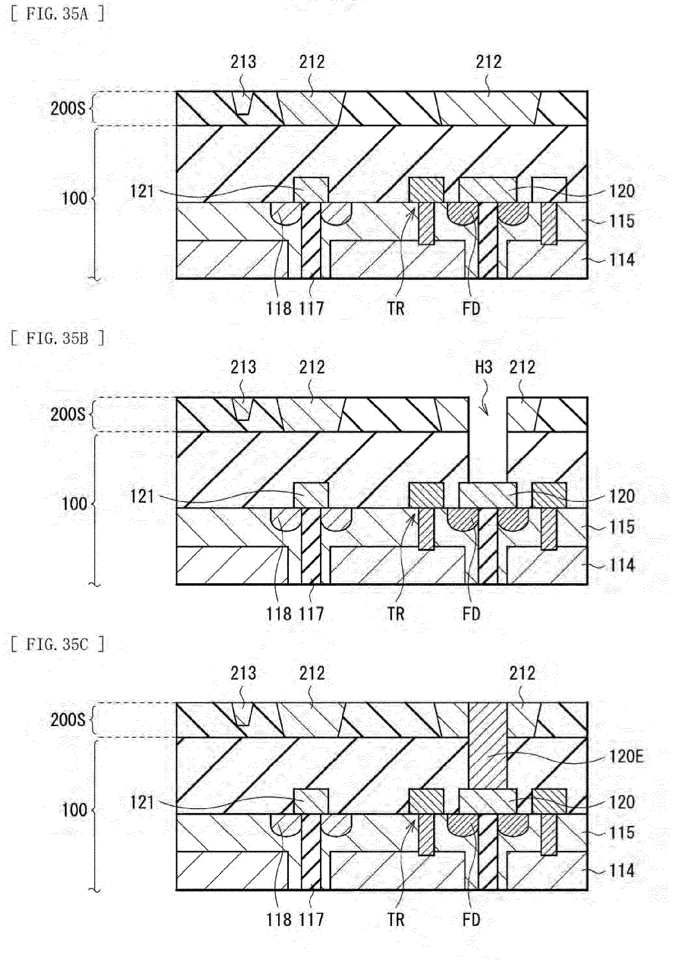

Hereinafter, description is given of a method of manufacturing the amplification transistor AMP according to the present embodiment. FIGs. 35A to 35I each illustrate an example of a manufacturing step of the amplification transistor AMP illustrated in FIGs. 32 to 34.

First, as illustrated in FIG. 35A, the semiconductor layer 200S is attached to the first substrate 100, and the insulating region 212 and the element separation region 213 are formed at predetermined positions. Next, as illustrated in FIG. 35B, an opening H3 reaching the pad section 120 is formed in the insulating region 212 formed above the pad section 120. Subsequently, as illustrated in FIG. 35C, after polysilicon is embedded inside the opening H3, for example, CMP is used to remove the polysilicon provided on the semiconductor layer 200S, and the front surface of the semiconductor layer 200S including the insulating region 212 and the element separation region 213 is planarized. This allows for formation of the through-electrode 120E that serves also as the gate AG of the amplification transistor AMP.

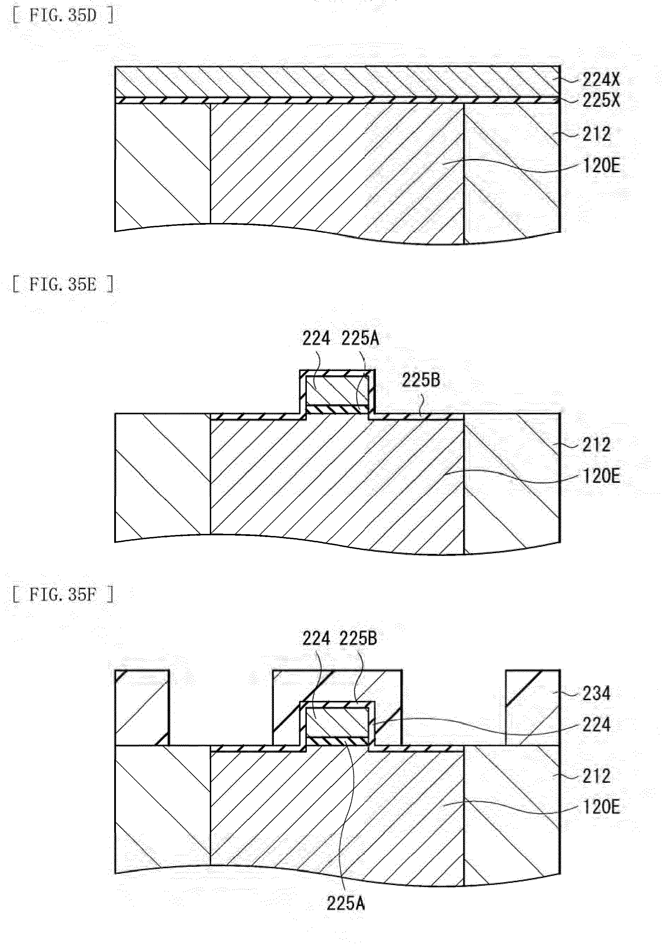

Next, as illustrated in FIG. 35D, for example, a silicon oxide film 225X and a polysilicon film 224X are formed in order on the semiconductor layer 200S including the insulating region 212, the element separation region 213, and the through-electrode 120E. Subsequently, for example, photolithography and etching are used to work the polysilicon film 224X and the silicon oxide film 225X. As illustrated in FIG. 35E, this allows for formation of the channel 224 of the amplification transistor AMP and a gate insulating film 225A covering the undersurface of the channel 224. Thereafter, an annealing treatment is used to form a thermal oxide film on the front surfaces of the through-electrode 120E and the channel 224. This thermal oxide film is to serve as a gate insulating film 225B extending on the top surface and the side surface of the channel 224 and extending outward beyond the undersurface of the channel 224.

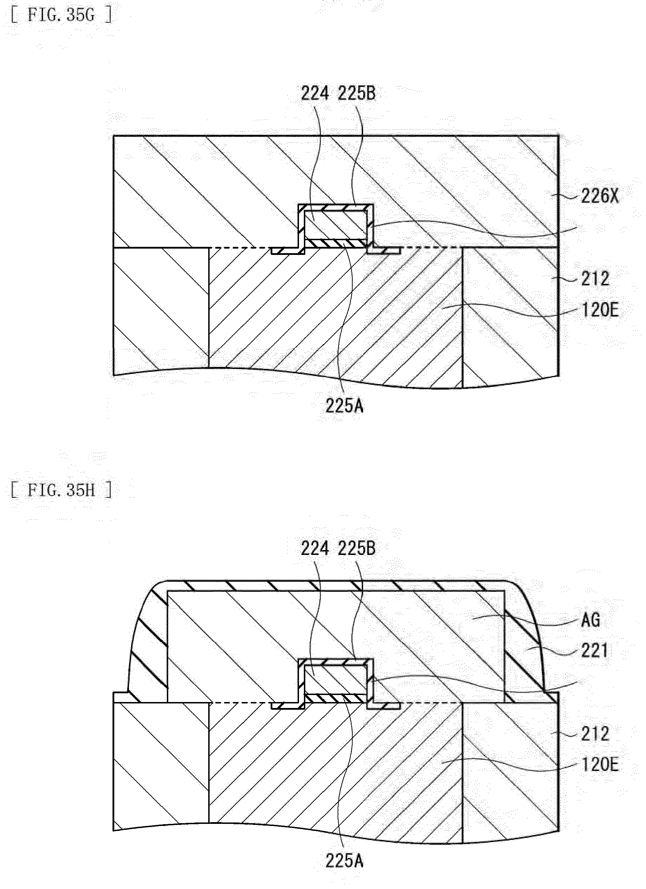

Next, as illustrated in FIG. 35F, for example, photolithography is used to form a resist film 234 having an opening at a predetermined position. Subsequently, as illustrated in FIG. 35G, for example, etching is used to remove the thermal oxide film on the through-electrode 120E exposed from the resist film 234, and then the resist film 234 is removed to form a polysilicon film 226X on the semiconductor layer 200S including the insulating region 212, the element separation region 213, the through-electrode 120E, the channel 224 provided on the through-electrode 120E, and the like.

Next, as illustrated in FIG. 35H, for example, photolithography and etching are used to work the polysilicon film 226X. This allows for formation of the gate AG of the amplification transistor AMP covering the side surface and the top surface of the channel 224 and a gate (unillustrated) of another pixel transistor. As described above, the amplification transistor AMP is completed that includes the gate insulating film 225 in which the gate insulating film 225B extending wider than the width of the channel 224 in the H direction and extending wider than the width of the channel 224 in the H direction is formed at a position one step lower than the gate insulating film 225A provided on the undersurface of the channel 224. Thereafter, as illustrated in FIG. 35H, the passivation film 221 is formed that covers the gate AG of the amplification transistor AMP and the gate (unillustrated) of another pixel transistor.

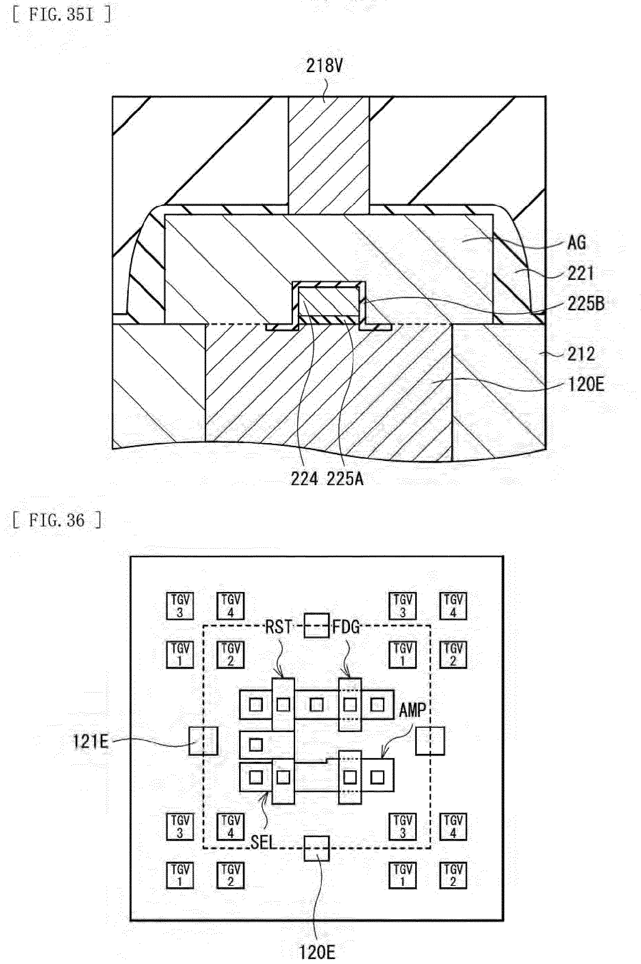

Subsequently, as illustrated in FIG. 35I, the interlayer insulating film 222 is formed on the passivation film 221, and then the coupling section 218V reaching the gate of the pixel transistor including the amplification transistor AMP and the through-electrode 121E, etc. (unillustrated) reaching pad section 121 are formed. Thereafter, the first wiring layer W1 is formed. As described above, the second substrate 200 of the imaging device 1 illustrated in FIG. 32 is formed.

### [Effects]

As described above, in the present embodiment, the amplification transistor AMP is allowed to have the GAA structure, and the floating diffusion FD (specifically, the pad section 120) and the amplification transistor AMP are directly coupled to each other by the through-electrode 120E. Thus, as compared with the common layout of the pixel circuit 210 as illustrated in FIG. 36, for example, it is possible to secure a large area for formation of the pixel circuit 210 inside the second substrate 200 (see FIG. 33). That is, in a manner similar to the foregoing first embodiment, it is possible to improve the area efficiency of the pixel transistor included in the pixel circuit 210 in the second substrate 200.

In addition, in the present embodiment, in a manner similar to the foregoing first embodiment, it is possible to shorten the wiring line length between the pad section 120 and the amplification transistor AMP, which makes it possible to reduce the wiring capacity and thus to improve the conversion efficiency. In addition, it is possible to reduce the noise.

Further, in a case where a common manufacturing method is used to form the amplification transistor AMP of the GAA structure in the second substrate 200, there is a possibility that electrical conduction with the floating diffusion FD may not be achieved due to formation of an oxide film at the contact portion (e.g., the front surface of the pad section 120) with the floating diffusion FD when forming a gate insulating film around the channel.

In contrast, in the present embodiment, the opening H3 reaching the pad section 120 is formed in advance, and polysilicon is embedded inside the opening H3 to form the through-electrode 120E; thereafter, the channel 224 is formed, and annealing is used to form the gate insulating film 225. This prevents an oxide film from being formed on the front surface of the pad section 120, thus making it possible to achieve electrical conduction between the pad section 120 and the amplification transistor AMP. Thus, it is possible to improve manufacturing yield as well as reliability.

### <4. Modification Examples>

### (4-1. Modification Example 9)

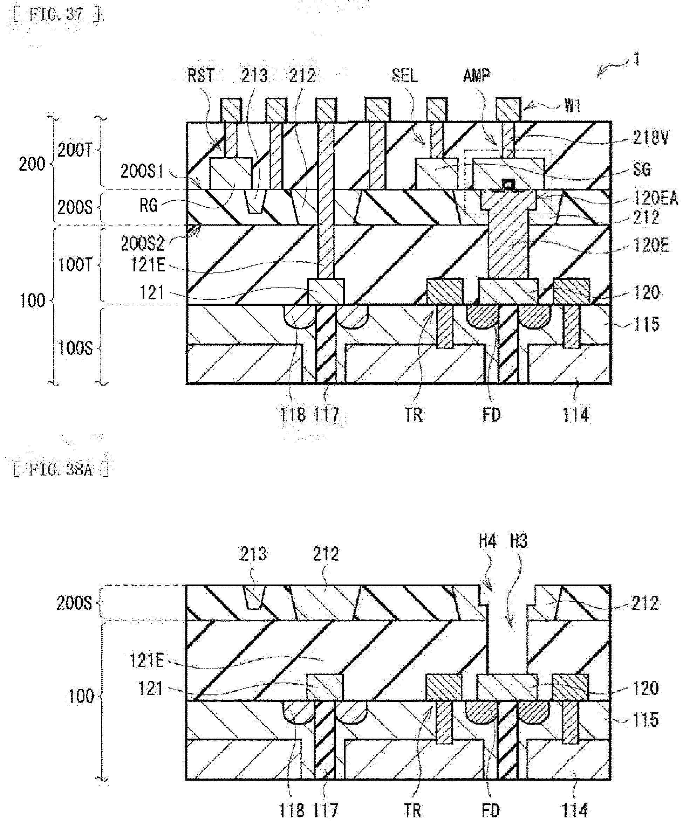

FIG. 37 schematically illustrates another example of the cross-sectional configuration of the main parts of the imaging device 1 in the foregoing second embodiment, that is, the cross-sectional configuration of the first substrate 100 and the second substrate 200. The present modification example differs from the foregoing second embodiment in that an increased width section 120EA is provided at an upper part of the through-electrode 120E that is embedded in the insulating region 212 and serves also as the gate AG on a side of the undersurface of the channel 224 of the amplification transistor AMP.

FIGs. 38A to 38E each illustrate an example of a manufacturing step of the amplification transistor AMP illustrated in FIG. 37.

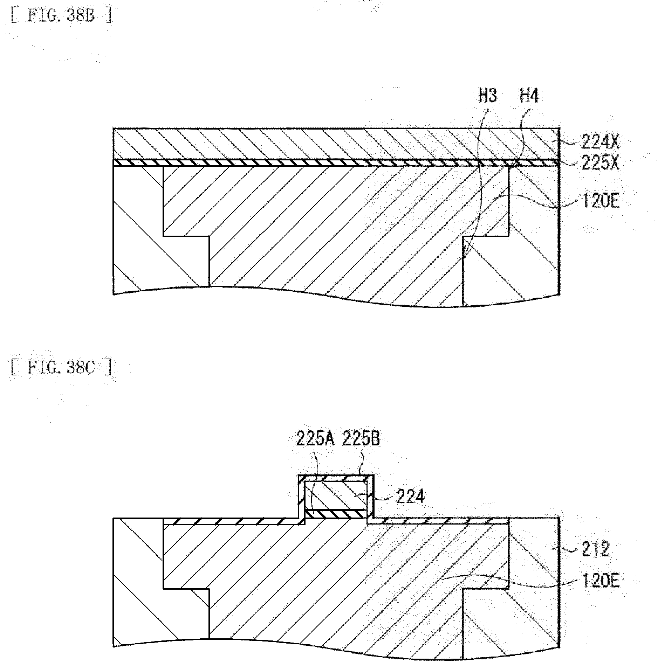

First, as illustrated in FIG. 38A, the semiconductor layer 200S is attached to the first substrate 100, and the insulating region 212 and the element separation region 213 are formed at predetermined positions. Thereafter, the opening H3 reaching the pad section 120 and an opening H4 wider than the opening H3 are formed in the insulating region 212 formed above the pad section 120. Next, in a manner similar to the foregoing second embodiment, as illustrated in FIG. 38B, the opening H3 and the opening H4 are filled with polysilicon, and, for example, the silicon oxide film 225X and the polysilicon film 224X are formed on the semiconductor layer 200S including the insulating region 212, the element separation region 213, and the through-electrode 120E.

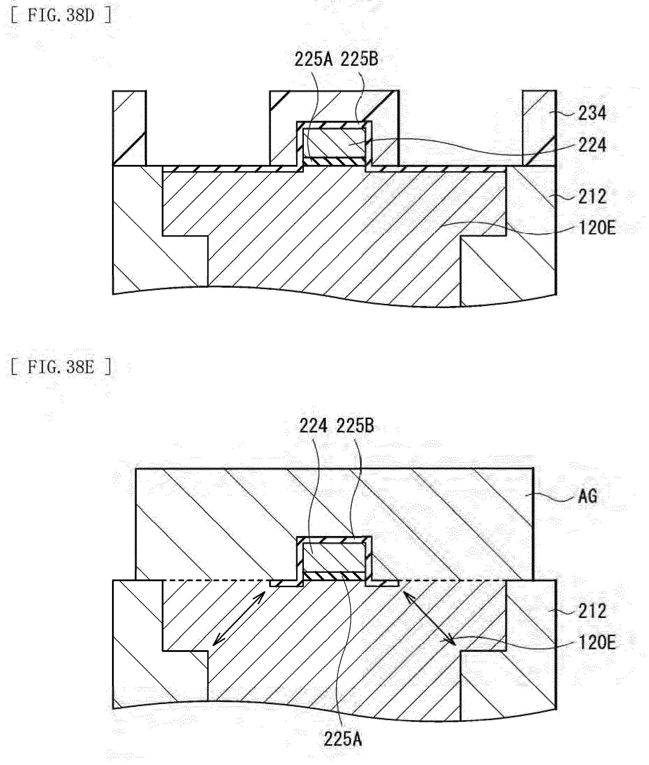

Subsequently, as illustrated in FIG. 38C, the polysilicon film 224X and the silicon oxide film 225X are worked to form the channel 224 and the gate insulating film 225A, and then an annealing treatment is used to form a thermal oxide film to serve as the gate insulating film 225B on the front surfaces of the through-electrode 120E and the channel 224. Next, as illustrated in FIG. 38D, for example, photolithography is used to form the resist film 234 having an opening at a predetermined position.

Subsequently, in a manner similar to the foregoing second embodiment, for example, etching is used to remove the thermal oxide film on the through-electrode 120E exposed from the resist film 234, and then the resist film 234 is removed to form the polysilicon film 226X on the semiconductor layer 200S including the insulating region 212, the element separation region 213, the through-electrode 120E, the channel 224 provided on the through-electrode 120E, and the like. Next, as illustrated in FIG. 38E, for example, photolithography and etching are used to work the polysilicon film 226X and form the gate AG. Thereafter, in a manner similar to the foregoing second embodiment, the passivation film 221, the interlayer insulating film 222, and the first wiring layer W1 are sequentially formed. As described above, the second substrate 200 of the imaging device 1 illustrated in FIG. 37 is formed.

In this manner, in the present modification example, the increased width section 120EA is provided at the upper part of the through-electrode 120E that is embedded in the insulating region 212 and serves also as the gate AG on the side of the undersurface of the channel 224 of the amplification transistor AMP. In other words, a portion, embedded in the insulating region 212, of the gate AG provided around the channel 224 is provided with a raised part having a diameter larger than a wiring diameter of the through-electrode 120E. As indicated by arrows illustrated in FIG. 38E, a distance between an end portion of the gate insulating film 225B and a contact section between the through-electrode 120E and the gate AG is increased as compared with the foregoing second embodiment. This allows a margin of conduction failure between the pad section 120 and the amplification transistor AMP to be increased, thus making it possible to further improve manufacturing yield as well as reliability.

### (4-2. Modification Example 10)

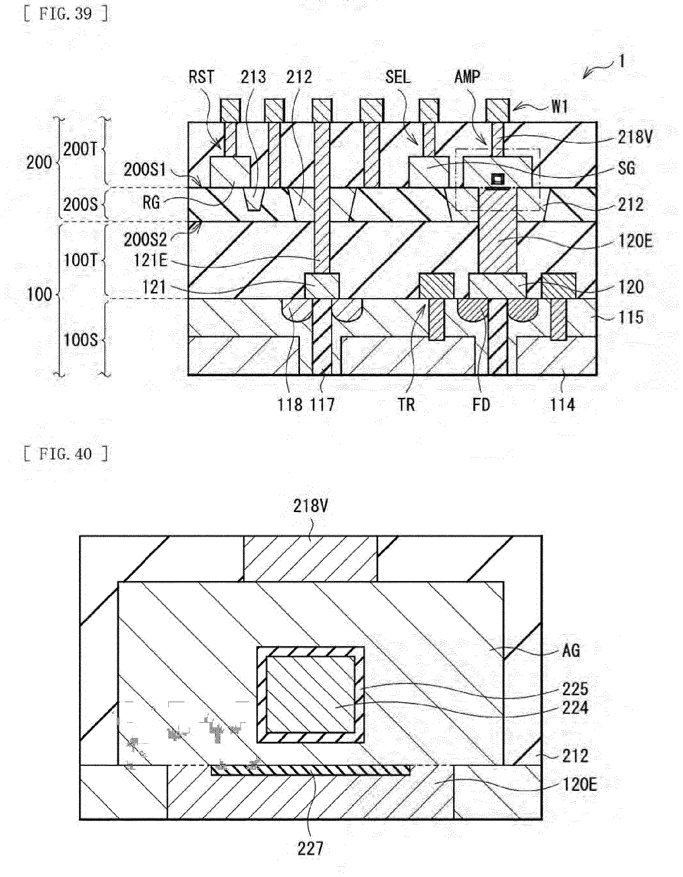

FIG. 39 schematically illustrates another example of the cross-sectional configuration of the main parts of the imaging device 1 according to the foregoing second embodiment, that is, the cross-sectional configuration of the first substrate 100 and the second substrate 200. FIG. 40 is an enlarged view of the amplification transistor AMP in an alternate long and short dashed line illustrated in FIG. 39. The present modification example differs from the foregoing second embodiment in that a thermal oxide film 227, which is wider than the width in the H direction of the channel 224 and is provided spaced apart from the channel 224 and the gate insulating film 225, is formed below the channel 224 in the gate AG.

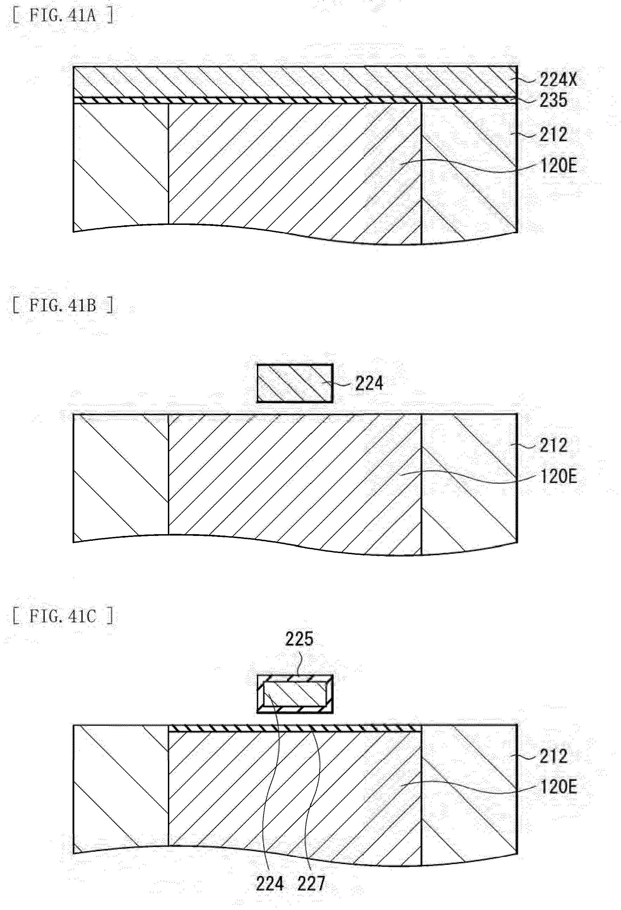

FIGs. 41A to 41E each illustrate an example of a manufacturing step of the amplification transistor AMP illustrated in FIGs. 39 and 40.

First, as illustrated in FIG. 41A, a sacrificial layer 235 including, for example, silicon germanium (SiGe) and the polysilicon film 224X are formed in order on the semiconductor layer 200S including the insulating region 212, the element separation region 213, and the through-electrode 120E. Next, as illustrated in FIG. 41B, for example, photolithography and wet etching are used to work the polysilicon film 224X and form the channel 224, and the sacrificial layer 235 is removed.

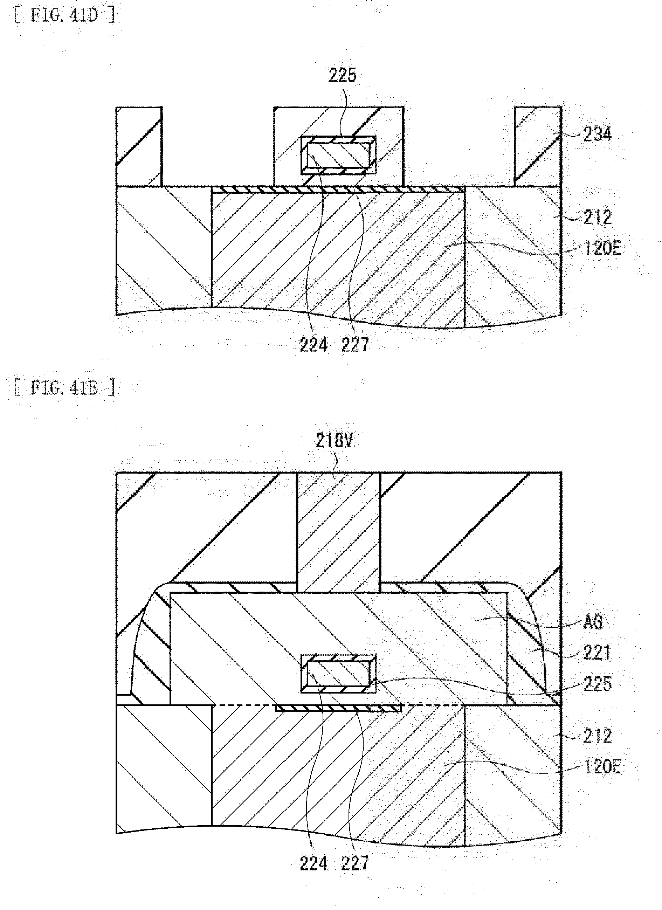

Subsequently, an annealing treatment is performed to form the gate insulating film 225 and the thermal oxide film 227, respectively, on the channel 224 and the through-electrode 120E, as illustrated in FIG. 41C. Next, as illustrated in FIG. 41D, in a manner similar to the foregoing second embodiment, the resist film 234 having an opening at a predetermined position is formed. Subsequently, for example, etching is used to remove the thermal oxide film 227 on the through-electrode 120E exposed from the resist film 234. Thereafter, the resist film 234 is removed, and the polysilicon film 226X is formed on the semiconductor layer 200S including the insulating region 212, the element separation region 213, the through-electrode 120E, the channel 224 provided on the through-electrode 120E, and the like. Next, as illustrated in FIG. 41E, for example, photolithography and etching are used to work the polysilicon film 226X and form the gate AG, and then the passivation film 221, the interlayer insulating film 222, and the first wiring layer W1 are sequentially formed in a manner similar to the foregoing second embodiment. As described above, the second substrate 200 of the imaging device 1 illustrated in FIG. 39 is formed.

As described above, in the present modification example, the sacrificial layer 235 and the polysilicon film 224X are formed in this order on the semiconductor layer 200S including the insulating region 212, the element separation region 213, and the through-electrode 120E. Thereafter, the polysilicon film 224X is worked to form the channel 224, and thermal oxidation is used to form the gate insulating film 225. This makes it possible to improve manufacturing yield as well as reliability, in addition to the effects of the foregoing first embodiment, as compared with the case of using the common method of manufacturing the amplification transistor AMP having the GAA structure, in a manner similar to the foregoing second embodiment.

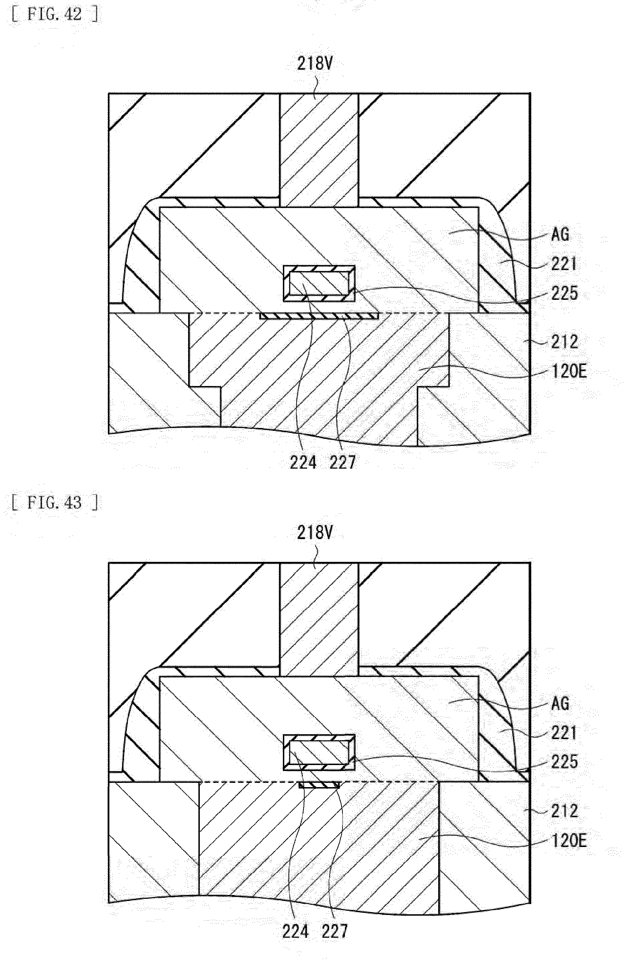

In addition, the present modification example may also be combined with Modification Example 9, as illustrated in FIG. 42. In addition, controlling a range of formation of the resist film 234 as well as etching time and condition, etc. also enables the thermal oxide film 227 to be formed to be narrower than the width in the H direction of the channel 224, as illustrated in FIG. 43. This allows the distance between an end portion of the thermal oxide film 227 and the contact section between the through-electrode 120E and the gate AG to be increased. This allows a margin of conduction failure between the pad section 120 and the amplification transistor AMP to be further increased, thus making it possible to further improve manufacturing yield as well as reliability.

### (4-3. Modification Example 11)

Description is given, in the present modification example, of a method of selectively removing the sacrificial layer 235 below the channel 224 and leaving the sacrificial layer 235 formed below a source 224S and a drain 224D formed at both ends of the channel 224, when forming the amplification transistor AMP using the method described in the foregoing Modification Example 10.

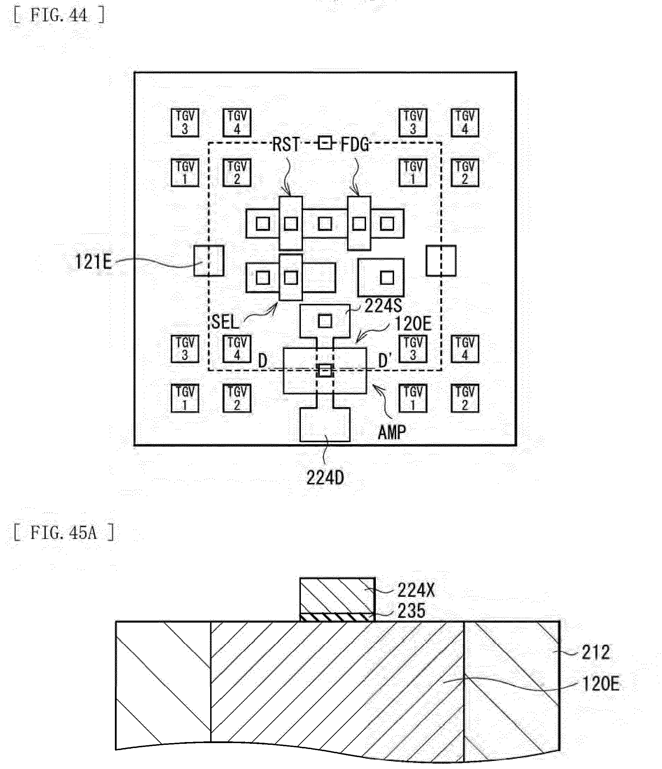

In a case of forming the amplification transistor AMP using the method exemplified in the foregoing Modification Example 10, the sacrificial layer 235 formed below the polysilicon film 224X included in the channel 224 is removed by wet etching or the like during working of the polysilicon film 224X. However, it is desirable that the sacrificial layer 235 below the polysilicon film 224X included in the source 224S and the drain 224D formed at both ends of the channel 224 remain not to detach the polysilicon film 224X. For this reason, the polysilicon film 224X of the portions of the source 224S and the drain 224D is generally worked to be larger than the portion of the channel 224, for example, as illustrated in FIG. 44.

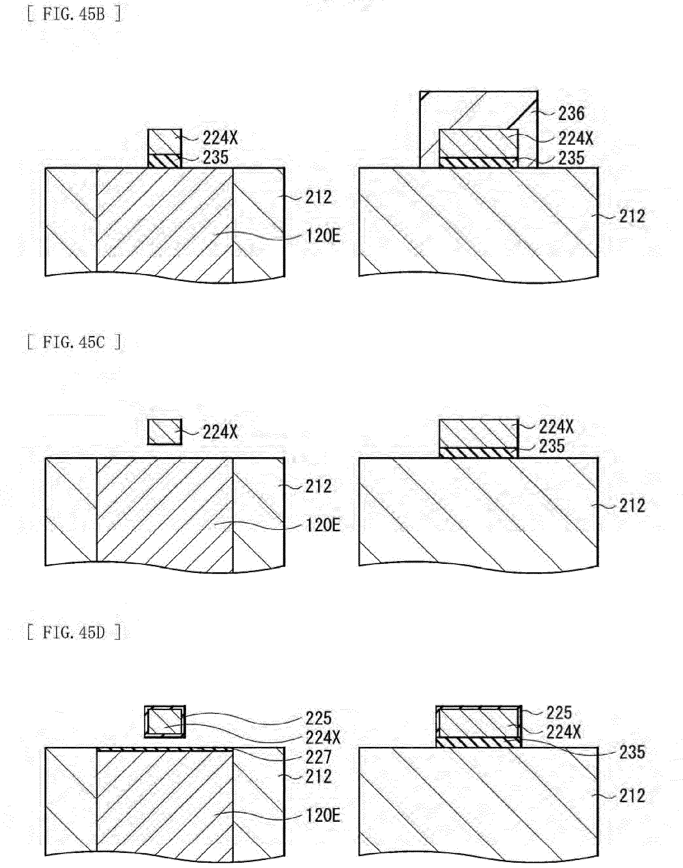

FIGs. 45A to 45J each illustrate an example of a manufacturing step of the amplification transistor AMP in the present modification example. It is to be noted that FIGs. 45B to 45J each illustrate, in (A), a cross-section (the portion of the channel 224) taken along the line C-C' illustrated in FIG. 44, and illustrate, in (B), a cross-section (the portion of the drain 224D) taken along a line D-D'.

First, as illustrated in FIG. 45A, the sacrificial layer 235 and the polysilicon film 224X formed on the semiconductor layer 200S including the insulating region 212, the element separation region 213, and the through-electrode 120E are worked into predetermined shapes. Next, as illustrated in FIG. 45B, a resist film 236 is formed at both end portions of the polysilicon film 224X which is to serve as the source 224S and the drain 224D.

Subsequently, as illustrated in FIG. 45C, for example, wet etching is used to remove the sacrificial layer 235 immediately below the polysilicon film 224X which is to serve as the channel 224. At this time, the sacrificial layer 235 immediately below the polysilicon film 224X, which is to serve as the source 224S and the drain 224D, is covered with the resist film 236 and thus is not removed. Thereafter, the resist film 236 is removed. Next, as illustrated in FIG. 45D, an annealing treatment is used to form a thermal oxide film on a front surface of the polysilicon film 224X and the front surface of the through-electrode 120E. This thermal oxide film is to serve as the gate insulating film 225 and the thermal oxide film 227 illustrated in FIGs. 39 and 40.

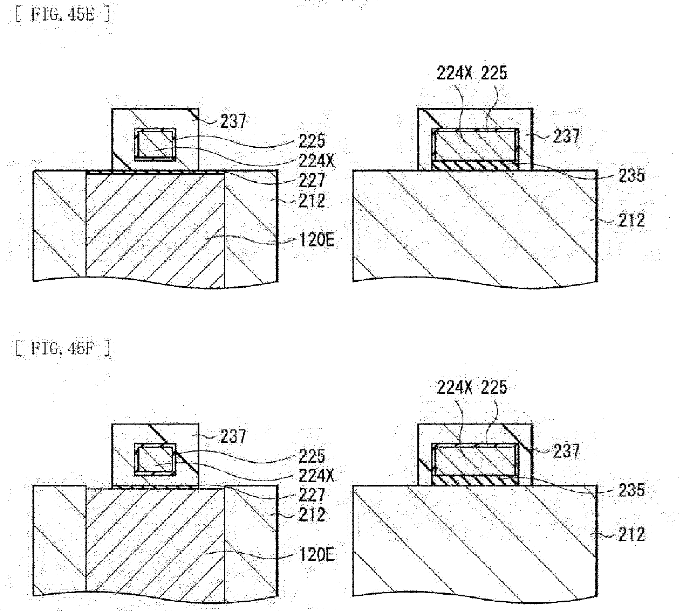

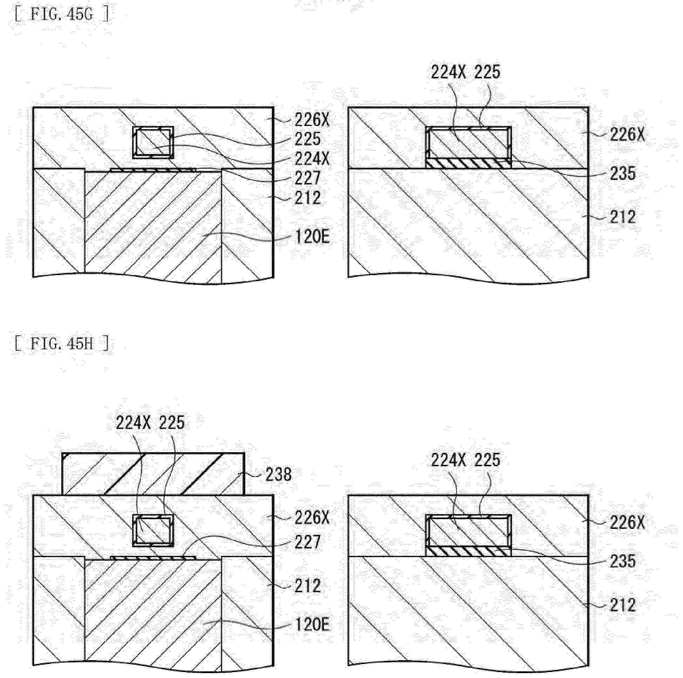

Subsequently, after a resist film 237 covering the polysilicon film 224X is formed as illustrated in FIG. 45E, etching is used to remove the thermal oxide film 227 formed on the top surface of the through-electrode 120E exposed from the resist film 237 as illustrated in FIG. 45F. Next, as illustrated in FIG. 45G, the polysilicon film 226X is formed on the semiconductor layer 200S including the insulating region 212, the element separation region 213, the through-electrode 120E, and the polysilicon film 224X which is to serve as the channel 224, the source 224S, and the drain 224D.

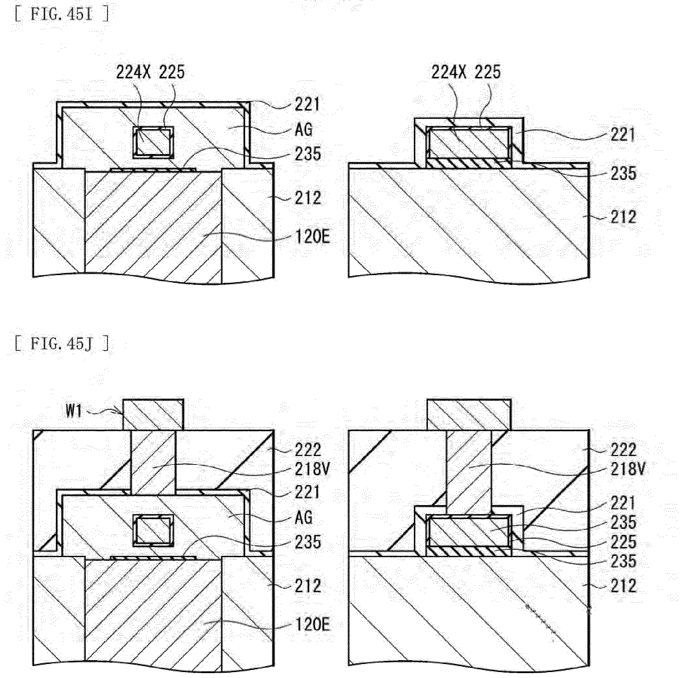

Subsequently, as illustrated in FIG. 45H, a resist film 238 is formed at a predetermined position of the polysilicon film 226X. Specifically, the resist film 238 is formed on the polysilicon film 224X which is to serve as the channel 224. Next, as illustrated in FIG. 45I, etching is used to work the polysilicon film 226X and form the gate AG, and then the passivation film 221 is formed. Thereafter, as illustrated in FIG. 45J, the interlayer insulating film 222, a coupling section 218B, and the first wiring layer W1 are formed in order.

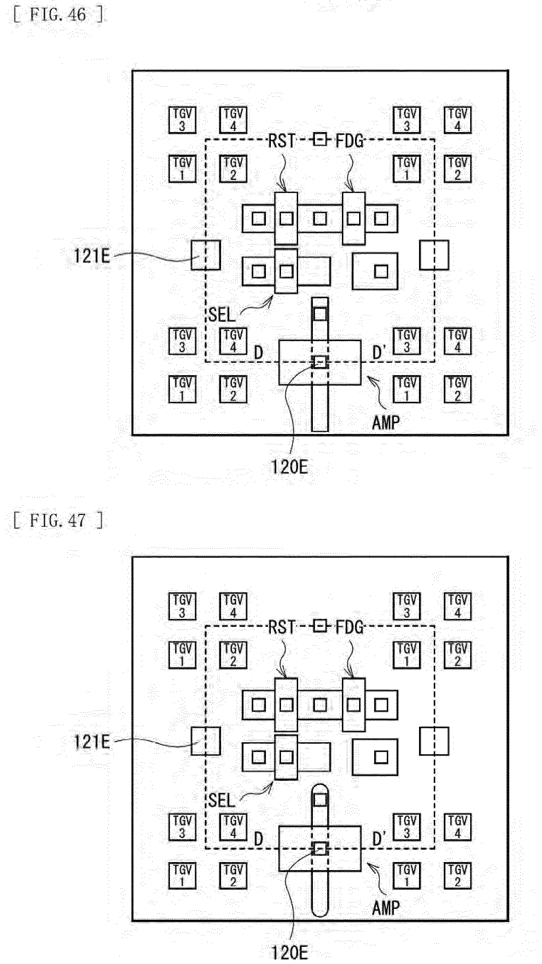

In the amplification transistor AMP formed using the manufacturing method described above, the sacrificial layer 235 immediately below the polysilicon film 224X, which is to serve as the source 224S and the drain 224D, is able to remain. Therefore, for example, as illustrated in FIG. 46, it is possible to form the source 224S, the drain 224D, and the channel 224 to have substantially the same width. Accordingly, it is possible to reduce the chip size of the entire pixel circuit 210, thus making it possible to improve the yield inside one silicon wafer, for example.

It is to be noted that the both ends of the polysilicon film 224X, which is to serve as the source 224S and the drain 224D, may have curved shapes with corners being chamfered as illustrated in FIG. 47, for example. In addition, the foregoing Modification Example 10 and the present modification example mention SiGe as the material of the sacrificial layer 235, but the sacrificial layer 235 is not limited thereto; for example, the sacrificial layer 235 may be formed using an electrically-conductive film or an insulating film, for example.

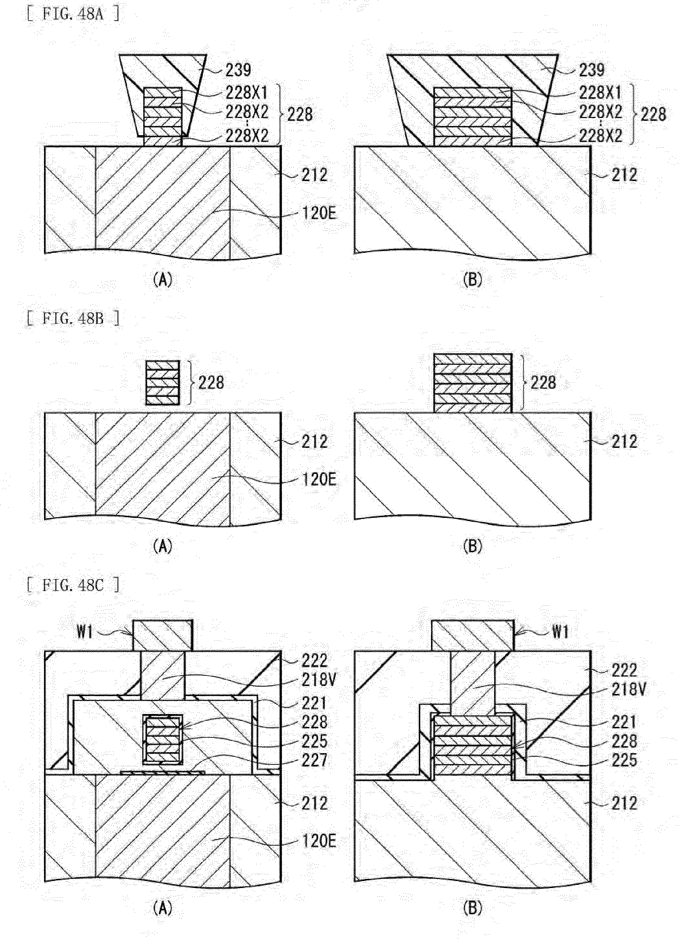

Further, the gate length may be insufficient, in some cases, even when the amplification transistor AMP is allowed to have the GAA structure. At that time, as illustrated in FIG. 48A, for example, a multilayer film 228 in which an Si film 228X1 including polysilicon and a sacrificial layer 228X2 including SiGe are alternately stacked on each other may be formed, for example, instead of the polysilicon film 224X included in the channel 224. This makes it possible to secure the gate length.

In a case where the multilayer film 228 in which the Si film 228X1 and the sacrificial layer 228X2 are alternately stacked on each other is used in this manner, working of the portion of the channel 224 and the portions of the source 224S and the drain 224D may be performed as follows.

First, the multilayer film 228 is worked into a predetermined shape, and then the multilayer film 228 is covered with an inversely tapered resist film 239, except the lowermost sacrificial layer 228X2 of the multilayer film 228 which is to serve as the channel 224, as illustrated in FIG. 48A. The inversely tapered resist film 239 may be formed using a negative resist, or the like, for example. Subsequently, for example, wet etching is performed to selectively remove the lowermost sacrificial layer 228X2 of the portion of the channel 224 exposed from the resist film 239 as illustrated in FIG. 48B. Thereafter, the resist film 239 is removed. Next, as illustrated in FIG. 48C, the gate insulating film 225, the thermal oxide film 227, the gate AG, the passivation film 221, the interlayer insulating film 222, the coupling section 218B, and the first wiring layer W are sequentially formed, in a manner similar to those described above.

It is to be noted that the foregoing second embodiment and Modification Examples 9 to 11 exemplify the case of the amplification transistor AMP having the GAA structure; however, all the transistors included in the pixel circuit 210 may have the GAA structure. In that case, the semiconductor layer 200S can be the multilayer film 228 in which the Si film 228X1 and the sacrificial layer 228X2 are alternately stacked on each other as described above. In such a case, the film thickness of the multilayer film 228 is smaller than the film thickness of the semiconductor layer 200S, thus enabling the film thickness of the second substrate 200 to be smaller. Therefore, the aspect ratio between the through-electrodes 120E and 121E is reduced, thus making it possible improve working easiness and stability as well as the yield.

### <5. Modification Example 12>

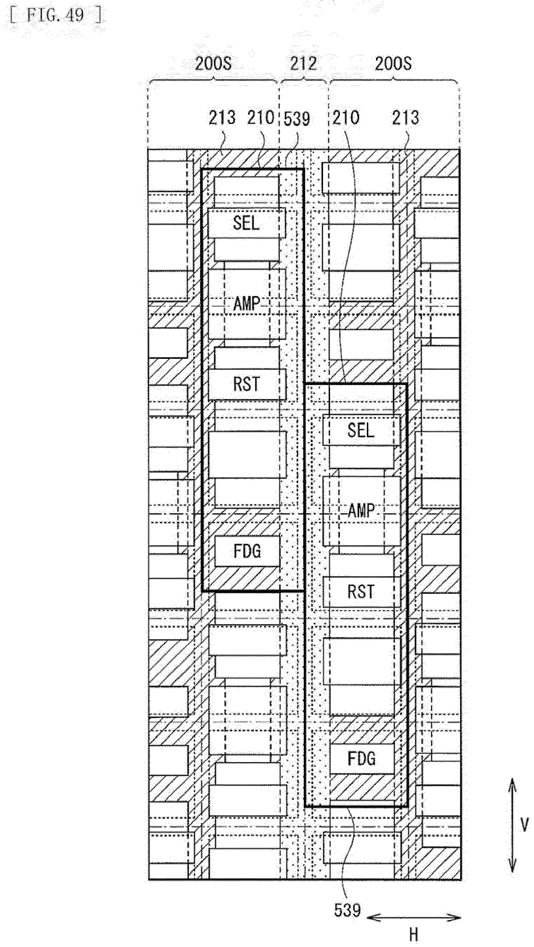

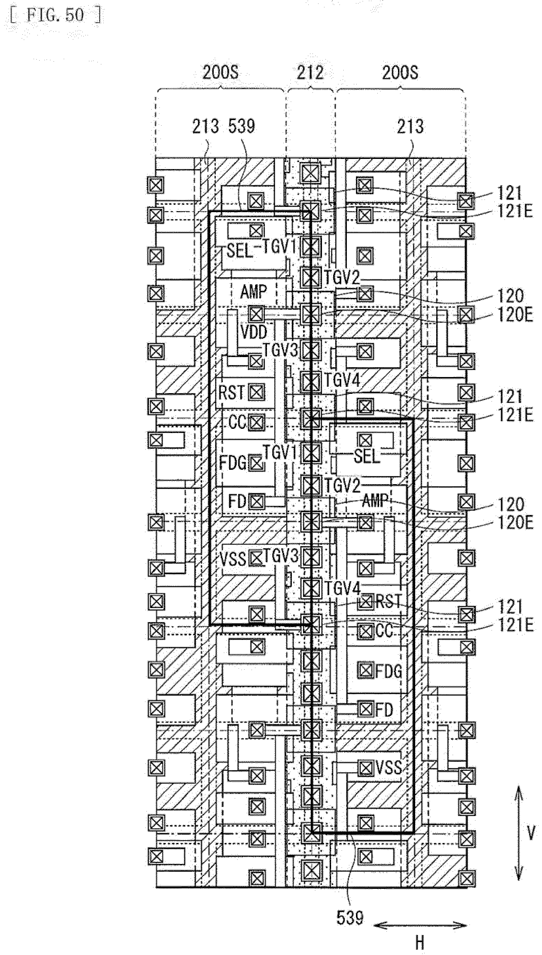

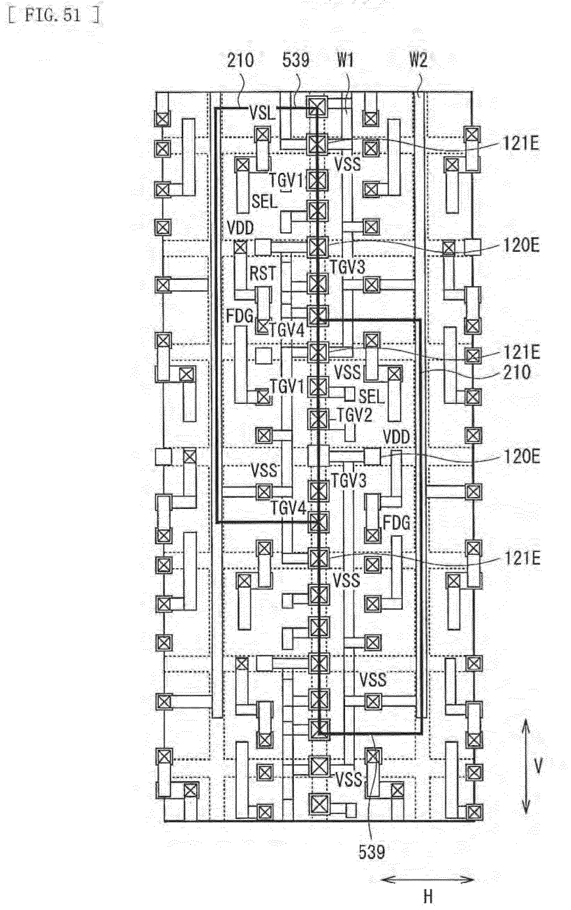

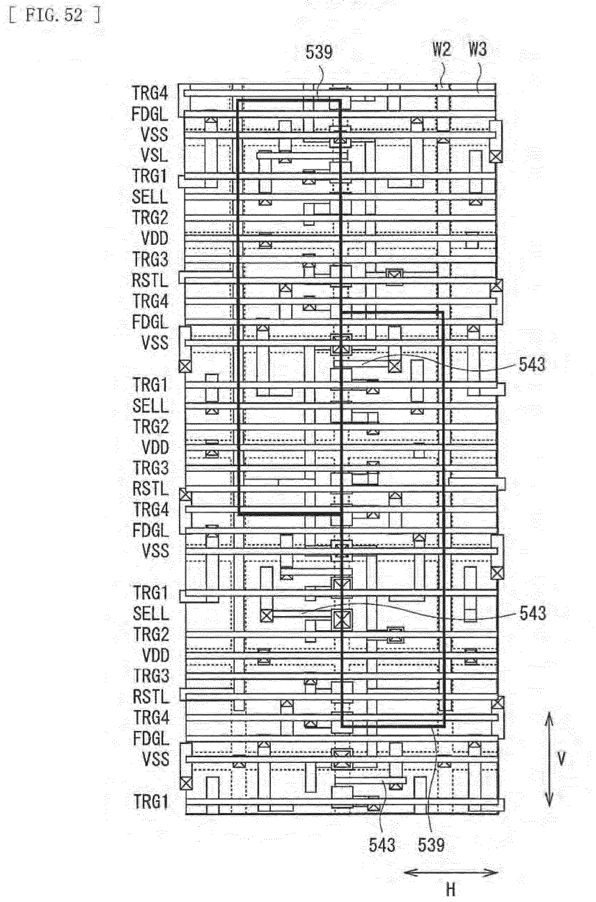

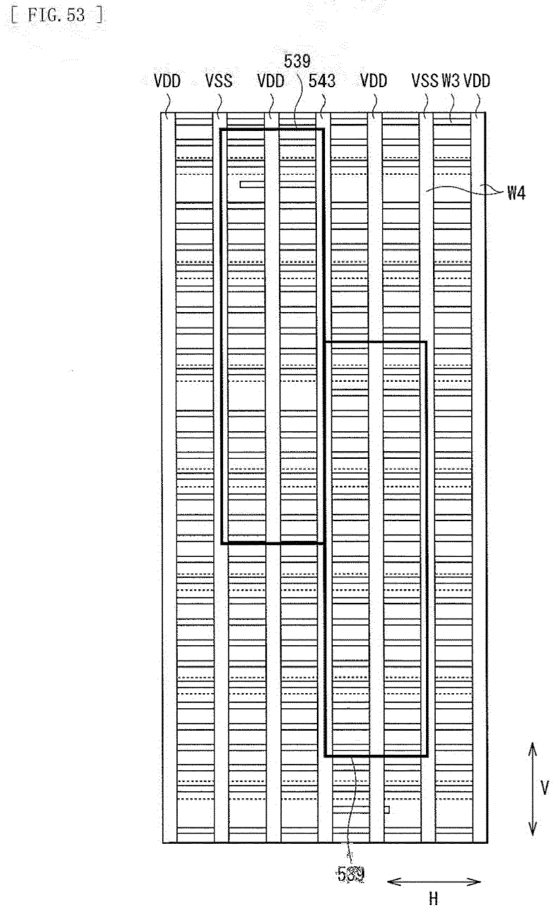

FIGs. 49 to 53 each illustrate a modification example of a planar configuration of the imaging device 1 according to any of the foregoing embodiments and the like. FIG. 49 schematically illustrates a planar configuration close to the front surface of the semiconductor layer 200S of the second substrate 200, and corresponds to FIG. 8 described in the foregoing first embodiment. FIG. 50 schematically illustrates a configuration of each of the first wiring layer W1, the semiconductor layer 200S coupled to the first wiring layer W1, and components of the first substrate 100, and corresponds to FIG. 9 described in the foregoing first embodiment. FIG. 51 illustrates an example of planar configurations of the first wiring layer W1 and the second wiring layer W2, and corresponds to FIG. 10 described in the foregoing first embodiment. FIG. 52 illustrates an example of planar configurations of the second wiring layer W2 and the third wiring layer W3, and corresponds to FIG. 11 described in the foregoing first embodiment. FIG. 53 illustrates an example of planar configurations of the third wiring layer W3 and the fourth wiring layer W4, and corresponds to FIG. 12 described in the foregoing first embodiment.

In the present modification example, as illustrated in FIG. 50, in the two pixel sharing units 539 arranged in the H direction of the second substrate 200, an internal layout of one pixel sharing unit 539 (e.g., on the right side of the sheet) has a configuration obtained by inverting an internal layout of the other pixel sharing unit 539 (e.g., on the left side of the sheet) only in the H direction. In addition, a deviation in the V direction between the contour line of the one pixel sharing unit 539 and the contour line of the other pixel sharing unit 539 is larger than the deviation (FIG. 9) described in the foregoing first embodiment. In such a manner, increasing the deviation in the V direction makes it possible to decrease a distance between the amplification transistor AMP of the other pixel sharing unit 539 and the pad section 120 coupled to the amplification transistor AMP (the pad section 120 of the other (on the lower side of the sheet) of the two pixel sharing units 539 arranged in the V direction illustrated in FIG. 7B). Such a layout allows Modification Example 12 of the imaging device 1 illustrated in FIGs. 49 to 53 to make its area the same as the area of the pixel sharing unit 539 of the second substrate 200 described in the foregoing first embodiment without inverting, to each other in the V direction, planar layouts of the two pixel sharing units 539 arranged in the H direction. It is to be noted that the planar layout of the pixel sharing unit 539 of the first substrate 100 is the same as the planar layout described in the foregoing first embodiment (FIGs. 7A and 7B). Thus, the imaging device 1 according to the present modification example is able to achieve effects similar to those of the imaging device 1 described in the foregoing first embodiment. The arrangement of the pixel sharing units 539 of the second substrate 200 is not limited to the arrangements described in the foregoing first and second embodiments and the present modification example.

### <6. Modification Example 13>

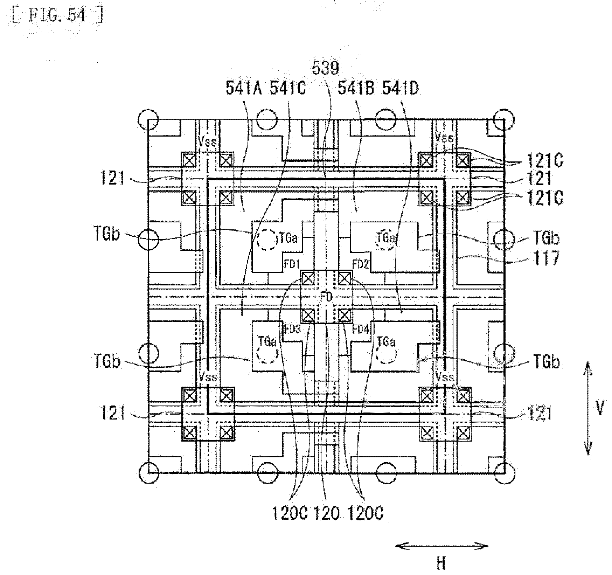

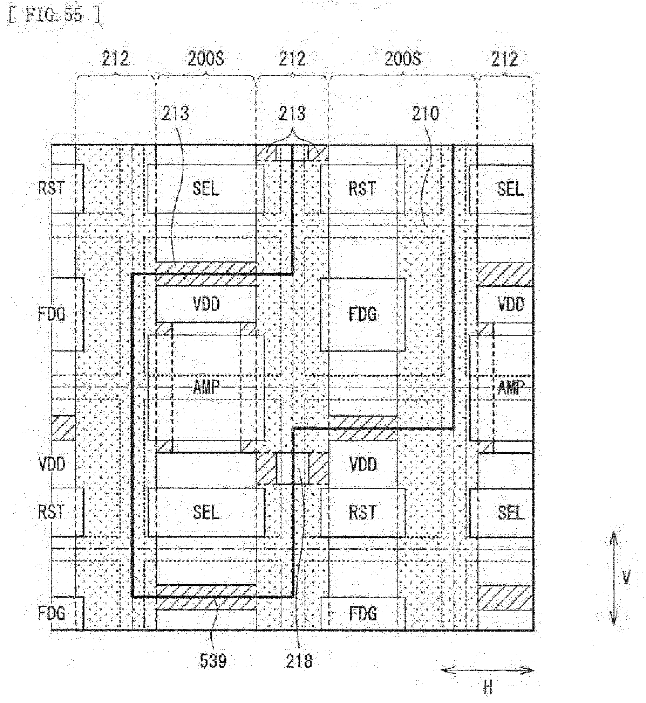

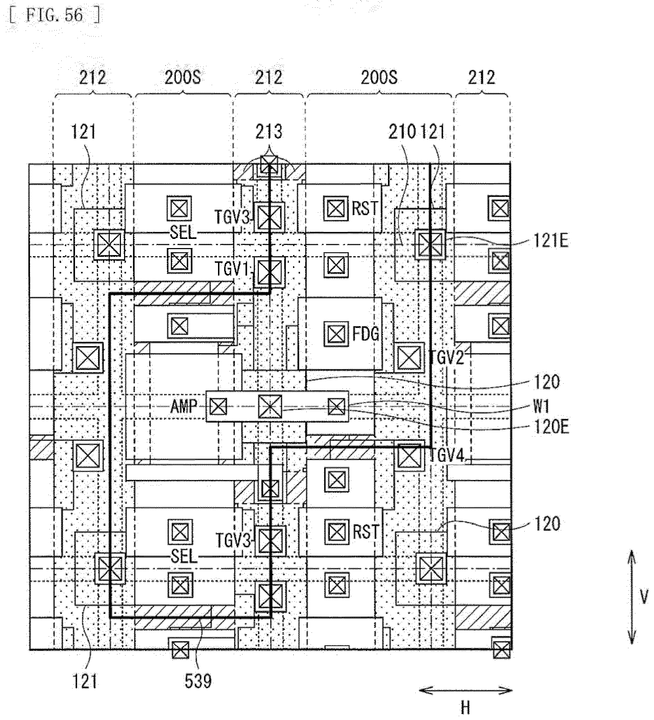

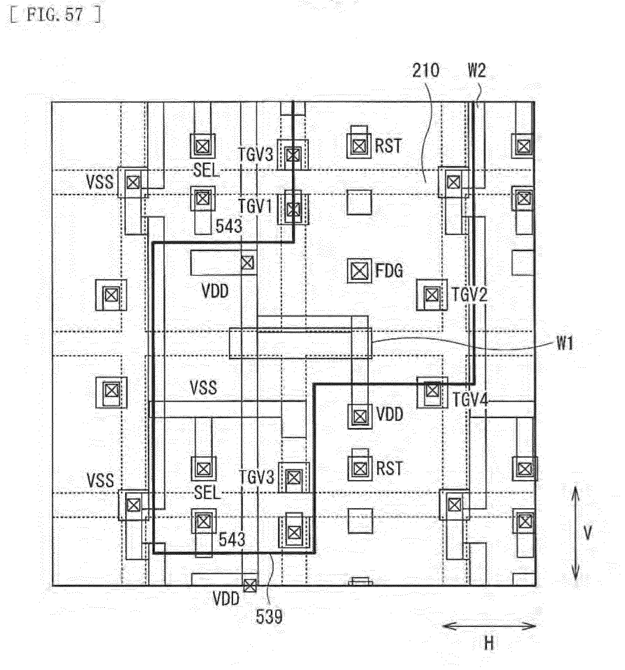

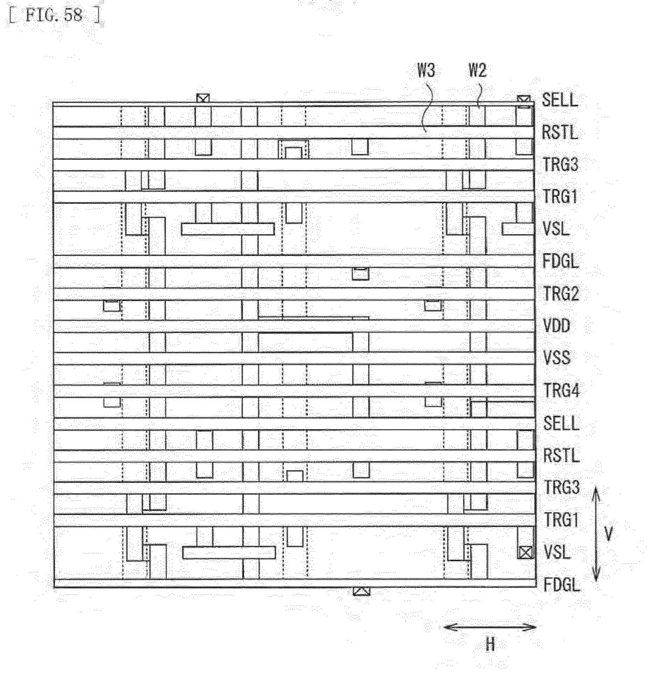

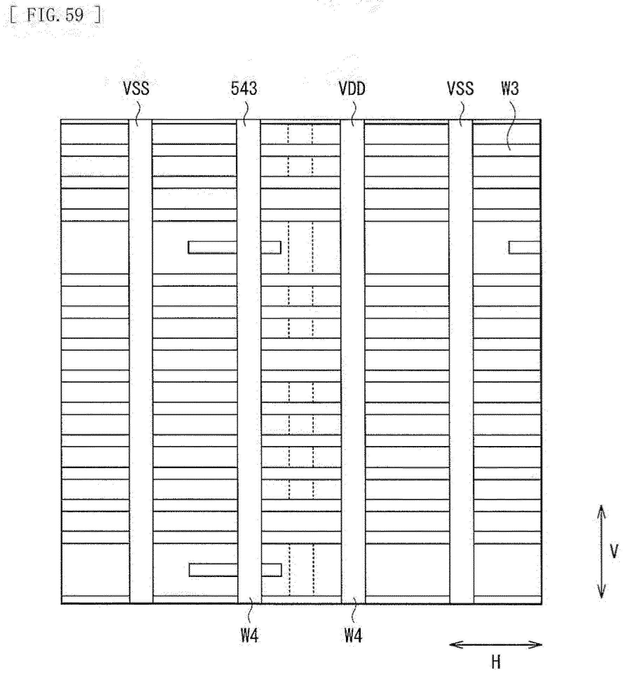

FIGs. 54 to 59 each illustrate a modification example of a planar configuration of the imaging device 1 according to any of the foregoing embodiments and the like. FIG. 54 schematically illustrates a planar configuration of the first substrate 100, and corresponds to FIG. 7A described in the foregoing first embodiment. FIG. 55 schematically illustrates a planar configuration close to the front surface of the semiconductor layer 200S of the second substrate 200, and corresponds to FIG. 8 described in the foregoing first embodiment. FIG. 56 schematically illustrates a configuration of each of the first wiring layer W1, the semiconductor layer 200S coupled to the first wiring layer W1, and components of the first substrate 100, and corresponds to FIG. 9 described in the foregoing first embodiment. FIG. 57 illustrates an example of planar configurations of the first wiring layer W1 and the second wiring layer W2, and corresponds to FIG. 10 described in the foregoing first embodiment. FIG. 58 illustrates an example of planar configurations of the second wiring layer W2 and the third wiring layer W3, and corresponds to FIG. 11 described in the foregoing first embodiment. FIG. 59 illustrates an example of planar configurations of the third wiring layer W3 and the fourth wiring layer W4, and corresponds to FIG. 12 described in the foregoing first embodiment.

In the present modification example, the contour of each of the pixel circuits 210 has a substantially square planar shape (FIG. 55 and the like). The planar configuration of the imaging device 1 according to the present modification example differs from the planar configuration of the imaging device 1 described in the foregoing first embodiment in this point.

For example, the pixel sharing unit 539 of the first substrate 100 is formed over a pixel region of two rows by two columns in a manner similar to those described in the foregoing first embodiment, and has a substantially square planar shape (FIG. 54). For example, in each of the pixel sharing units 539, the horizontal portions TGb of the transfer gates TG1 and TG3 of the pixel 541A and the pixel 541C in one pixel column extend in a direction from positions superimposed on the vertical portions TGa toward a middle part of the pixel sharing unit 539 in the H direction (more specifically, in a direction toward outer edges of the pixels 541A and 541C and a direction toward the middle part of the pixel sharing unit 539), and the horizontal portions TGb of the transfer gates TG2 and TG4 of the pixels 541B and the pixel 541D in the other pixel column extend in a direction from positions superimposed on the vertical portions TGa toward outside of the pixel sharing unit 539 in the H direction (more specifically, in a direction toward outer edges of the pixels 541B and 541D and a direction toward outside of the pixel sharing unit 539). The pad section 120 coupled to the floating diffusion FD is provided in the middle part of the pixel sharing unit 539 (a middle part in the H direction and the V direction of the pixel sharing unit 539), and the pad section 121 coupled to the VSS contact region 118 is provided in an end portion of the pixel sharing unit 539 at least in the H direction (in the H direction and the V direction in FIG. 54).

As another arrangement example, it is also conceivable that the horizontal portions TGb of the transfer gates TG1, TG2, TG3, and TG4 are provided only in regions opposed to the vertical portions TGa. At this time, in a manner similar to those described in the foregoing first embodiment, the semiconductor layer 200S is easily divided finely. Accordingly, it is difficult to make the transistors of the pixel circuit 210 large. In contrast, when the horizontal portions TGb of the transfer gates TG1, TG2, TG3, and TG4 extend from the positions superimposed on the vertical portion TGa in the H direction as with the modification example described above, it is possible to increase the width of the semiconductor layer 200S in a manner similar to those described in the foregoing first embodiment. Specifically, it is possible to dispose the positions in the H direction of the through-electrodes TGV1 and TGV3 coupled to the transfer gates TG1 and TG3 close to the position in the H direction of the through-electrode 120E, and dispose the positions in the H direction of the through-electrodes TGV2 and TGV4 coupled to the transfer gates TG2 and TG4 close to the position in the H direction of the through-electrode 121E (FIG. 56). This makes it possible to increase the width (a size in the H direction) of the semiconductor layer 200S extending in the V direction in a manner similar to those described in the foregoing first embodiment. Accordingly, it is possible to increase the sizes of the transistors of the pixel circuit 210, specifically the size of the amplification transistor AMP. This consequently makes it possible to improve the signal-to-noise ratio of the pixel signal, thereby allowing the imaging device 1 to output more favorable pixel data (image information).

The pixel sharing unit 539 of the second substrate 200 has, for example, substantially the same size as the size in the H direction and the V direction of the pixel sharing unit 539 of the first substrate 100, and is provided over a region substantially corresponding to a pixel region of two rows by two columns. For example, in each of the pixel circuits 210, the selection transistor SEL and the amplification transistor AMP are arranged side by side in the V direction in one semiconductor layer 200S extending in the V direction, and the FD conversion gain switching transistor FDG and the reset transistor RST are arranged side by side in the V direction in one semiconductor layer 200S extending in the V direction. The one semiconductor layer 200S provided with the selection transistor SEL and the amplification transistor AMP and the one semiconductor layer 200S provided with the FD conversion gain switching transistor FDG and the reset transistor RST are arranged in the H direction with the insulating region 212 interposed therebetween. The insulating region 212 extends in the V direction (FIG. 55).

Here, description is given of the contour of the pixel sharing unit 539 of the second substrate 200 with reference to FIGs. 55 and 56. For example, the pixel sharing unit 539 of the first substrate 100 illustrated in FIG. 54 is couple to the amplification transistor AMP and the selection transistor SEL provided on one side (on left side of the sheet of FIG. 56) in the H direction of the pad section 120 and to the FD conversion gain switching transistor FDG and the reset transistor RST provided on the other side (on right side of the sheet of FIG. 56) in the H direction of the pad section 120. The contour of the pixel sharing unit 539 of the second substrate 200 including the amplification transistor AMP, the selection transistor SEL, the FD conversion gain switching transistor FDG, and the reset transistor RST is determined by the following four outer edges.

A first outer edge is an outer edge of one end (an end on upper side of the sheet of FIG. 56) in the V direction of the semiconductor layer 200S including the selection transistor SEL and the amplification transistor AMP. The first outer edge is provided between the amplification transistor AMP included in that pixel sharing unit 539 and the selection transistor SEL included in the pixel sharing unit 539 adjacent in the V direction to one side (on upper side of the sheet of FIG. 56) of that pixel sharing unit 539. More specifically, the first outer edge is provided in a middle part in the V direction of the element separation region 213 between the amplification transistor AMP and the selection transistor SEL. A second outer edge is an outer edge of another end (an end on lower side of the sheet of FIG. 56) in the V direction of the semiconductor layer 200S including the selection transistor SEL and the amplification transistor AMP. The second outer edge is provided between the selection transistor SEL included in that pixel sharing unit 539 and the amplification transistor AMP included in the pixel sharing unit 539 adjacent in the V direction to another side (lower side of the sheet of FIG. 56) of that pixel sharing unit 539. More specifically, the second outer edge is provided in a middle part in the V direction of the element separation region 213 between the selection transistor SEL and the amplification transistor AMP. A third outer edge is an outer edge of another end (an end on the lower side of the sheet of FIG. 56) in the V direction of the semiconductor layer 200S including the reset transistor RST and the FD conversion gain switching transistor FDG. The third outer edge is provided between the FD conversion gain switching transistor FDG included in that pixel sharing unit 539 and the reset transistor RST included in the pixel sharing unit 539 adjacent in the V direction to another side (lower side of the sheet of FIG. 56) of that pixel sharing unit 539. More specifically, the third outer edge is provided in a middle part in the V direction of the element separation region 213 between the FD conversion gain switching transistor FDG and the reset transistor RST. A fourth outer edge is an outer edge of one end (an end on upper side of the sheet of FIG. 56) in the V direction of the semiconductor layer 200S including the reset transistor RST and the FD conversion gain switching transistor FDG. The fourth outer edge is provided between the reset transistor RST included in that pixel sharing unit 539 and the FD conversion gain switching transistor FDG (unillustrated) included in the pixel sharing unit 539 adjacent in the V direction to one side (on upper side of the sheet of FIG. 56) of that pixel sharing unit 539. More specifically, the fourth outer edge is provided in a middle part in the V direction of the element separation region 213 (unillustrated) between the reset transistor RST and the FD conversion gain switching transistor FDG.

In the contour of the pixel sharing unit 539 of the second substrate 200 including such first, second, third, and fourth outer edges, the third and fourth outer edges are disposed to be deviated on one side in the V direction from the first and second outer edges (in other words, to be offset to one side in the V direction). Using such a layout makes it possible to dispose both the gate of the amplification transistor AMP and the source of the FD conversion gain switching transistor FDG as close as possible to the pad section 120. This makes it easier to decrease the area of wiring lines to which they are coupled, and miniaturize the imaging device 1. It is to be noted that the VSS contact region 218 is provided between the semiconductor layer 200S including the selection transistor SEL and the amplification transistor AMP and the semiconductor layer 200S including the reset transistor RST and the FD conversion gain switching transistor FDG. For example, a plurality of pixel circuits 210 has the same arrangement as each other.

The imaging device 1 including such a second substrate 200 also achieves effects similar to those described in the foregoing first embodiment. The arrangement of the pixel sharing units 539 of the second substrate 200 is not limited to the arrangements described in the foregoing first and second embodiments and the present modification example.

### <7. Modification Example 14>

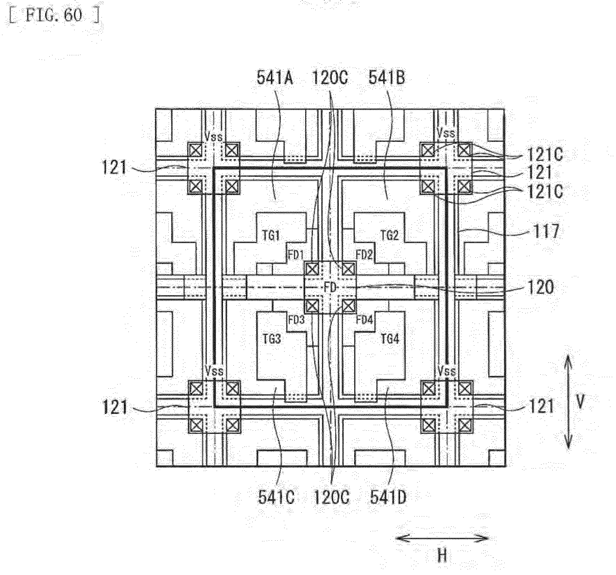

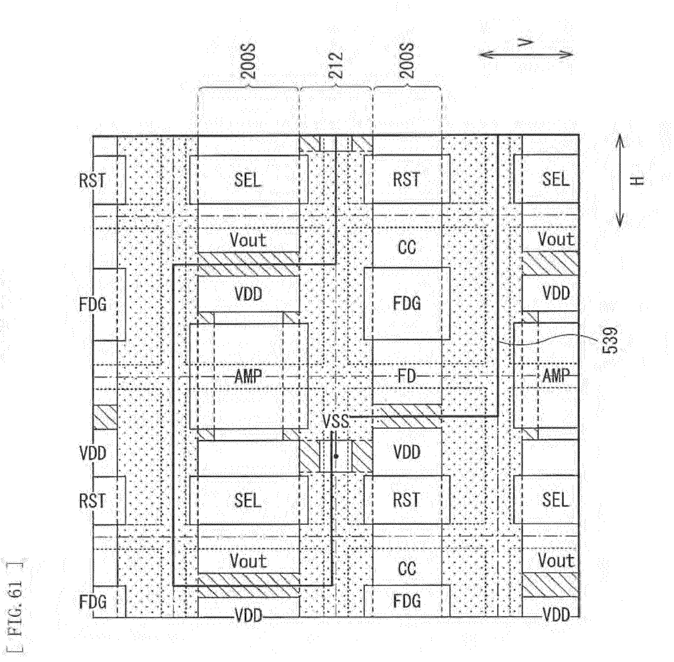

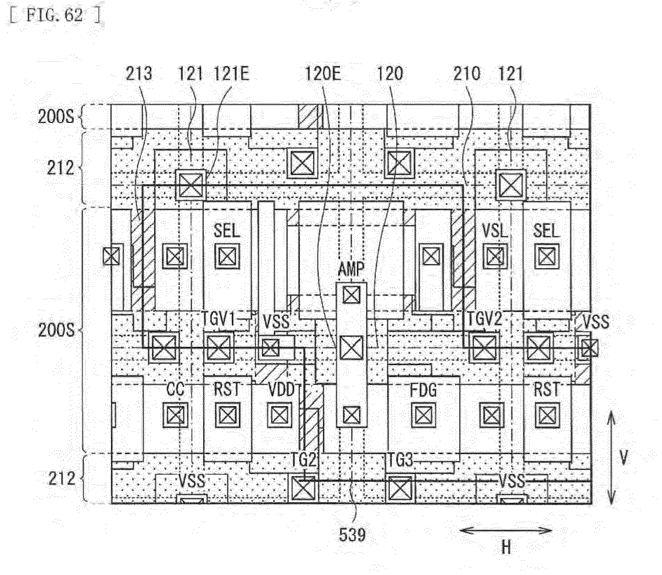

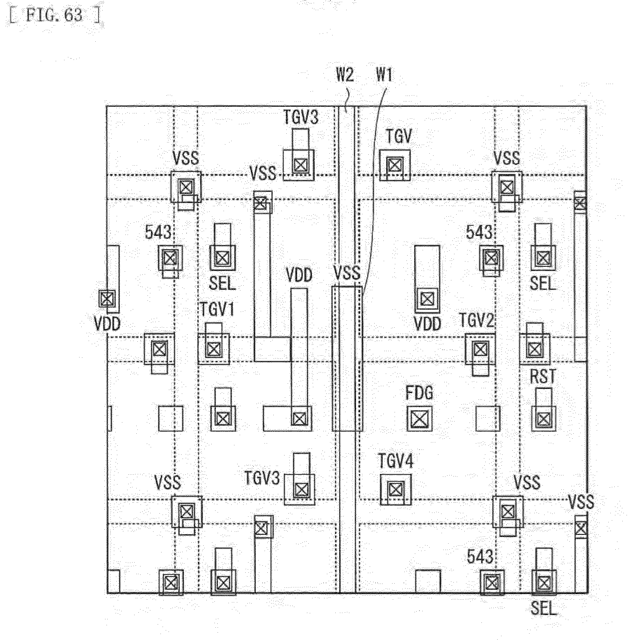

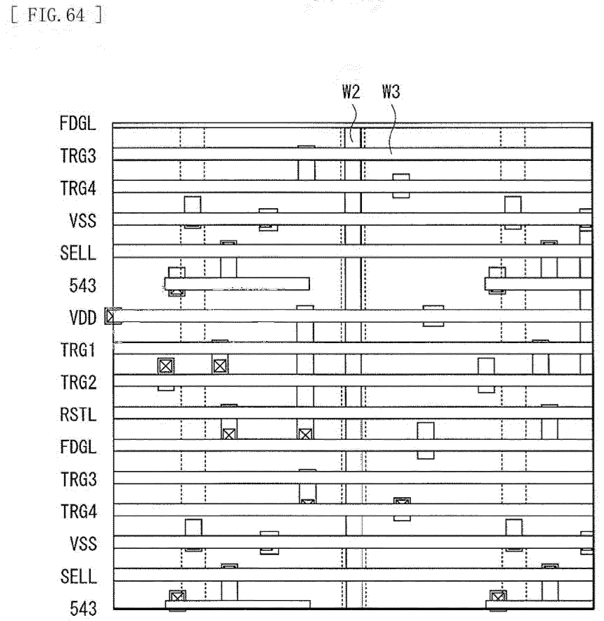

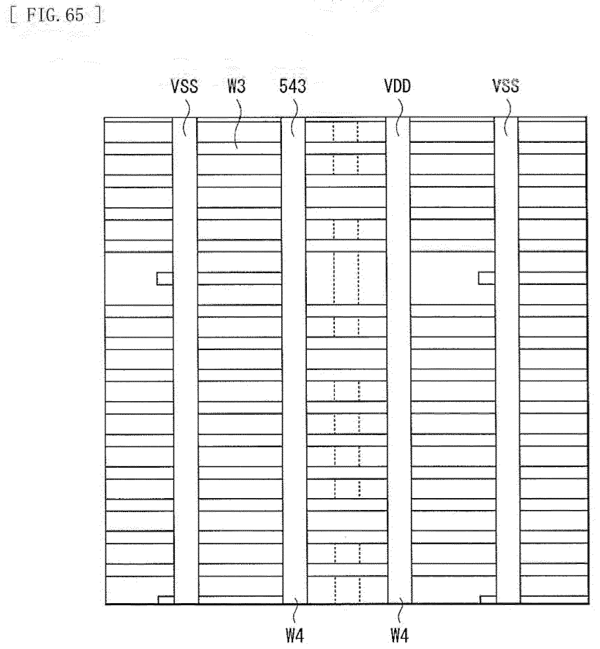

FIGs. 60 to 65 each illustrate a modification example of the planar configuration of the imaging device 1 according to any of the foregoing embodiments and the like. FIG. 60 schematically illustrates a planar configuration of the first substrate 100, and corresponds to FIG. 7B described in the foregoing first embodiment. FIG. 61 schematically illustrates a planar configuration close to the front surface of the semiconductor layer 200S of the second substrate 200, and corresponds to FIG. 8 described in the foregoing first embodiment. FIG. 62 schematically illustrates a configuration of each of the first wiring layer W 1, the semiconductor layer 200S coupled to the first wiring layer W1, and components of the first substrate 100, and corresponds to FIG. 9 described in the foregoing first embodiment. FIG. 63 illustrates an example of planar configurations of the first wiring layer W1 and the second wiring layer W2, and corresponds to FIG. 10 described in the foregoing first embodiment. FIG. 64 illustrates an example of planar configurations of the second wiring layer W2 and the third wiring layer W3, and corresponds to FIG. 11 described in the foregoing first embodiment. FIG. 65 illustrates an example of planar configurations of the third wiring layer W3 and the fourth wiring layer W4, and corresponds to FIG. 12 described in the foregoing first embodiment.

In the present modification example, the semiconductor layer 200S of the second substrate 200 extends in the H direction (FIG. 62). That is, the present modification example substantially corresponds to a configuration obtained by rotating, by 90 degrees, the planar configuration of the imaging device 1 illustrated in FIG. 55 described above and the like.

For example, the pixel sharing unit 539 of the first substrate 100 is formed over a pixel region of two rows by two columns in a manner similar to those described in the foregoing first embodiment, and has a substantially square planar shape (FIG. 60). For example, in each of the pixel sharing units 539, the transfer gates TG1 and TG2 of the pixel 541A and the pixel 541B in one pixel row extend in the V direction toward the middle part of the pixel sharing unit 539, and the transfer gates TG3 and TG4 of the pixel 541C and the pixel 541D in the other pixel row extend in the V direction toward outside of the pixel sharing unit 539. The pad section 120 coupled to the floating diffusion FD is provided in the middle part of the pixel sharing unit 539, and the pad section 121 coupled to the VSS contact region 118 is provided in an end portion of the pixel sharing unit 539 at least in the V direction (in the V direction and the H direction in FIG. 60). At this time, the positions in the V direction of the through-electrodes TGV1 and TGV2 of the transfer gates TG1 and TG2 are close to the position in the V direction of the through-electrode 120E, and the positions in the V direction of the through-electrodes TGV3 and TGV4 of the transfer gates TG3 and TG4 are close to the position in the V direction of the through-electrode 121E (FIG. 62). Accordingly, it is possible to increase the width (the size in the V direction) of the semiconductor layer 200S extending in the H direction for a reason similar to that described in the foregoing first embodiment. This makes it possible to increase the size of the amplification transistor AMP and suppress the noise.

In each of the pixel circuits 210, the selection transistor SEL and the amplification transistor AMP are arranged side by side in the H direction, and the reset transistors RST are arranged at adjacent positions in the V direction with the selection transistor SEL and the insulating region 212 interposed therebetween (FIG. 61). The FD conversion gain switching transistor FDG is disposed side by side in the H direction with the reset transistor RST. The VSS contact region 218 is provided in an island shape in the insulating region 212. For example, the third wiring layer W3 extends in the H direction (FIG. 64), and the fourth wiring layer W4 extends in the V direction (FIG. 65).

The imaging device 1 having such a second substrate 200 also achieves effects similar to those described in the foregoing first embodiment. The arrangement of the pixel sharing units 539 of the second substrate 200 is not limited to the arrangements described in the foregoing first and second embodiments and the present modification example. For example, the semiconductor layer 200S described in the foregoing first and second embodiments and Modification Example 12 may extend in the H direction.

### <8. Modification Example 15>

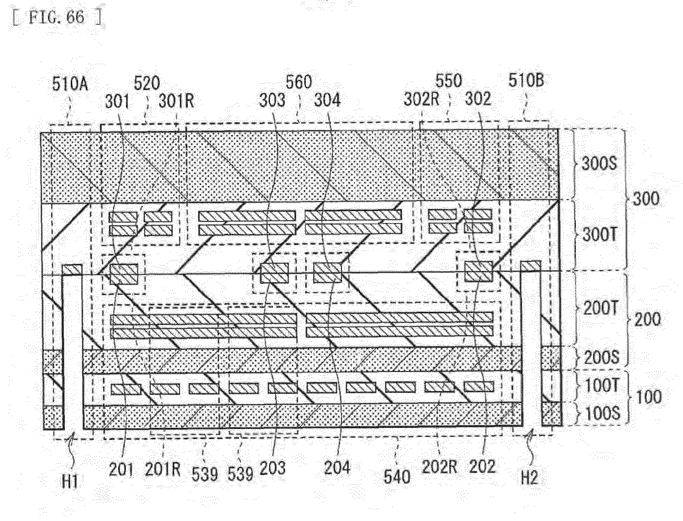

FIG. 66 schematically illustrates a modification example of the cross-sectional configuration of the imaging deice 1 according to any of the foregoing embodiments and the like. FIG. 66 corresponds to FIG. 3 described in the foregoing first embodiment. In the present modification example, the imaging device 1 includes, at positions facing the middle part of the pixel array section 540, contact sections 203, 204, 303, and 304 in addition to the contact sections 201, 202, 301, and 302. The imaging device 1 according to the present modification example differs from the imaging device 1 described in the foregoing first embodiment in this point.

The contact sections 203 and 204 are provided in the second substrate 200, and are exposed to a bonding surface with the third substrate 300. The contact sections 303 and 304 are provided in the third substrate 300, and are exposed to a bonding surface with the second substrate 200. The contact section 203 is in contact with the contact section 303, and the contact section 204 is in contact with the contact section 304. That is, in the imaging device 1, the second substrate 200 and the third substrate 300 are coupled to each other by the contact sections 203, 204, 303, and 304 in addition to the contact sections 201, 202, 301, and 302.

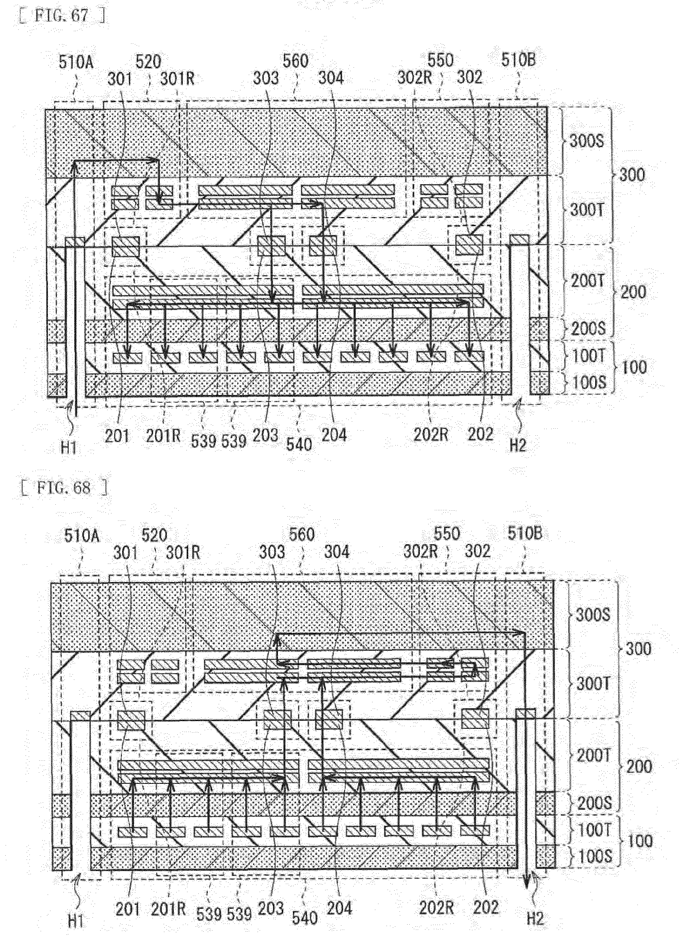

Next, description is given of an operation of the imaging device 1 with use of FIGs. 67 and 68. FIG. 67 illustrates an input signal to be inputted from outside to the imaging device 1 and paths of a power supply potential and a reference potential indicated by arrows. FIG. 68 illustrates a signal path of a pixel signal to be outputted from the imaging device 1 to the outside indicated by arrows. For example, the input signal inputted to the imaging device 1 through the input section 510A is transmitted to the row driving section 520 of the third substrate 300, and a row drive signal is produced in the row driving section 520. The row drive signal is transmitted to the second substrate 200 through the contact sections 303 and 203. Further, the row drive signal reaches each of the pixel sharing units 539 of the pixel array section 540 through the row drive signal line 542 in the wiring layer 200T. A drive signal other than the transfer gate TG of the row drive signal having reached the pixel sharing unit 539 of the second substrate 200 is inputted to the pixel circuit 210 to drive each of the transistors included in the pixel circuit 210. A drive signal of the transfer gate TG is inputted to the transfer gates TG1, TG2, TG3, and TG4 of the first substrate 100 through the through-electrode TGV to drive the pixels 541A, 541B, 541C, and 541D. In addition, the power supply potential and the reference potential supplied from outside of the imaging device 1 to the input section 510A (the input terminal 511) of the third substrate 300 are transmitted to the second substrate 200 through the contact sections 303 and 203 to be supplied to the pixel circuit 210 of each of the pixel sharing units 539 through a wiring line in the wiring layer 200T. The reference potential is further supplied to the pixels 541A, 541B, 541C, and 541D of the first substrate 100 through the through-electrode 121E. Meanwhile, the pixel signal photoelectrically converted in the pixels 541A, 541B, 541C, and 541D of the first substrate 100 is transmitted to the pixel circuit 210 of the second substrate 200 for each pixel sharing unit 539. A pixel signal based on the pixel signal is transmitted from the pixel circuit 210 to the third substrate 300 through the vertical signal line 543 and the contact sections 204 and 304. The pixel signal is processed in the column signal processing section 550 and the image signal processing section 560 of the third substrate 300, and then outputted to the outside through the output section 510B.

The imaging device 1 including such contact sections 203, 204, 303, and 304 also achieves effects similar to those described in the foregoing first embodiment. It is possible to change the positions, the number and the like of contact sections depending on design of the circuit and the like of the third substrate 300, which is a coupling target of wiring lines through the contact sections 303 and 304.

### <9. Modification Example 16>

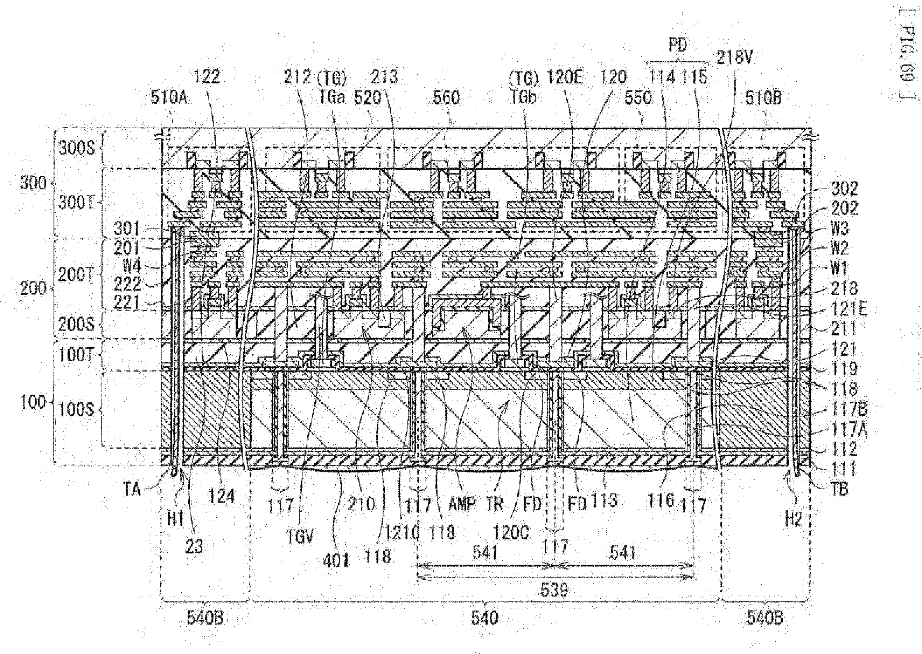

FIG. 69 illustrates a modification example of the cross-sectional configuration of the imaging device 1 according to any of the foregoing embodiments and the like. FIG. 69 corresponds to FIG. 6 described in the foregoing first embodiment. In the present modification example, the transfer transistor TR having a planar structure is provided in the first substrate 100. The imaging device 1 according to the present modification example differs from the imaging device 1 described in the foregoing first embodiment in this point.

In the transfer transistor TR, only the horizontal portion TGb is included in the transfer gate TG. In other words, the transfer gate TG does not include the vertical portion TGa, and is provided opposed to the semiconductor layer 100S.

The imaging device 1 including the transfer transistor TR having such a planar structure also achieves effects similar to those described in the foregoing first embodiment. Further, it is also conceivable that providing the planar transfer gate TG in the first substrate 100 allows for formation of the photodiode PD closer to the front surface of the semiconductor layer 100S, as compared with a case where a vertical transfer gate TG is provided in the first substrate 100, to thereby increase a saturation signal amount (Qs). In addition, it is also conceivable that the method of forming the planar transfer gate TG in the first substrate 100 involves a smaller number of manufacturing steps, as compared with the method of forming the vertical transfer gate TG in the first substrate 100, which hinders the photodiode PD from being adversely affected due to the manufacturing steps.

### < 10. Modification Example 17>

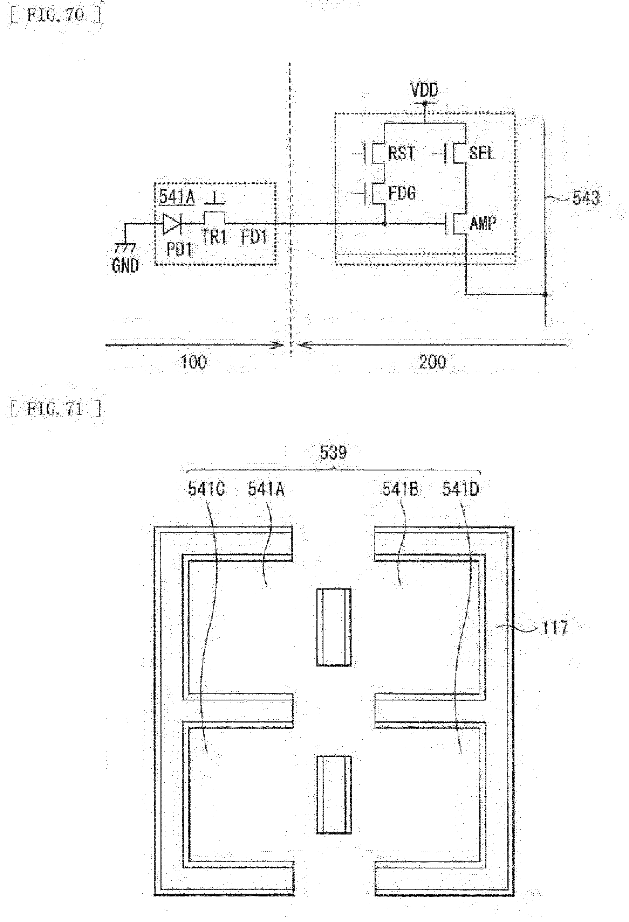

FIG. 70 illustrates a modification example of the pixel circuit of the imaging device according to any of the foregoing embodiments and the like. FIG. 70 corresponds to FIG. 4 described in the foregoing first embodiment. In the present modification example, the pixel circuit 210 is provided for each pixel (pixel 541A). That is, the pixel circuit 210 is not shared by a plurality of pixels. The imaging device 1 according to the present modification example differs from the imaging device 1 described in the foregoing first embodiment in this point.

The imaging device 1 according to the present modification example is the same as the imaging device 1 described in the foregoing first embodiment in that the pixel 541A and the pixel circuit 210 are provided in different substrates (the first substrate 100 and the second substrate 200). Accordingly, the imaging device 1 according to the present modification example is also able to achieve effects similar to those described in the foregoing first embodiment.

### <11. Modification Example 18>

FIG. 71 illustrates a modification example of the planar configuration of the pixel separation section 117 described in any of the foregoing embodiments and the like. A clearance may be provided in the pixel separation section 117 surrounding each of the pixels 541A, 541B, 541C, and 541D. That is, the entire periphery of each of the pixels 541A, 541B, 541C, and 541D may not be surrounded by the pixel separation section 117. For example, the clearance of the pixel separation section 117 is provided close to the pad sections 120 and 121 (see FIG. 7B).

In the foregoing first embodiment, an example in which the pixel separation section 117 has the FTI structure that penetrates the semiconductor layer 100S (see FIG. 6) has been described; however, the pixel separation section 117 may have a configuration other than the FTI structure. For example, the pixel separation section 117 may not be provided to completely penetrate the semiconductor layer 100S, and may have a so-called DTI (Deep Trench Isolation) structure.

### <12. Modification Example 19>

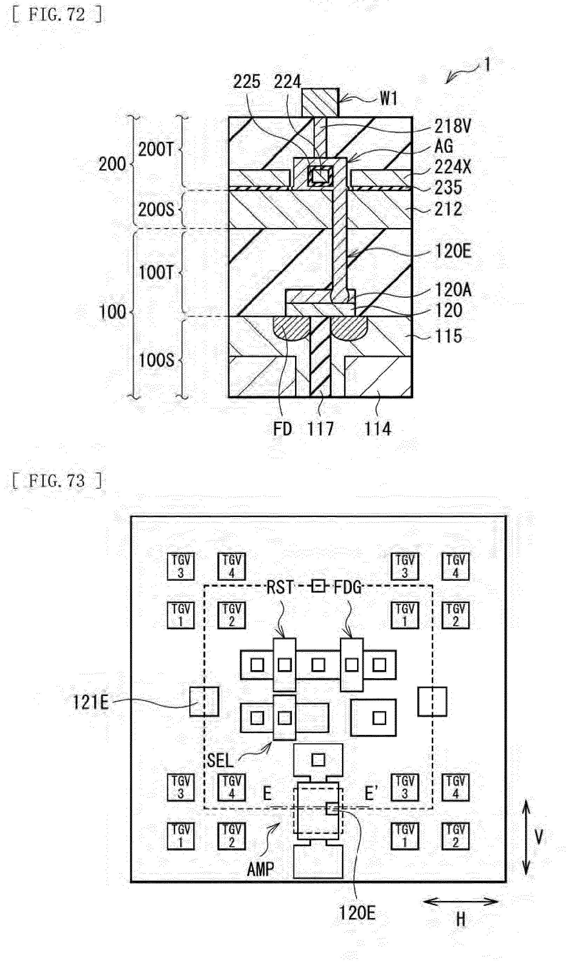

FIG. 72 schematically illustrates a cross-sectional configuration of main parts of the imaging device 1 according to Modification Example 19 of the present disclosure. FIG. 73 schematically illustrates a planar configuration of the second substrate 200 in the imaging device illustrated in FIG. 72. It is to be noted that FIG. 72 illustrates a cross-section corresponding to a line E-E' illustrated in FIG. 73. The imaging device 1 including the amplification transistor AMP of the GAA structure described in the foregoing second embodiment may be formed, for example, as follows.

First, for example, a chemical vapor deposition method (CVD method) is used to form a sacrificial layer 120A in advance on the pad section 120 that couples the floating diffusions FD (the floating diffusions FD1, FD2, FD3, and FD4) of the respective pixels 541A, 541B, 541C, and 541D to each other.

It may be possible to use, as the material of the sacrificial layer 120A, a material which is oxidized to increase etching selectivity with a silicon oxide film. Examples of such a material include Ge. It may be possible to use, in addition, as the material of the sacrificial layer 120A, a material which increases etching selectivity with a silicon oxide film, for example. Examples of such a material include a III-V group compound semiconductor material (e.g., inGaAs, inP and GaAs) and amorphous carbon. Hereinafter, description is given of a case where the sacrificial layer 120A is formed using Ge.

Thereafter, in a manner similar to the foregoing second embodiment, the semiconductor layer 200S is attached to the first substrate 100, and the insulating region 212 and the element separation region 213 are formed at predetermined positions.

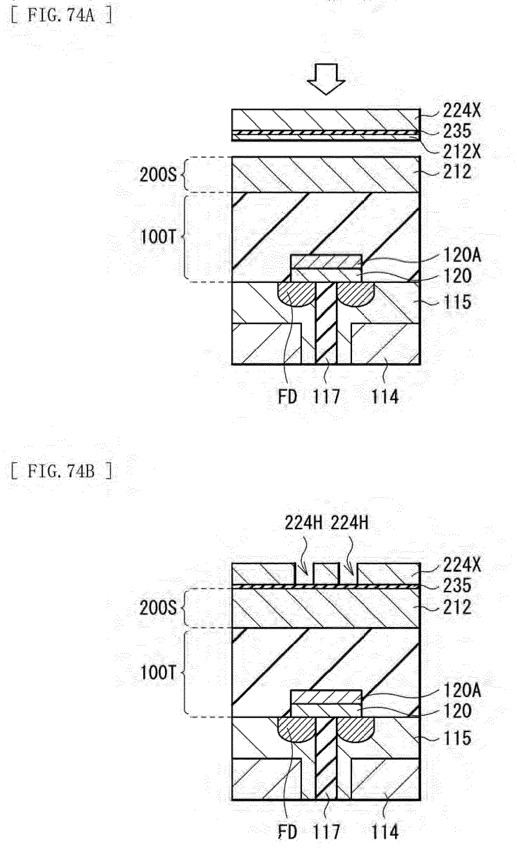

Next, as illustrated in FIG. 74A, for example, the sacrificial layer 235 and the polysilicon film 224X are stacked on the semiconductor layer 200S, and an Si thin film layer including an insulating film 212X is attached to an undersurface of the sacrificial layer 235 on a side opposite to a side of the polysilicon film 224X. Subsequently, as illustrated in FIG. 74B, for example, photolithography and reactive ion etching (RIE) are used to work the polysilicon film 224X and form an opening 224H penetrating the polysilicon film 224X.

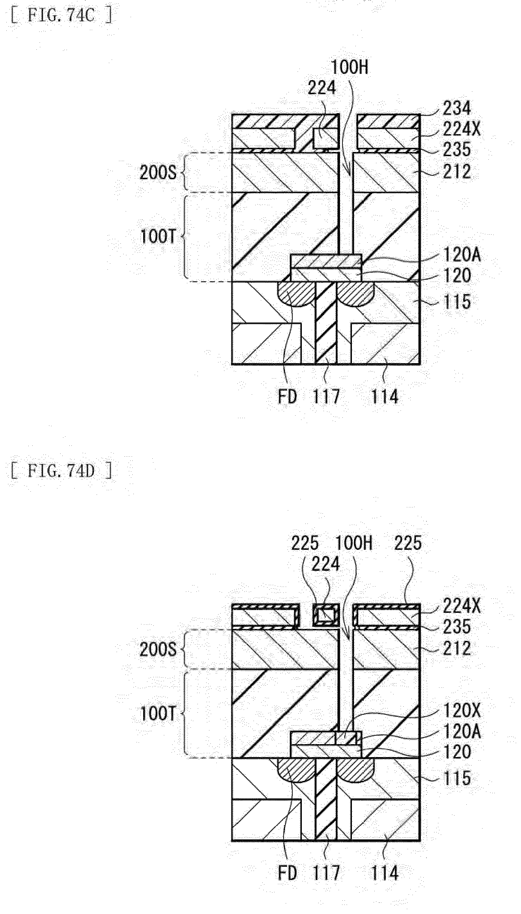

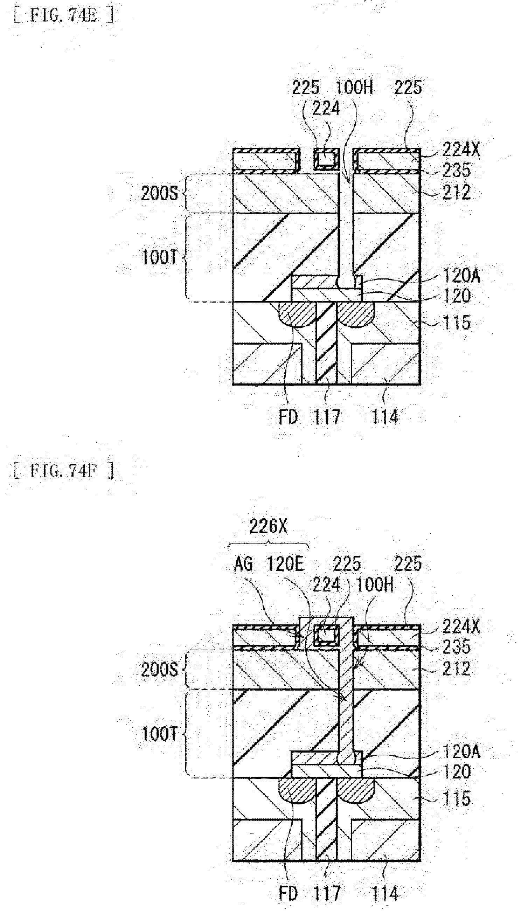

Next, for example, an aqueous alkaline solution (e.g., an etchant of hydrogen fluoride: hydrogen peroxide: acetic acid = 1:200:3) having a selectivity of SiGe/Si of 10 or more and a selectivity of SiOz/Si of 7.5 or more is prepared, and the sacrificial layer 235 is etched. At this time, the sacrificial layer 235 is also retracted in a planar direction, and the sacrificial layer 235 below the channel 224 is removed. Subsequently, as illustrated in FIG. 74C, the resist film 234 protecting one opening 224H is formed on the polysilicon film 224X. Thereafter, for example, dry etching using a gas including a halogen element such as F, Cl, or Br is used to etch the insulating region 212 and the wiring layer 100T and form an opening 100H reaching the sacrificial layer 120A. Next, the resist film 234 is removed, and then an annealing treatment is performed to form a thermal oxide film which is to serve as the gate insulating film 225 on the front surface of the polysilicon film 224X including the channel 224, as illustrated in FIG. 74D. At this time, the sacrificial layer 120A exposed to a bottom portion of the opening 100H is also oxidized to form, for example a GeOz layer 120X. Thereafter, for example, washing with pure water is performed. This allows the GeO₂ layer 120X to be removed, as illustrated in FIG. 74E.

It is to be noted that, in a case where the sacrificial layer 120A is formed using a III-V group material, for example, it is possible to remove the oxidized sacrificial layer 120A by washing with hydrochloric acid. In a case where the sacrificial layer 120A is formed using amorphous carbon, for example, it is possible to remove the oxidized sacrificial layer 120A by washing with sulfuric acid/hydrogen peroxide.

Subsequently, as illustrated in FIG. 74F, for example, a CVD method is used to form the polysilicon film 226X around the channel 224 and in the opening 100H. This allows for collective formation of the gate AG and the through-electrode 120E electrically coupling the amplification transistor AMP and the floating diffusion FD to each other. Thereafter, the passivation film 221, the interlayer insulating film 222, and the first wiring layer W1 are sequentially formed in a manner similar to the foregoing second embodiment. As described above, the second substrate 200 of the imaging device 1 illustrated in FIG. 72 is formed.

In addition, the imaging device 1 including the amplification transistor AMP of the GAA structure described in the foregoing second embodiment may be formed, for example, as follows.

First, the sacrificial layer 120A is formed in advance on the pad section 120 in a manner similar to those described above. Thereafter, in a manner similar to the foregoing second embodiment, the semiconductor layer 200S is attached to the first substrate 100, and the insulating region 212 and the element separation region 213 are formed at predetermined positions.

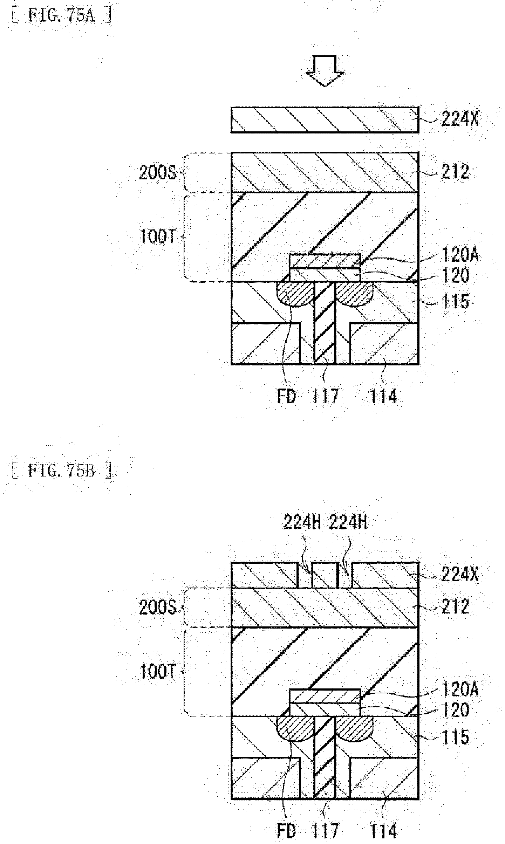

Next, as illustrated in FIG. 75A, the polysilicon film 224X is attached onto the semiconductor layer 200S. Subsequently, as illustrated in FIG. 75B, for example, photolithography and RIE are used to work the polysilicon film 224X and form the opening 224H penetrating the polysilicon film 224X.

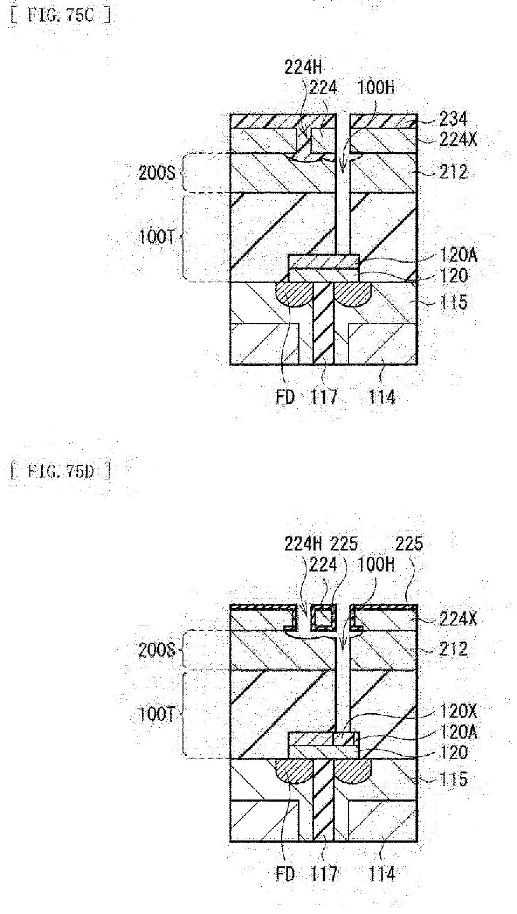

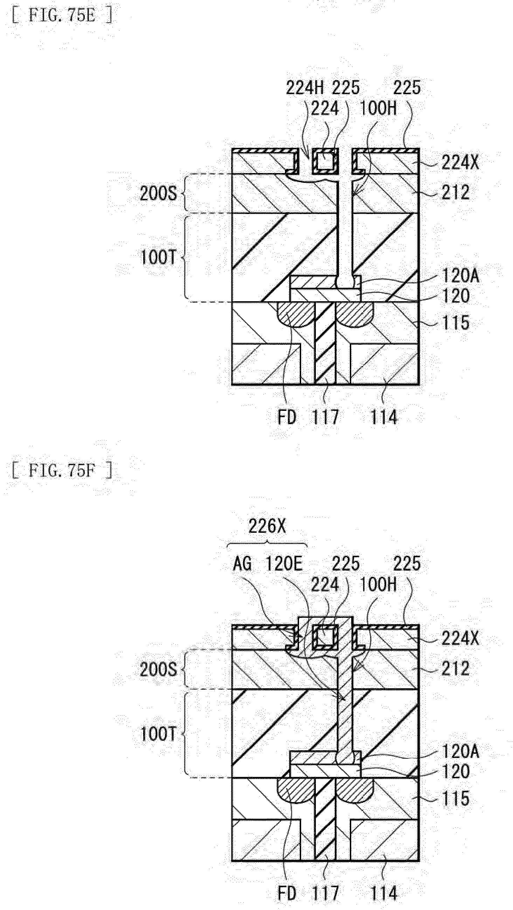

Next, for example, wet etching is performed using hydrofluoric acid diluted to an ultra-low concentration to remove the insulating region 212 below the polysilicon film 224X between the openings 224H. Subsequently, as illustrated in FIG. 75C, the resist film 234 protecting one opening 224H is formed on the polysilicon film 224X. Thereafter, for example, dry etching using a gas including a halogen element such as F, Cl, or Br is used to etch the insulating region 212 and the wiring layer 100T and form the opening 100H reaching the sacrificial layer 120A. Next, the resist film 234 is removed, and then an annealing treatment is performed to form a thermal oxide film which is to serve as the gate insulating film 225 on the front surface of the polysilicon film 224X, as illustrated in FIG. 75D. At this time, the sacrificial layer 120A exposed to a bottom portion of the opening 100H is also oxidized to form, for example a GeOz layer 120X. Thereafter, for example, washing with pure water is performed. This allows the GeOz layer 120X to be removed, as illustrated in FIG. 75E.

Subsequently, as illustrated in FIG. 75F, for example, the polysilicon film 226X is formed around the channel 224 and in the opening 100H. This allows for collective formation of the gate AG and the through-electrode 120E electrically coupling the amplification transistor AMP and the floating diffusion FD to each other. Thereafter, the passivation film 221, the interlayer insulating film 222, and the first wiring layer W1 are sequentially formed in a manner similar to the foregoing second embodiment. As described above, the second substrate 200 of the imaging device 1 illustrated in FIG. 72 is formed.

As described above, in the present modification example, the sacrificial layer 120A is formed in advance on the pad section 120. This allows for collective formation of the gate AG and the through-electrode 120E electrically coupling the amplification transistor AMP and the floating diffusion FD to each other. Therefore, it is possible to simplify the manufacturing steps and to reduce bonding resistance, in addition to the effects of the foregoing second embodiment. In addition, it is possible to form the amplification transistor AMP without detaching the oxide film around the channel 224, thus making it possible to reduce destabilization of a threshold voltage due to a parasitic transistor with an adjacent contact in the second substrate 200.

### <13. Modification Example 20>

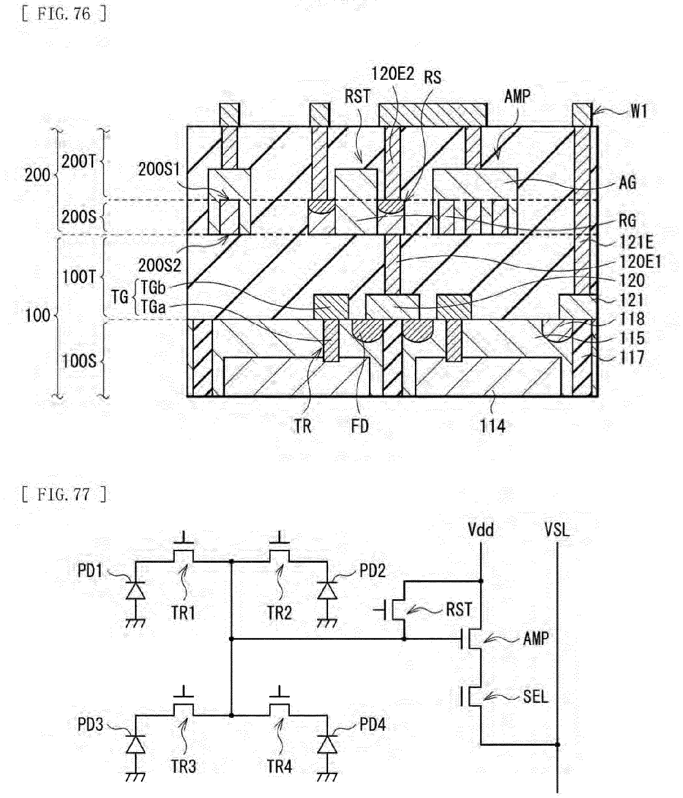

FIG. 76 schematically illustrates a cross-sectional configuration of main parts of the imaging device 1 according to Modification Example 20 of the present disclosure. FIG. 77 is an equivalent circuit diagram of the imaging device 1 illustrated in FIG. 76. In the foregoing first embodiment, the example is given in which the floating diffusion FD and the gate AG of the amplification transistor AMP are directly coupled to each other by the through-electrode 120E. However, for example, the floating diffusion FD and a source RS of the reset transistor RST may be directly coupled to each other by the through-electrode 120E1.

The foregoing embodiments and the like exemplify the pixel circuit 210 including the FD conversion gain switching transistor FDG; however, the FD conversion gain switching transistor FDG may be omitted. At that time, as illustrated in FIG. 77, the source RS of the reset transistor RST has the same potential as those of the floating diffusion FD and the gate AG of the amplification transistor AMP.

In the present modification example, the reset transistor RST has the Fin-type FD-SOI structure, and the source and drain thereof are formed across from the front surface (the surface 200S1) to the back surface (the surface 200S2) of the semiconductor layer 200S. Therefore, as illustrated in FIG. 76, coupling the through-electrode 120E1 to the surface 200S2 of the semiconductor layer 200S in which the source RS of the reset transistor RST is formed makes it possible to electrically couple the floating diffusion FD and the source RS of the reset transistor RST to each other. Such an imaging device 1 may be formed, for example, as follows.

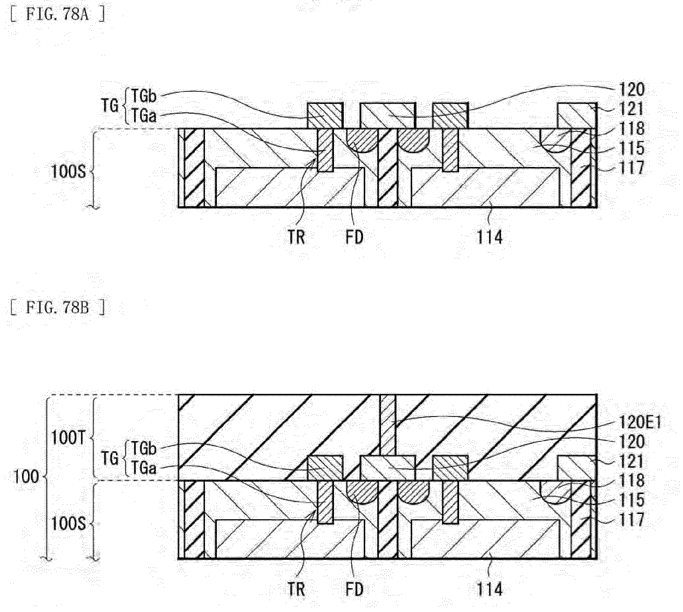

First, as illustrated in FIG. 78A, the pad sections 120 and 121 and a wiring line such as the gate TGb of the transfer transistor TR are formed on the semiconductor layer 100S. Subsequently, as illustrated in FIG. 78B, after the interlayer insulating film 123 covering the wiring line is formed on the semiconductor layer 100S, the through-electrode 120E1 reaching the pad section 120 is provided to form the wiring layer 100T.

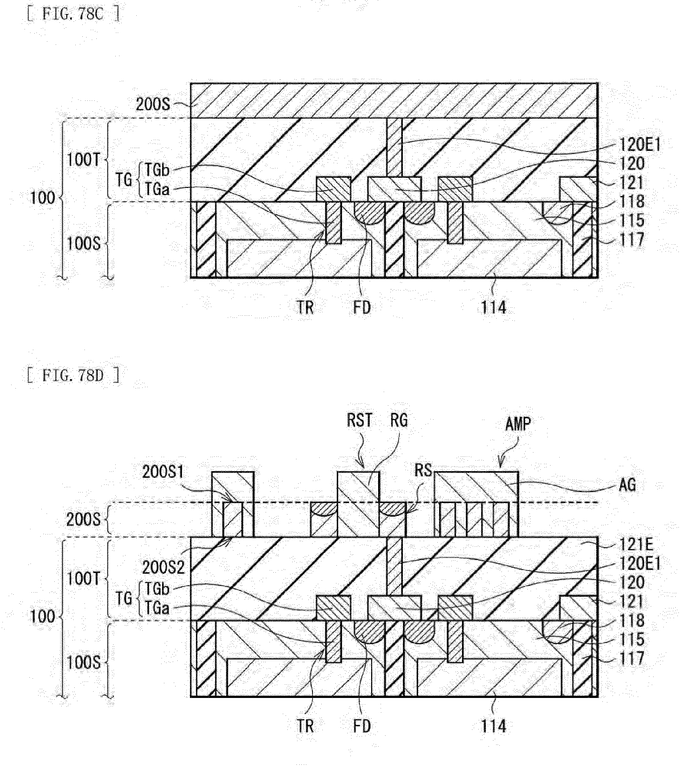

Next, as illustrated in FIG. 78C, the semiconductor layer 200S is attached onto the wiring layer 100T. Subsequently, as illustrated in FIG. 78D, a source follower circuit, the amplification transistor AMP, the reset transistor RST, the selection transistor SEL, and the FD conversion gain switching transistor FDG are formed in the semiconductor layer 200S. At this time, at least the gate RG of the reset transistor RST is allowed to have the Fin structure penetrating the semiconductor layer 200S. This allows the source RS of the reset transistor RST and the floating diffusion FD to be electrically coupled to each other through the through-electrode 120E1. There is no restriction on other transistors; however, for simplification of the structure and the number of steps, it is preferable to adopt the Fin structure similar to that of the reset transistor RST.

Thereafter, the interlayer insulating film 222 and various wiring lines are provided to form the wiring layer 200T. As described above, the imaging device 1 illustrated in FIG. 76 is completed.

In this manner, in the present modification example, the floating diffusion FD and the source RS of the reset transistor RST are directly coupled to each other by the through-electrode 120E1. This eliminates the needs for separately provide a wiring line to electrically couple the floating diffusion FD to the reset transistor RST, thus reducing the area of the insulating region 212 formed in the plane of the semiconductor layer 200S and securing the area of the semiconductor layer 200S for formation of the pixel circuit 210. That is, it is possible to improve area efficiency of the pixel transistor included in the pixel circuit 210 in the second substrate 200.

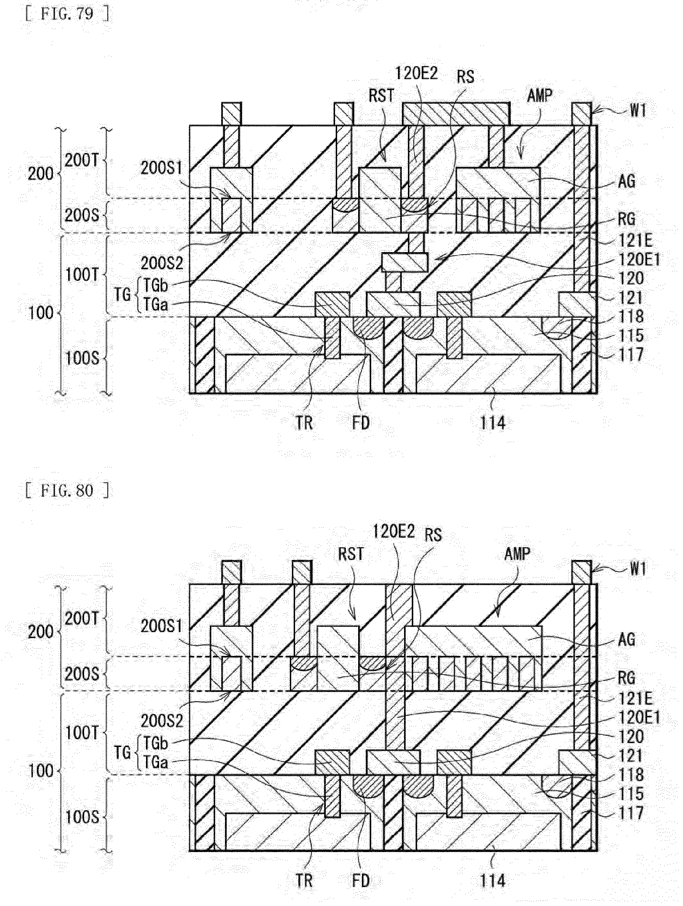

In addition, in the present modification example, the example is given in which the floating diffusion FD and the source RS of the reset transistor RST are superimposed on each other in a stacking direction in a plan view for direct coupling between the floating diffusion FD and the source RS of the reset transistor RST by the through-electrode 120E1. However, this is not limitative. For example, as illustrated in FIG. 79, a wiring line extending in an in-plane direction may be provided inside the wiring layer 100T to use the wiring line as a portion of the through-electrode 120E1 coupling the floating diffusion FD and the source RS of the reset transistor RST to each other. This improves flexibility of the layout of the pixel transistors provided in the semiconductor layer 200S.

Further, in the present modification example, the example is given in which the floating diffusion FD and the source RS of the reset transistor RST are directly coupled to each other by the through-electrode 120E1. However, this example may be combined with Modification Example 5, for example. That is, as illustrated in FIG. 80, a side surface of the source RS of the reset transistor RST and the side surface of the gate AG of the amplification transistor AMP are brought into contact with the through-electrode 120E penetrating the semiconductor layer 200S and the wiring layer 100T. This makes it possible to further reduce the area of the insulating region 212 formed in the plane of the semiconductor layer 200S. That is, it is possible to further improve the area efficiency of the pixel transistors included in the pixel circuit 210 in the second substrate 200.

### <14. Modification Example 21>

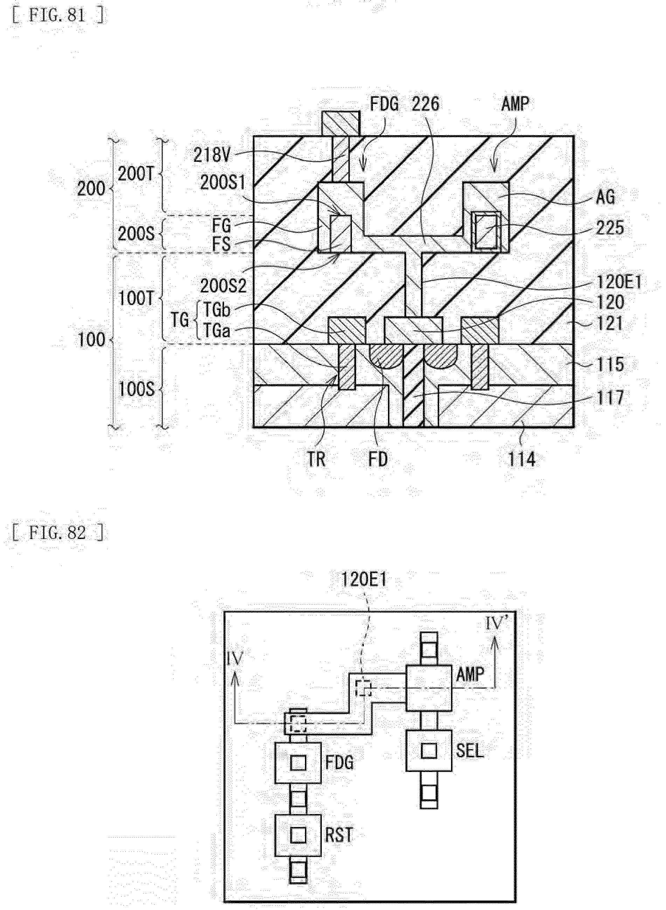

FIG. 81 schematically illustrates a cross-sectional configuration of main parts of the imaging device 1 according to Modification Example 21 of the present disclosure. FIG. 82 schematically illustrates a planar configuration of the second substrate 200 in the imaging device 1 illustrated in FIG. 81. In the foregoing embodiments and the like, the example is given in which the gate AG of the amplification transistor AMP and a source FS of the FD conversion gain switching transistor FDG are electrically coupled to each other through the coupling section 218V and the first wiring layer W1. However, this is not limitative.

In the imaging device 1 of the modification example, polysilicon 226 forming the gate of the pixel transistor is extended between the amplification transistor AMP and the FD conversion gain switching transistor FDG, and the polysilicon 226 is used to electrically couple the gate AG of the amplification transistor AMP and the source FS of the FD conversion gain switching transistor FDG to each other. Such an imaging device 1 may be formed, for example, as follows.

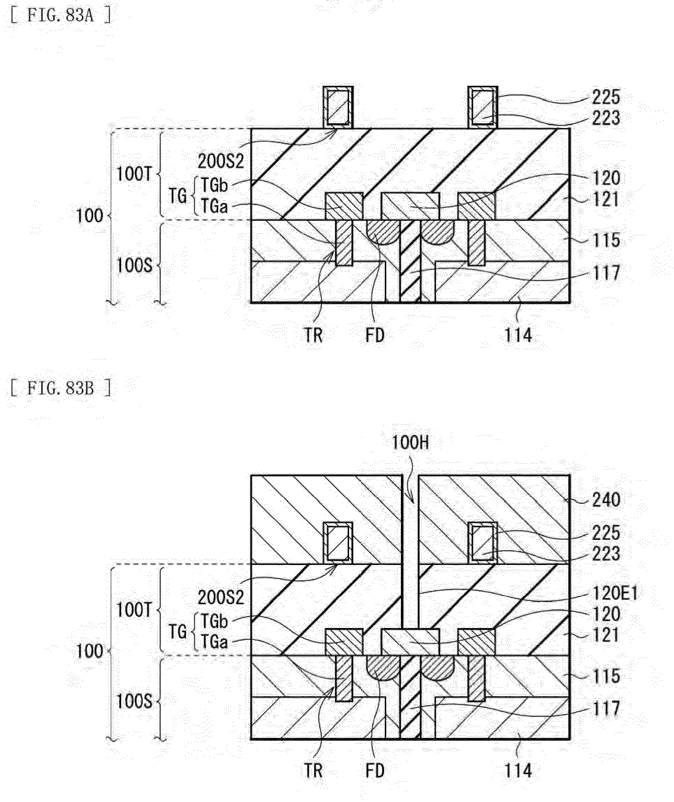

First, as illustrated in FIG. 83A, the semiconductor layer 200S is worked to form, on the wiring layer 100T, the fins 223 of the various transistors included in the pixel circuit 210 and to form a silicon oxide film which is to serve as the gate insulating film 225 around the fin 223.

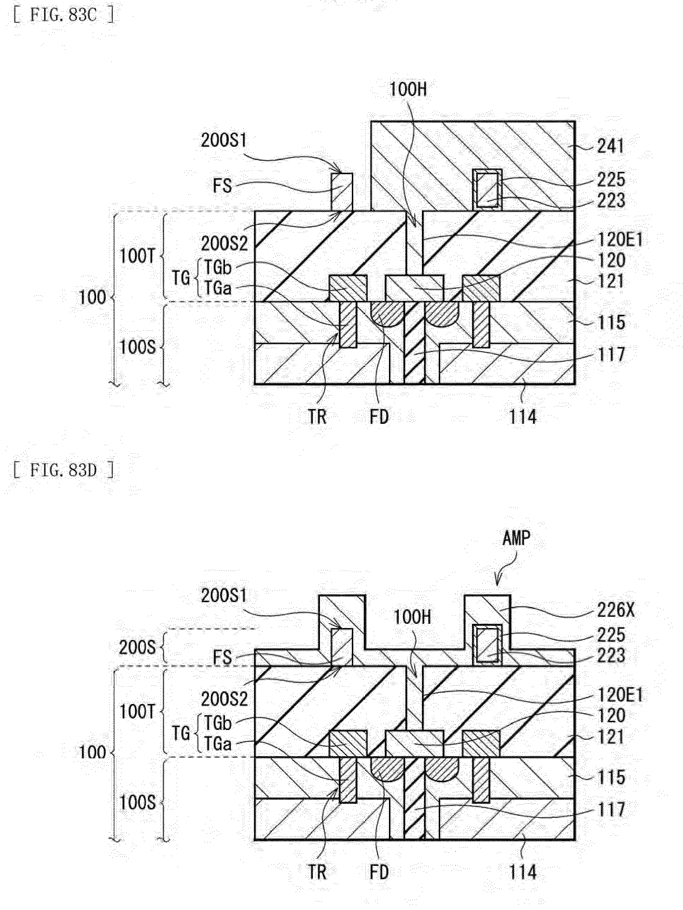

Next, as illustrated in FIG. 83B, a resist film 240 having a predetermined pattern is formed on the wiring layer 100T, and the opening 100H reaching the pad section 120 is formed. Subsequently, as illustrated in FIG. 83C, the opening 100H is embedded on the wiring layer 100T, and a resist film 241 covering those other than the fin 223 included in the FD conversion gain switching transistor FDG is formed to detach the gate insulating film 225 provided around the source FS of the fin 223 included in the FD conversion gain switching transistor FDG.

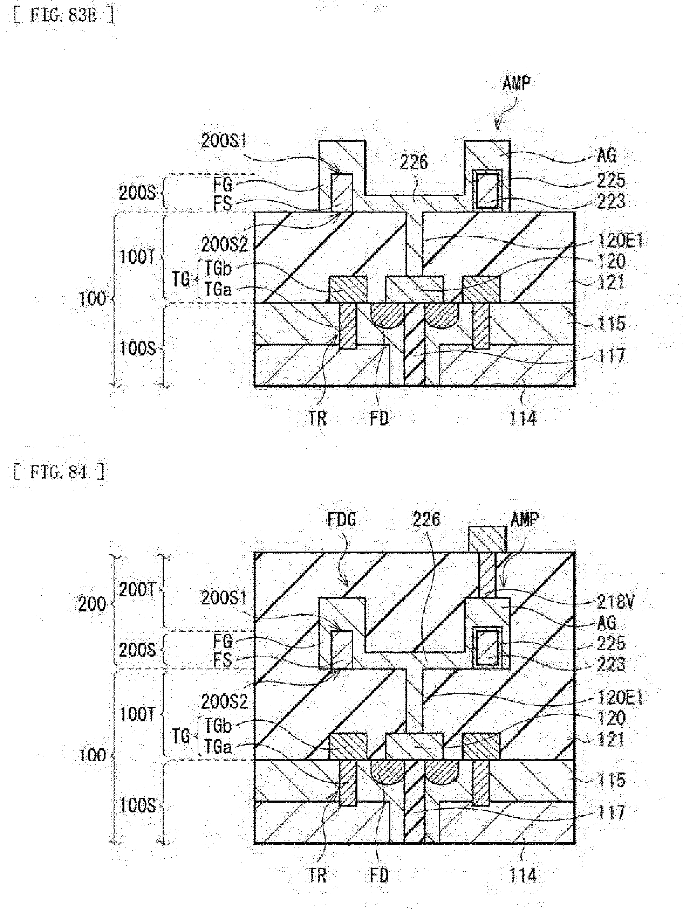

Next, after the resist film 241 is removed, the polysilicon film 226X is formed that covers the fin 223 and fills the opening 100H, as illustrated in FIG. 83D. Subsequently, as illustrated in FIG. 83E, the polysilicon film 226X is worked. This allows for formation of the respective gates AG and FG of the amplification transistor AMP and the FD conversion gain switching transistor FDG, the polysilicon 226 coupling the gate AG of the amplification transistor AMP and the source FS of the FD conversion gain switching transistor FDG to each other, and the through-electrode 120E1 coupled thereto.

Thereafter, the interlayer insulating film 222 and various wiring lines are provided to form the wiring layer 200T. As described above, the imaging device 1 illustrated in FIG. 81 is completed.

As described above, in the present modification example, the polysilicon 226 forming the gate of the pixel transistor is used to electrically couple the gate AG of the amplification transistor AMP and the source FS of the FD conversion gain switching transistor FDG, which have the same potential, to each other, and this polysilicon film and the pad section 120 are electrically coupled to each other through the through-electrode 120E1. This eliminates the need for the through-wiring line (e.g., the through-electrode 120E) penetrating the first substrate 100 and the second substrate 200. Therefore, the area of the insulating region 212 formed in the plane of the semiconductor layer 200S is reduced to secure the area of the semiconductor layer 200S forming the pixel circuit 210. That is, it is possible to improve the area efficiency of the pixel transistor included in the pixel circuit 210 in the second substrate 200.

In addition, there is no need to form, above the pad section 120, the gate AG of the amplification transistor AMP or the source FS of the FD conversion gain switching transistor FDG having the same potential as that of the floating diffusion FD. This improves flexibility of the layout of the pixel transistors provided in the semiconductor layer 200S.

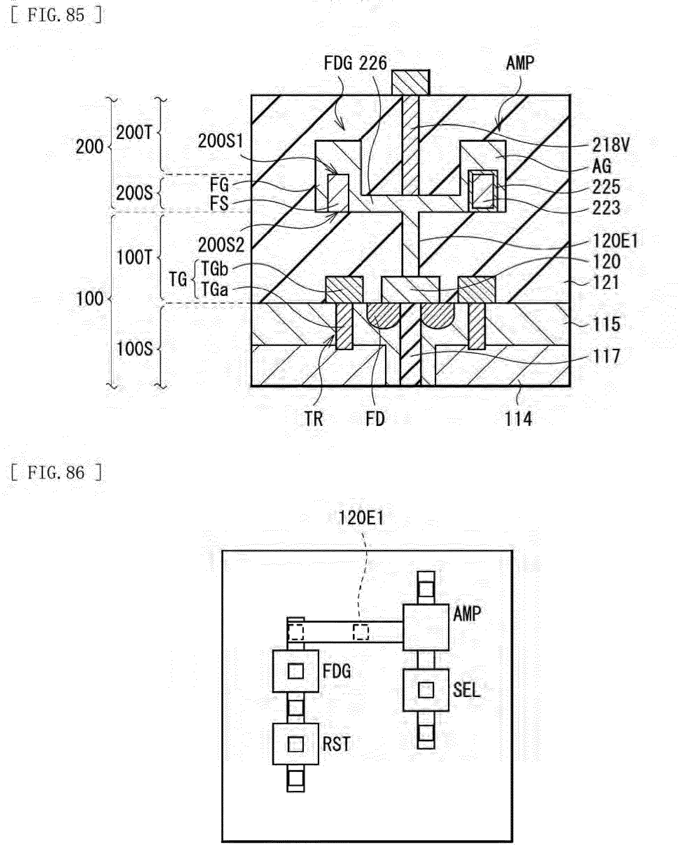

Further, the example is given, in FIG. 81, in which the coupling section 218V to be coupled to the first wiring layer W1 is coupled to the FD conversion gain switching transistor FDG. However, this is not limitative. For example, as illustrated in FIG. 84, the coupling section 218V may be coupled to the amplification transistor AMP. Alternatively, as illustrated in FIG. 85, the coupling section 218V may be coupled to the polysilicon 226 that couples the gate AG of the amplification transistor AMP and the source FS of the FD conversion gain switching transistor FDG to each other.

Furthermore, as illustrated in FIG. 86, for example, the gate AG of the amplification transistor AMP and the source FS of the FD conversion gain switching transistor FDG may be arranged linearly and coupled to each other by the polysilicon 226. This shortens the wiring line length of the polysilicon 226 coupling the gate AG of the amplification transistor AMP and the source FS of the FD conversion gain switching transistor FDG to each other, thus making it possible to reduce the capacity.

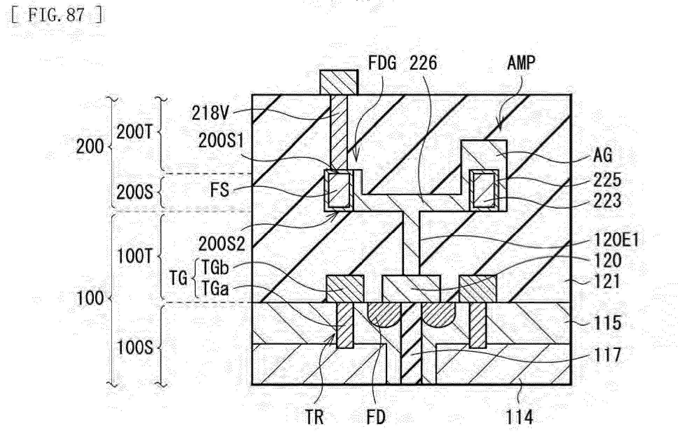

In addition, as illustrated in FIG. 87, for example, the silicon oxide film may be left around the source FS of the FD conversion gain switching transistor FDG to electrically couple the source FS of the FD conversion gain switching transistor FDG and the polysilicon 226 to each other through the coupling section 218V.

### < 15. Modification Example 22>

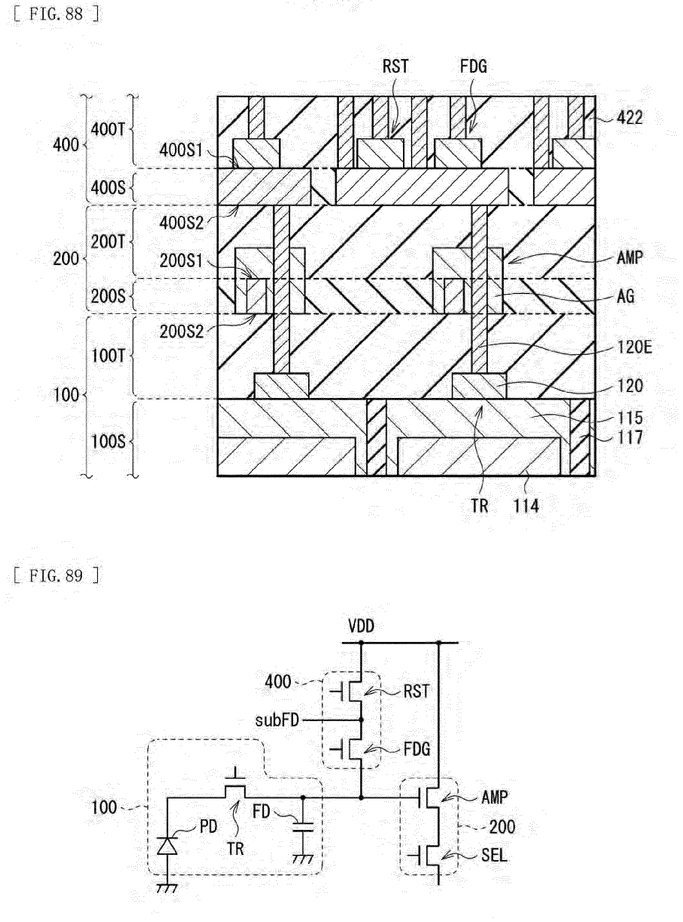

FIG. 88 schematically illustrates a cross-sectional configuration of main parts of the imaging device 1 according to Modification Example 22 of the present disclosure. FIG. 89 is an equivalent circuit diagram of the imaging device 1 illustrated in FIG. 88. In the foregoing embodiments, the example is given in which the pixel circuit 210 is provided in the second substrate 200. However, this is not limitative. For example, a fourth substrate 400 including a semiconductor layer 400S may be provided between the second substrate 200 and third substrate 300 described above, and a plurality of transistors included in the pixel circuit 210 may be separately provided in the semiconductor layers 200S and 400S.

Specifically, as illustrated in FIGs. 88 and 89, the amplification transistor AMP and the selection transistor SEL, of the plurality of transistors included in the pixel circuit 210, may be provided in the semiconductor layer 200S, and the reset transistor RST and the FD conversion gain switching transistor FDG may be provided in the semiconductor layer 400S. This makes it possible to secure the area for formation of the pixel transistor such as the amplification transistor AMP while reducing the pixel pitch.

Further, in a case where the amplification transistor AMP and the selection transistor SEL are provided in the semiconductor layer 200S and the reset transistor RST and the FD conversion gain switching transistor FDG are provided in the semiconductor layer 400S, it is preferable to adopt the following planar layout. For example, it is preferable that the source or the drain of the transfer transistor TR, the gate AG of the amplification transistor AMP, and the source of the FD conversion gain switching transistor FDG be laid out to be superimposed on each other in a plan view. Thus, causing the above-described through-electrode 120E to penetrate to the fourth substrate 400 makes it possible to electrically couple the source or the drain of the transfer transistor TR, the gate AG of the amplification transistor AMP, and the source of the FD conversion gain switching transistor FDG to one another through the through-electrode 120E. That is, the wiring line length is minimized, making it possible to theoretically minimize the FD capacity. Further, the number of vias for electrically coupling the pixel transistors is reduced, thus making it possible to further reduce the pixel pitch. In addition, stress caused by the via is reduced, thus making it possible to reduce variation in characteristics of the transistor.

Such an imaging device 1 may be formed, for example, as follows.

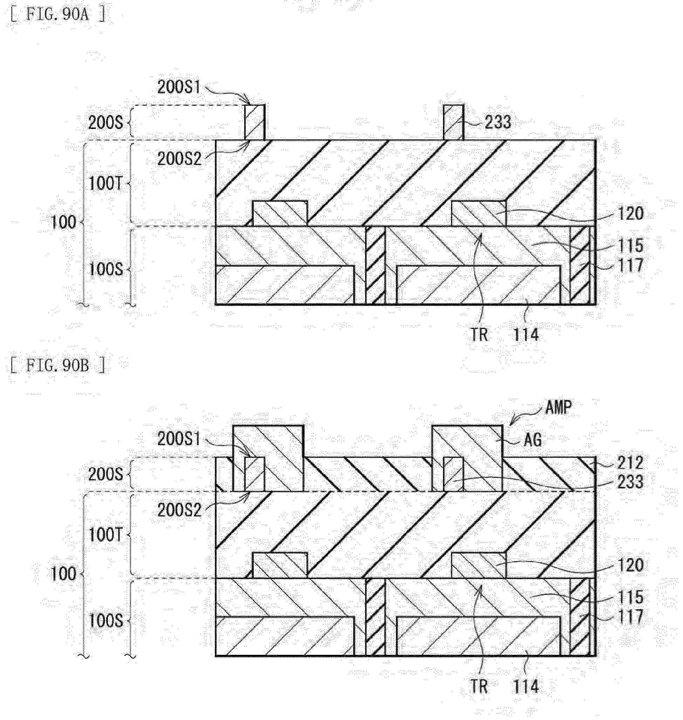

First, as illustrated in FIG. 90A, for example, etching is used to work the semiconductor layer 200S and form, on the wiring layer 100T, a fin 233 of each of the amplification transistor AMP and the selection transition SEL. Next, as illustrated in FIG. 90B, the insulating region 212 is formed, and polysilicon is formed and worked to form gates (e.g., the gate AG) of the amplification transistor AMP and the selection transition SEL.

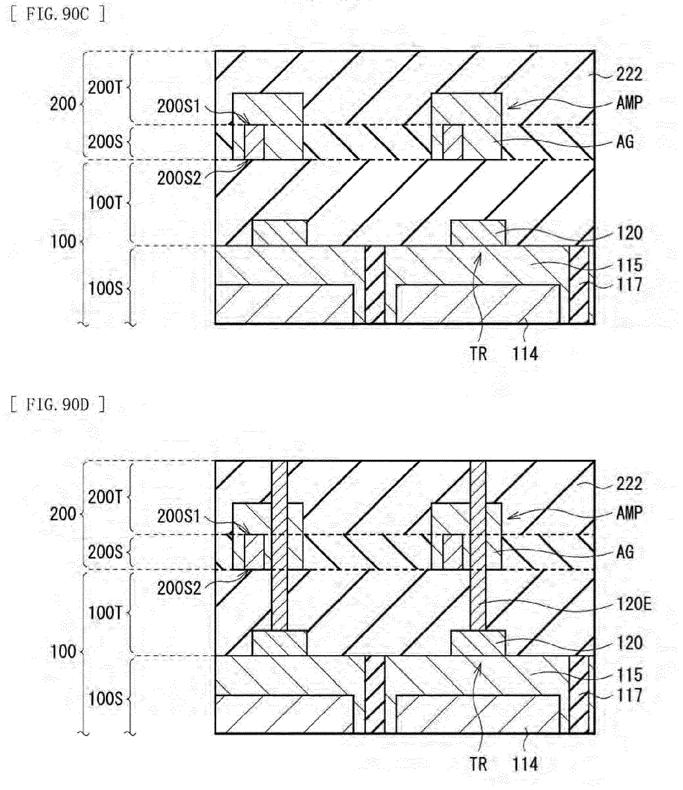

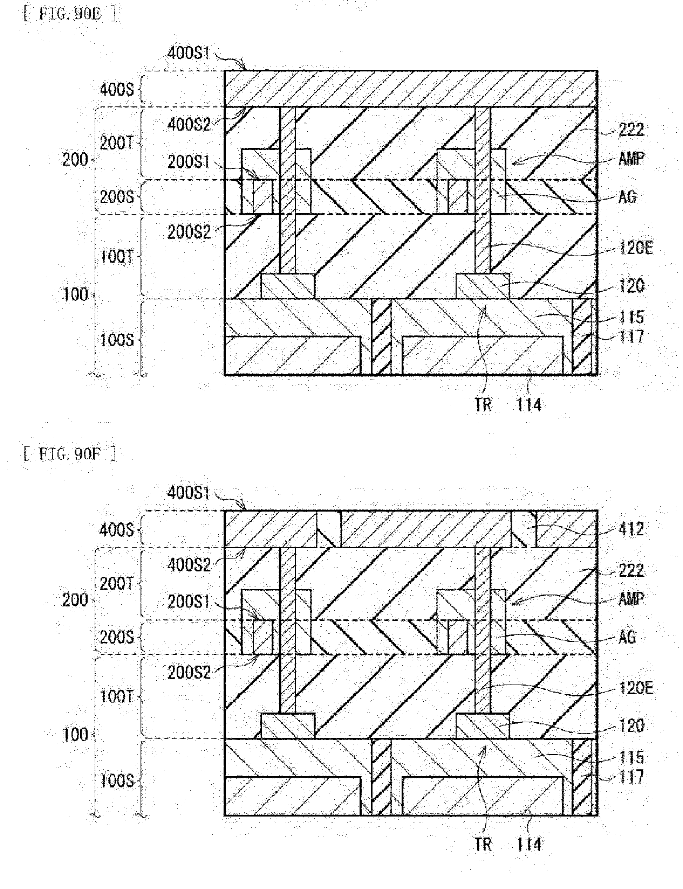

Subsequently, after the interlayer insulating film 222 is formed as illustrated in FIG. 90C, the through-electrode 120E is formed that penetrates the gate AG of the amplification transistor AMP and reaches the pad section 120 provided on the source or the drain of the transfer transistor TR, as illustrated in FIG. 90D. Next, as illustrated in FIG. 90E, the semiconductor layer 400S is attached onto the wiring layer 200T.

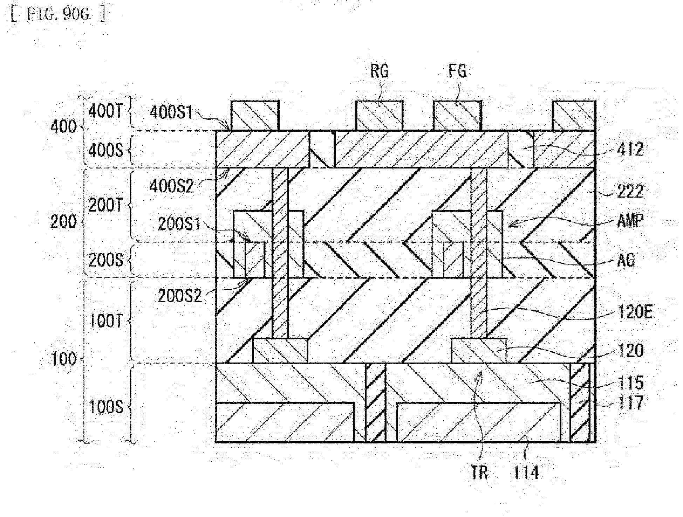

Subsequently, as illustrated in FIG. 90F, for example, after etching is used to work the semiconductor layer 400S, an insulating region 412 is formed. Next, as illustrated in FIG. 90G, the respective gates RG and FG of the reset transistor RST and the FD conversion gain switching transistor FDG are formed. Thereafter, an interlayer insulating film 422 and various wiring lines are provided to form a wiring layer 400T. As described above, the imaging device 1 illustrated in FIG. 88 is completed.

In this manner, in the present modification example, among the amplification transistor AMP, the selection transistor SEL, the reset transistor RST, and the FD conversion gain switching transistor FDG included in the pixel circuit 210, the amplification transistor AMP and the selection transistor SEL are provided in the semiconductor layer 200S, whereas the reset transistor RST and the FD conversion gain switching transistor FDG are provided in the semiconductor layer 400S. This makes it possible to secure the area for formation of the pixel transistor such as the amplification transistor AMP while reducing the pixel pitch.

In addition, the source or the drain of the transfer transistor TR, the gate AG of the amplification transistor AMP, and the source of the FD conversion gain switching transistor FDG are superimposed on each other in a plan view, thus making it possible to electrically couple these components to one another by the through-electrode 120E. Therefore, it is possible to theoretically minimize the FD capacity. Further, the number of vias for electrically coupling the pixel transistors is reduced, thus making it possible to further reduce the pixel pitch. In addition, stress caused by the via is reduced, thus making it possible to reduce variation in characteristics of the transistor.

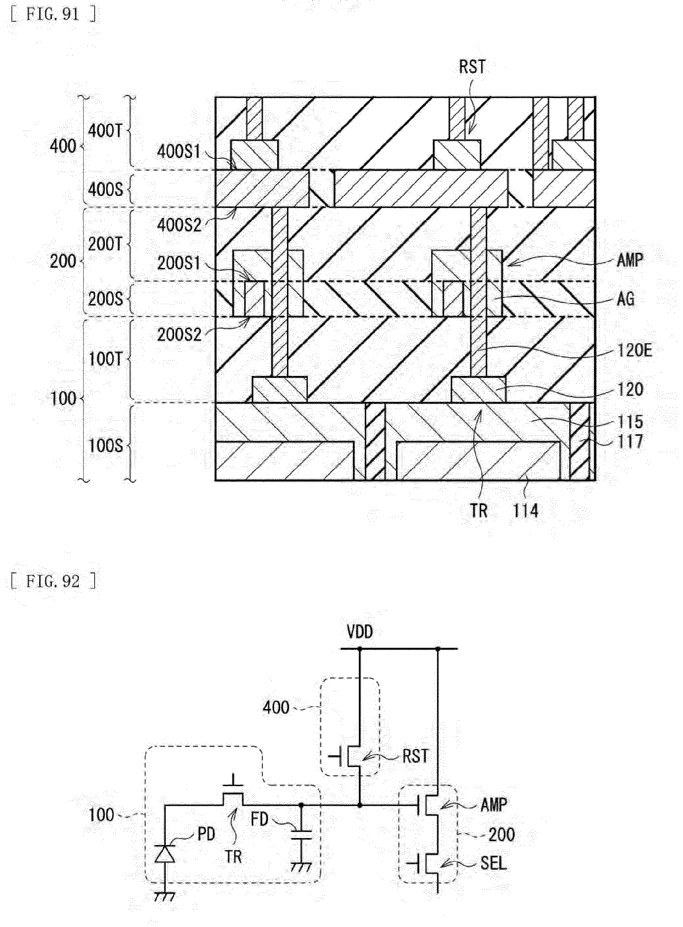

Further, FIGs. 88 and 89 give the example of including the FD conversion gain switching transistor FDG as a plurality of transistors included in the pixel circuit 210. However, for example, as illustrated in FIG. 92, the FD conversion gain switching transistor FDG may be omitted. At that time, for example, as illustrated in FIG. 91, the source or the drain of the transfer transistor TR, the gate AG of the amplification transistor AMP, and the source of the reset transistor RST are superimposed on each other in a plan view, and these components are electrically coupled to one another by the through-electrode 120E.

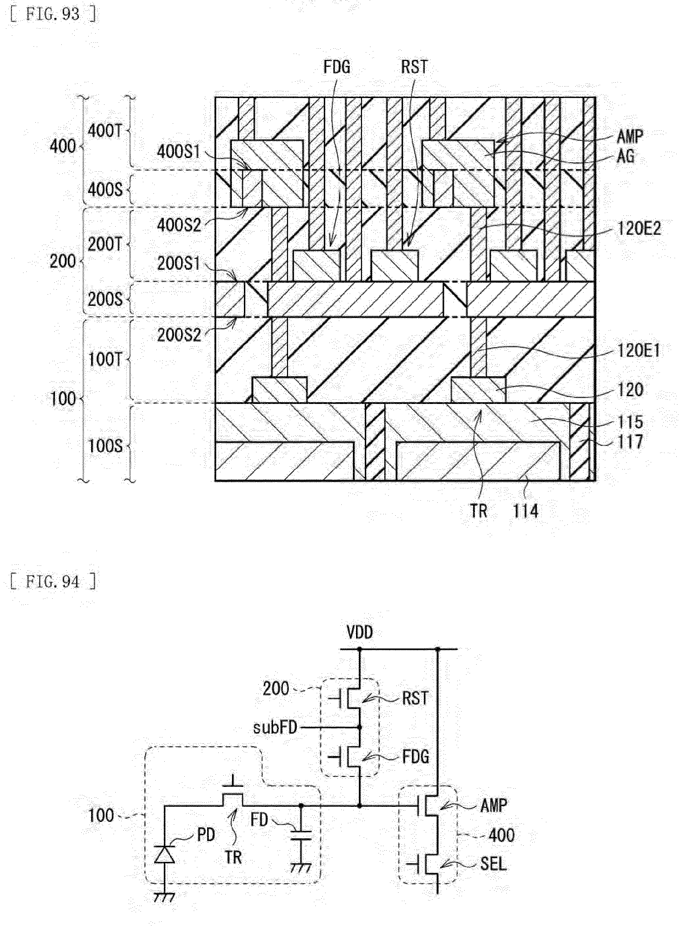

Furthermore, FIG. 88, FIG. 91, and the like give the example in which, among the amplification transistor AMP, the selection transistor SEL, the reset transistor RST, and the FD conversion gain switching transistor FDG included in the pixel circuit 210, the amplification transistor AMP and the selection transistor SEL are provided in the semiconductor layer 200S, whereas the reset transistor RST and the FD conversion gain switching transistor FDG are provided in the semiconductor layer 400S. However, this is not limitative. For example, as illustrated in FIGs. 93 and 94, the reset transistor RST and the FD conversion gain switching transistor FDG may be provided in the semiconductor layer 200S, whereas the amplification transistor AMP and selection transistor SEL may be provided in the semiconductor layer 400S.

Such an imaging device 1 may be formed, for example, as follows.

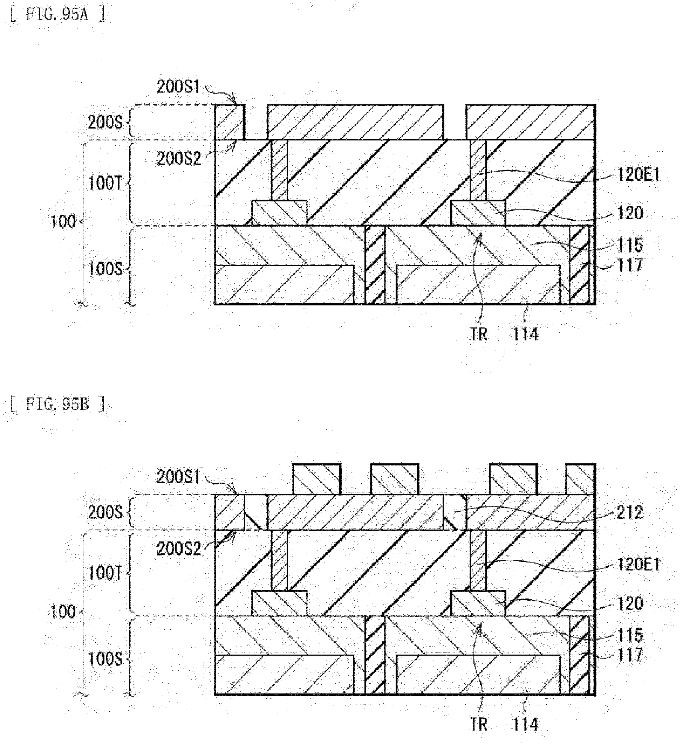

First, as illustrated in FIG. 95A, after the through-electrode 120E1 is formed in the wiring layer 100T, the semiconductor layer 200S is attached to the wiring layer 100T, and, for example, etching is used to work the semiconductor layer 200S. Next, as illustrated in FIG. 95B, after the insulating region 212 is formed, the respective gates RG and FG of the reset transistor RST and the FD conversion gain switching transistor FDG are formed on the semiconductor layer 200S.

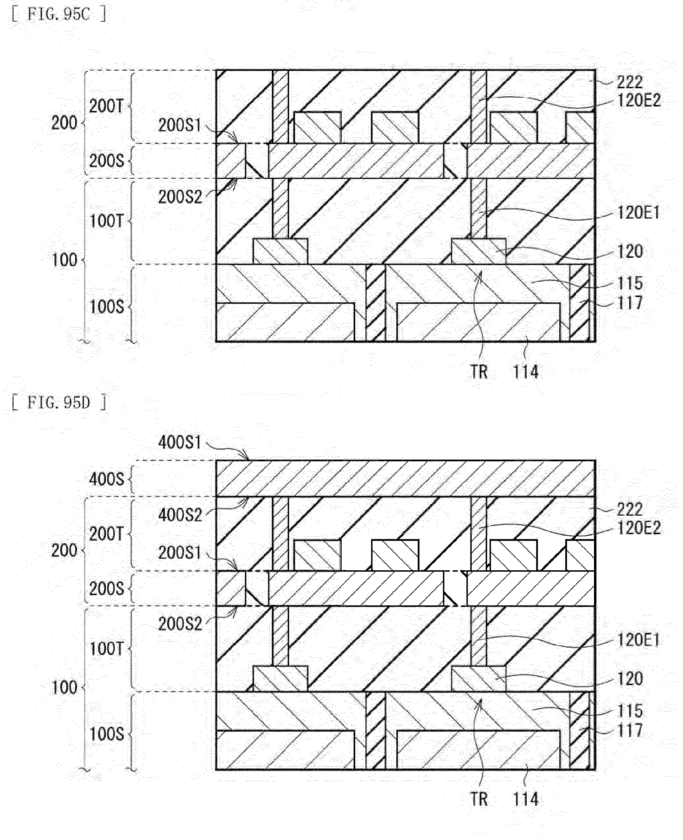

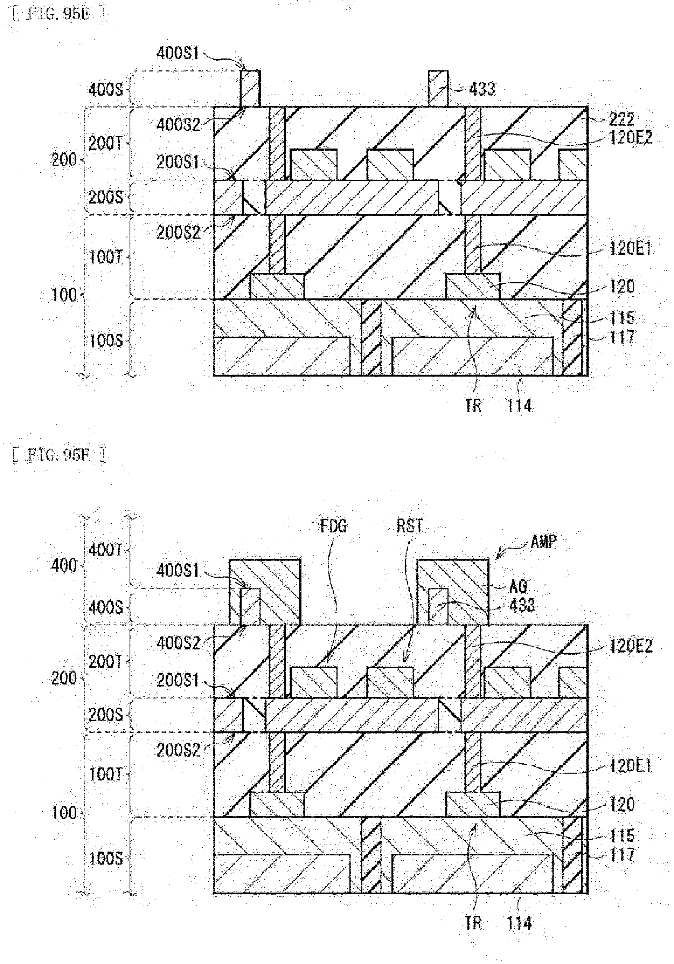

Subsequently, as illustrated in FIG. 95C, the through-electrode 120E2 is formed that penetrates the interlayer insulating film 222 and the interlayer insulating film 222. Next, as illustrated in FIG. 95D, the semiconductor layer 400S is attached onto the wiring layer 200T. Subsequently, as illustrated in FIG. 95E, for example, etching is used to work the semiconductor layer 400S and form a fin 433 of each of the amplification transistor AMP and the selection transistor SEL.

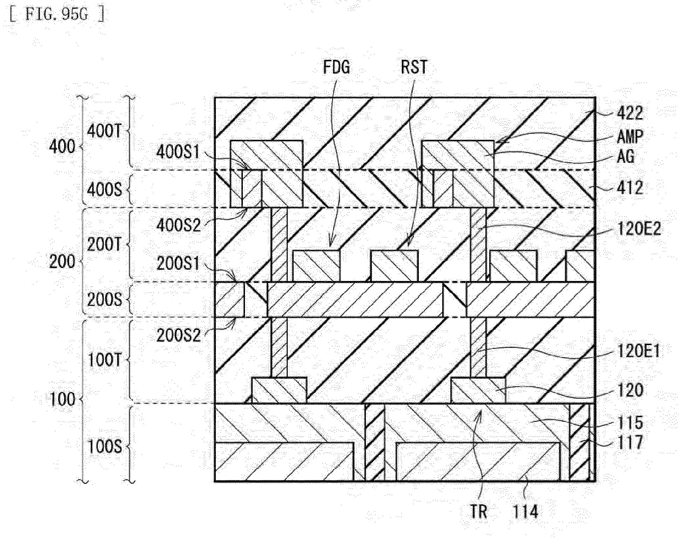

Next, as illustrated in FIG. 95F, polysilicon is formed as a film and is worked to thereby form gates (e.g., the gate AG) of the amplification transistor AMP and the selection transistor SEL. Subsequently, as illustrated in FIG. 95G, the insulating region 412 and the interlayer insulating film 422 are formed. Thereafter, various wiring lines are provided to form the wiring layer 400T. As described above, the imaging device 1 illustrated in FIG. 93 is completed.

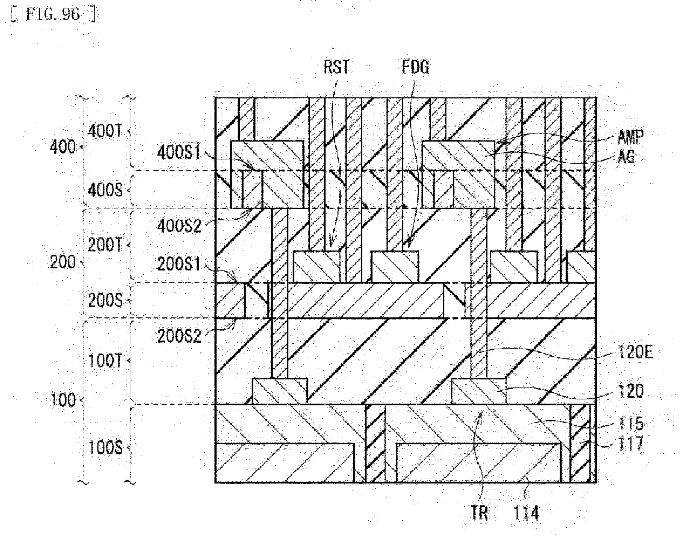

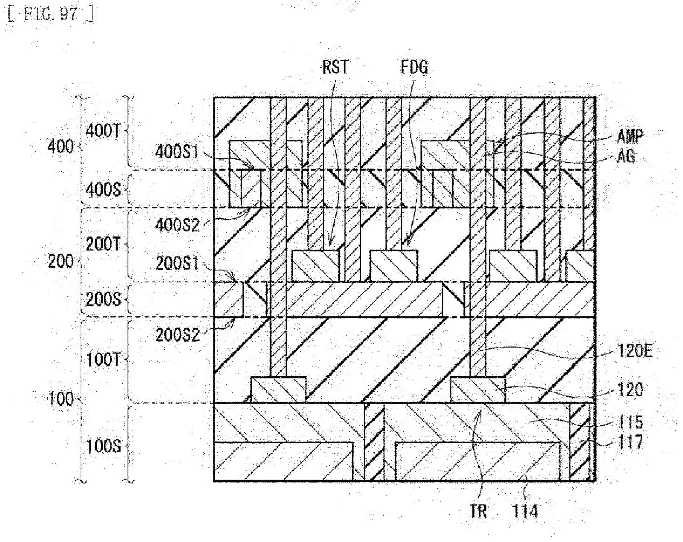

In addition, FIG. 93 gives the example in which the gate AG of the amplification transistor AMP and the source of the FD conversion gain switching transistor FDG are electrically coupled to each other through the through-electrode 120E1, and the source of the FD conversion gain switching transistor FDG and the gate AG of the amplification transistor AMP are electrically coupled to each other through the through-electrode 120E2. However, this is not limitative. For example, as illustrated in FIG. 96, the gate AG of the amplification transistor AMP, the source of the FD conversion gain switching transistor FDG, and the gate AG of the amplification transistor AMP may be electrically coupled to each other through the through-electrode 120E that penetrates the semiconductor layer 200S and reaches a surface 400S2 of the semiconductor layer 400S. Further, for example, as illustrated in FIG. 97, the through-electrode 120E may further be allowed to penetrate the gate AG of the amplification transistor AMP provided in the fourth substrate.

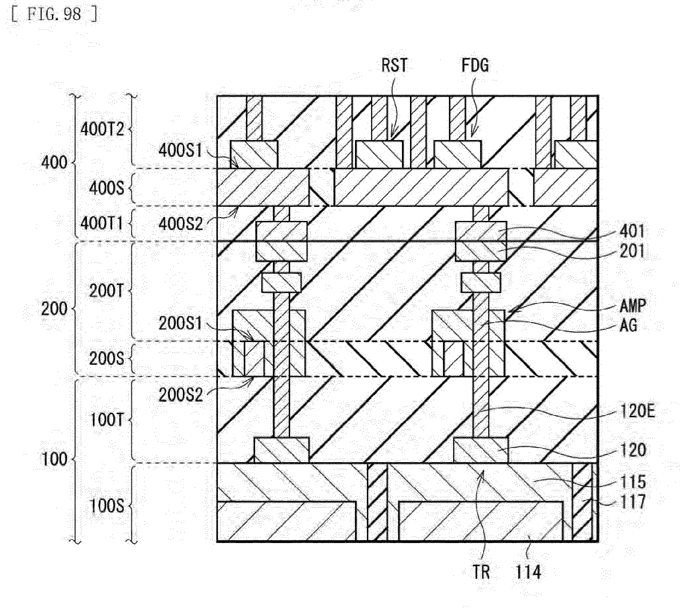

It is to be noted that, for example, as illustrated in FIG. 98, the second substrate 200 and the fourth substrate 400 may be electrically coupled to each other by bonding the contact sections 201 and 401, to each other, which are provided, respectively, on the front surface of the wiring layer 200T of the second substrate 200 facing the fourth substrate 400 and on a front surface of a wiring layer 400T1 provided on a side of the surface 400S2 of the fourth substrate 400 facing the second substrate 200.

### (Other Modification Examples)

The foregoing Modification Examples 1 to 22 may be combined with one another.

### <16. Application Example>

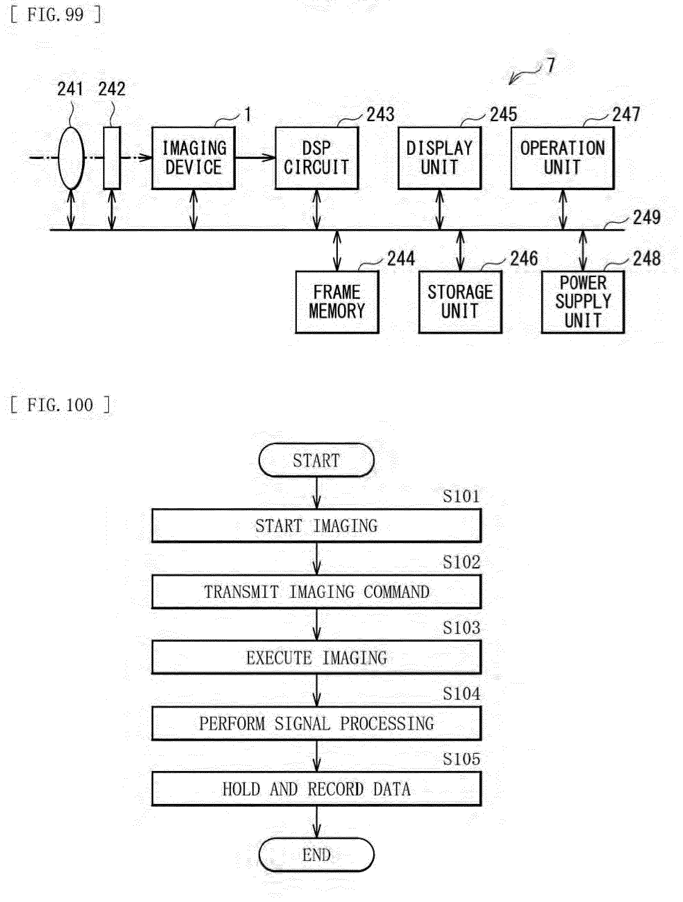

FIG. 99 illustrates an example of an outline configuration of an imaging system 7 including the imaging device 1 according to any of the foregoing embodiments and the like.

The imaging system 7 is an electronic apparatus including, for example, an imaging device such as a digital still camera or a video camera, or a portable terminal apparatus such as a smartphone or a tablet-type terminal. The imaging system 7 includes, for example, the imaging device 1 according to any of the foregoing embodiments and the like, a DSP circuit 243, a frame memory 244, a display unit 245, a storage unit 246, an operation unit 247, and a power supply unit 248. In the imaging system 7, the imaging device 1 according to any of the foregoing embodiments and the like, the DSP circuit 243, the frame memory 244, the display unit 245, the storage unit 246, the operation unit 247, and the power supply unit 248 are coupled to one another via a bus line 249.

The imaging device 1 according to any of the foregoing embodiments and the like outputs image data corresponding to incident light. The DSP circuit 243 is a signal processing circuit that processes a signal (image data) outputted from the imaging device 1 according to any of the foregoing embodiments and the like. The frame memory 244 temporarily holds the image data processed by the DSP circuit 243 in a frame unit. The display unit 245 includes, for example, a panel-type display device such as a liquid crystal panel or an organic EL (Electro Luminescence) panel, and displays a moving image or a still image captured by the imaging device 1 according to any of the foregoing embodiments and the like. The storage unit 246 records image data of a moving image or a still image captured by the imaging device 1 according to any of the foregoing embodiments and the like in a recording medium such as a semiconductor memory or a hard disk. The operation unit 247 issues an operation command for various functions of the imaging system 7 in accordance with an operation by a user. The power supply unit 248 appropriately supplies various types of power for operation to the imaging device 1 according to any of the foregoing embodiments and the like, the DSP circuit 243, the frame memory 244, the display unit 245, the storage unit 246, and the operation unit 247 which are supply targets.

Next, description is given of an imaging procedure in the imaging system 7.

FIG. 100 illustrates an example of a flowchart of an imaging operation in the imaging system 7. A user instructs start of imaging by operating the operation unit 247 (step S101). Then, the operation unit 247 transmits an imaging command to the imaging device 1 (step S102). The imaging device 1 (specifically, a system control circuit 36) executes imaging in a predetermined imaging method upon receiving the imaging command (step S103).

The imaging device 1 outputs image data obtained by imaging to the DSP circuit 243. As used herein, the image data refers to data for all pixels of pixel signals generated on the basis of electric charge temporarily held in the floating diffusions FD. The DSP circuit 243 performs predetermined signal processing (e.g., noise reduction processing, etc.) on the basis of the image data inputted from the imaging device 1 (step S104). The DSP circuit 243 causes the frame memory 244 to hold the image data having been subjected to the predetermined signal processing, and the frame memory 244 causes the storage unit 246 to store the image data (step S105). In this manner, the imaging in the imaging system 7 is performed.

In the present application example, the imaging device 1 according to any of the foregoing embodiments and the like is applied to the imaging system 7. This enables smaller size or higher definition of the imaging device 1, thus making it possible to provide a small or high-definition imaging system 7.

### <17. Practical Application Examples>

### [Practical Application Example 1]

The technology according to the present disclosure (the present technology) is applicable to various products. For example, the technology according to the present disclosure may be achieved in the form of an apparatus to be mounted to a mobile body of any kind such as an automobile, an electric vehicle, a hybrid electric vehicle, a motorcycle, a bicycle, a personal mobility, an aircraft, a drone, a vessel, and a robot.

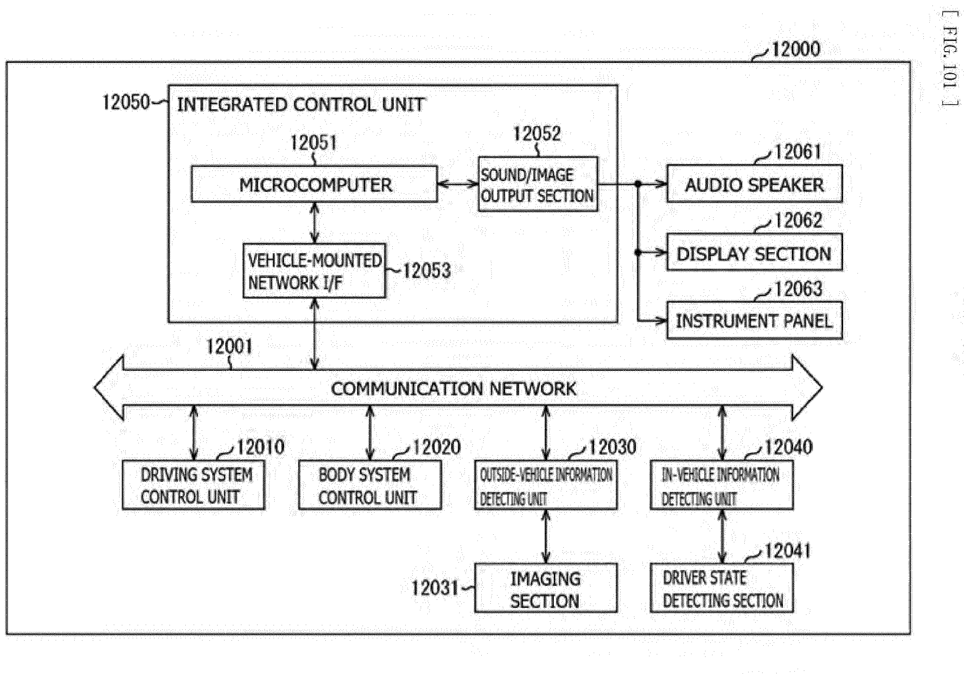

FIG. 101 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 101, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 57, an audio speaker 12061, a display section 12062, and an instrument panel 12063 are illustrated as the output device. The display section 12062 may, for example, include at least one of an on-board display and a head-up display.

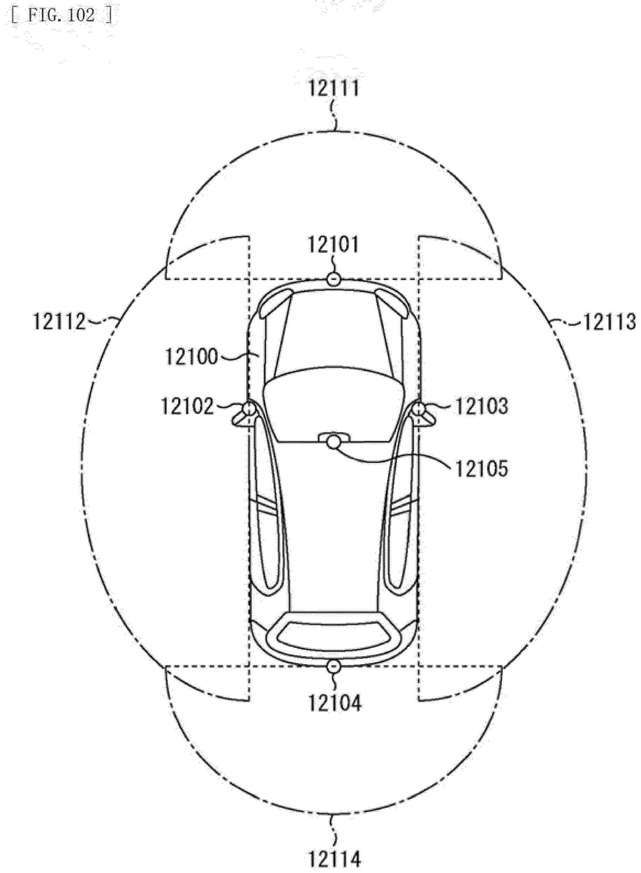

FIG. 102 is a diagram depicting an example of the installation position of the imaging section 12031.

In FIG. 102, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 102 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given hereinabove of one example of the mobile body control system, to which the technology according to the present disclosure may be applied. The technology according to the present disclosure may be applied to the imaging section 12031 among the configurations described above. Specifically, the imaging device 1 according to any of the foregoing embodiments and the like is applicable to the imaging section 12031. Applying the technology according to the present disclosure to the imaging section 12031 allows for a high-definition captured image with less noise, thus making it possible to perform highly accurate control utilizing the captured image in the mobile body control system.

### [Practical Application Example 2]

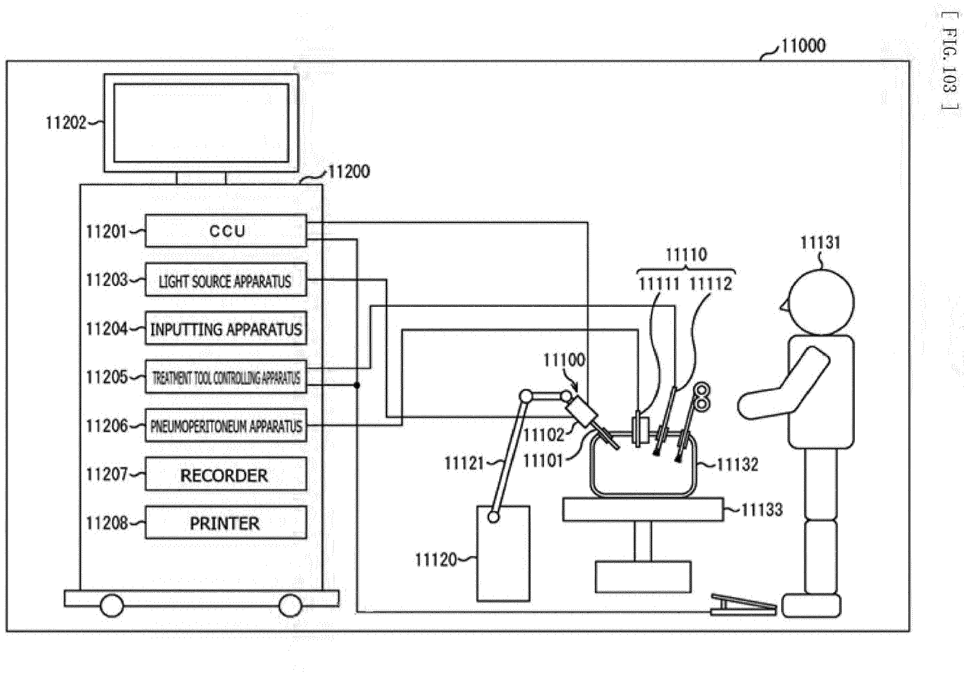

FIG. 103 is a view depicting an example of a schematic configuration of an endoscopic surgery system to which the technology according to an embodiment of the present disclosure (present technology) can be applied.

In FIG. 103, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

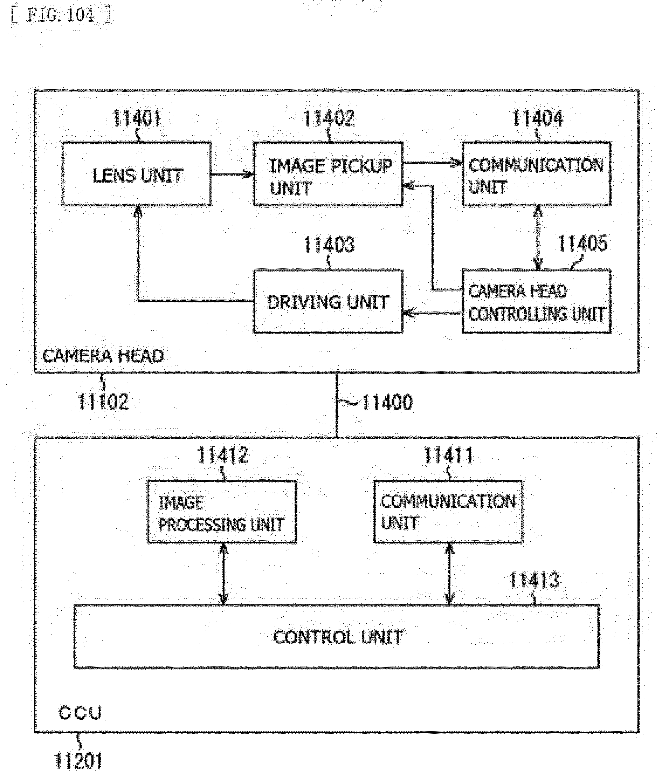

FIG. 104 is a block diagram depicting an example of a functional configuration of the camera head 11102 and the CCU 11201 depicted in FIG. 103.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The description has been given above of one example of the endoscopic surgery system, to which the technology according to the present disclosure may be applied. The technology according to the present disclosure may be suitably applied to, for example, the image pickup unit 11402 provided in the camera head 11102 of the endoscope 11100, among the configurations described above. Applying the technology according to the present disclosure to the image pickup unit 11402 enables miniaturization or higher definition of the image pickup unit 11402, thus making it possible to provide the miniaturized or high-definition endoscope 11100.

Description has been given hereinabove of the present disclosure referring to the first and second embodiments and Modification Examples 1 to 22 thereof, Application Example, and Practical Application Examples; however, the present disclosure is not limited to the foregoing embodiments and the like, and may be modified in a wide variety of ways. For example, although the description has been given of present technology by exemplifying the imaging device 1 in the foregoing embodiments and the like, the present technology is also applicable to, for example, a light-receiving element, and the like.

It is to be noted that the effects described herein are merely illustrative. The effects of the present disclosure are not limited to the effects described herein. The present disclosure may also have effects other than those described herein.

It is to be noted that the present disclosure may also have the following configurations. According to the following configurations, a charge accumulation section provided in a first semiconductor layer and a pixel transistor having a three-dimensional structure provided in a second semiconductor layer are directly coupled to each other by a through-wiring line, which enables a reduction in an area for formation of components other than the pixel transistor in a plane of a second semiconductor substrate, thus making it possible to improve area efficiency.
(1) An imaging device including:
   a first semiconductor layer including, for each pixel, a photoelectric conversion section and a charge accumulation section that accumulates signal charge generated in the photoelectric conversion section;
   a second semiconductor layer stacked on the first semiconductor layer and having a first surface provided with a pixel transistor, the pixel transistor having a three-dimensional structure and reading the signal charge from the charge accumulation section; and
   a through-wiring line that directly couples the charge accumulation section and a gate electrode of the pixel transistor to each other.
(2) The imaging device according to (1), in which the pixel transistor has a fin-type structure.
(3) The imaging device according to (1) or (2), in which
   the second semiconductor layer further has a second surface opposed to the first semiconductor layer, on a side opposite to the first surface, and
   the gate electrode penetrates through the first surface and the second surface of the second semiconductor layer.
(4) The imaging device according to (3), in which an end portion of a penetrating part, which penetrates the second semiconductor layer, of the gate electrode protrudes from the second surface of the second semiconductor layer.
(5) The imaging device according to (4), in which the through-wiring line couples the charge accumulation section and the end portion of the gate electrode protruding from the second surface of the second semiconductor layer to each other.
(6) The imaging device according to any one of (3) to (5), in which the through-wiring line is in contact with a side surface of the gate electrode penetrating the second semiconductor layer.
(7) The imaging device according to (6), in which the through-wiring line is further in contact with a portion of a top surface of the gate electrode.
(8) The imaging device according to according to any one of (3) to (7), in which
   the pixel transistor includes a plurality of fins, and
   a first width of the through-wiring line penetrating between the plurality of fins is narrower than a second width of the through-wiring line extending above the gate electrode.
(9) The imaging device according to according to any one of (1) to (8), in which the pixel transistor has a gate-all-round structure.
(10) The imaging device according to (9), in which
   the pixel transistor includes
   a semiconductor layer provided on a side of the first surface of the second semiconductor layer and extending in a direction substantially parallel to a planar direction of the second semiconductor layer,
   the gate electrode covering a top surface and an undersurface of a portion of the semiconductor layer and a pair of side surfaces,
   a first insulating film provided between the semiconductor layer and the gate electrode and covering the top surface and the pair of side surfaces of the semiconductor layer, and
   a second insulating film covering the undersurface of the semiconductor layer, and the second insulating film is provided to be wider than a third width in a direction orthogonal to an extending direction of the semiconductor layer.
(11) The imaging device according to (10), in which an extending part, of the second insulating film, extending outward beyond the third width of the semiconductor layer is formed below the second insulating film covering the undersurface of the semiconductor layer.
(12) The imaging device according to (10) or (11), in which the gate electrode has a raised part that is wider than the through-wiring line, on a side of a surface opposed to the first semiconductor layer.
(13) The imaging device according to (12), in which the width of the raised part is wider than a wiring diameter of the through-wiring line.
(14) The imaging device according to according to any one of (10) to (13), in which
   the pixel transistor includes
   a semiconductor layer provided on the side of the first surface of the second semiconductor layer and extending in the direction substantially parallel to the planar direction of the second semiconductor layer,
   the gate electrode covering a top surface and an undersurface of a portion of the semiconductor layer and a pair of side surfaces,
   a third insulating film provided between the semiconductor layer and the gate electrode and covering the top surface, the undersurface, and the pair of side surfaces of the semiconductor layer, and
   a fourth insulating film provided spaced apart at a predetermined interval below the semiconductor layer.
(15) The imaging device according to (14), in which the fourth insulating film is provided to be wider than the third width of the semiconductor layer.
(16) The imaging device according to (14), in which the fourth insulating film is provided to be narrower than the third width of the semiconductor layer.
(17) The imaging device according to (15) or (16), in which the gate electrode has a raised part that is wider than the fourth insulating film, on the side of a surface opposed to the first semiconductor layer.
(18) The imaging device according to (17), in which the width of the raised part is wider than the wiring diameter of the through-wiring line.
(19) The imaging device according to according to any one of (10) to (18), in which
   the pixel transistor includes a source region and a drain region at both ends of the semiconductor layer provided on the side of the first surface of the second semiconductor layer and extending in the direction substantially parallel to the planar direction of the second semiconductor layer, and
   a sacrificial layer is further provided that has side surfaces substantially same as the side surfaces of the semiconductor layer, immediately below the semiconductor layer in the source region and the drain region.
(20) The imaging device according to (19), in which the semiconductor layer has a substantially uniform width with respect to the extending direction.
(21) The imaging device according to according to any one of (1) to (20), in which an amplification transistor, a reset transistor, a selection transistor, and an FD conversion gain switching transistor are provided, as the pixel transistor.
(22) The imaging device according to (21), in which the amplification transistor, the reset transistor, the selection transistor, and the FD conversion gain switching transistor each have the three-dimensional structure.
(23) The imaging device according to (22), in which a gate electrode of at least the amplification transistor, among the amplification transistor, the reset transistor, the selection transistor, and the FD conversion gain switching transistor, penetrates through the first surface and the second surface of the second semiconductor layer, the second surface being opposed to the first semiconductor layer, on the side opposite to the first surface.
(24) The imaging device according to according to any one of (21) to (23), in which
   the amplification transistor has the three-dimensional structure, and
   the reset transistor, the selection transistor, and the FD conversion gain switching transistor each have a planar structure.
(25) A light-receiving element including:
   a first semiconductor layer including a photoelectric conversion section and a charge accumulation section that accumulates signal charge generated in the photoelectric conversion section;
   a second semiconductor layer stacked on the first semiconductor layer and having a first surface provided with a transistor, the transistor having a three-dimensional structure and reading the signal charge from the charge accumulation section; and
   a through-wiring line that directly couples the charge accumulation section and a gate electrode of the transistor to each other.
(26) A method of manufacturing an imaging device, the method including:
   forming, in a first semiconductor layer, a photoelectric conversion section and a charge accumulation section that accumulates signal charge generated in the photoelectric conversion section, for each pixel;
   stacking a second semiconductor layer on a first surface of the first semiconductor layer with a first insulating film interposed therebetween,
   forming a pixel transistor having a three-dimensional structure and reading the signal charge from the charge accumulation section; and
   forming a through-wiring line that penetrates the first insulating film and directly couples the charge accumulation section and a gate electrode of the pixel transistor to each other.
(27) The method of manufacturing the imaging device according to (26), in which, in the pixel transistor,
   the second semiconductor layer is worked to form a fin,
   the fin is embedded by a light-absorbing film that absorbs first light of a predetermined wavelength, and
   the first light is irradiated to form a layer of a different etching rate in the light-absorbing film, and then the light-absorbing film is etched.
(28) The method of manufacturing the imaging device according to (27), in which
   the second semiconductor layer is worked to form a fin,
   a high light-absorbing film having a higher absorption coefficient to the first light than the light-absorbing film is formed on a front surface of the fin, and then
   the fin is embedded by the light-absorbing film.
(29) The method of manufacturing the imaging device according to any one of (26) to (28), in which, in the pixel transistor,
   after the formation of the through-wiring line,
   a second insulating film and a polysilicon film included in the pixel transistor are stacked in order on the second semiconductor layer including the through-wiring line,
   the second insulating film and the polysilicon film are worked into predetermined shapes of the pixel transistor, and
   a thermal oxide film is formed, by an annealing treatment, on a front surface of the polysilicon film and a front surface of the through-wiring line, and then at least a portion of the thermal oxide film formed on the front surface of the through-wiring line outside the polysilicon film, in a plan view, is removed.
(30) The method of manufacturing the imaging device according to any one of (26) to (28), in which, in the pixel transistor,
   after the formation of the through-wiring line,
   a first sacrificial layer and a polysilicon film included in the pixel transistor are stacked in order on the second semiconductor layer including the through-wiring line,
   the first sacrificial layer and the polysilicon film are worked into predetermined shapes of the pixel transistor,
   the first sacrificial layer formed in a channel portion of the pixel transistor is removed, and
   a thermal oxide film is formed, by the annealing treatment, on the front surface of the polysilicon film and the front surface of the through-wiring line, and then at least a portion of the thermal oxide film formed on the front surface of the through-wiring line outside the polysilicon film, in a plan view, is removed.
(31) The method of manufacturing the imaging device according to any one of (26) to (28), in which, in the pixel transistor,
   after the formation of the through-wiring line,
   a first sacrificial layer and a polysilicon film included in the pixel transistor are stacked in order on the second semiconductor layer including the through-wiring line,
   the first sacrificial layer and the polysilicon film are worked into predetermined shapes of the pixel transistor, and
   the first sacrificial layer formed below a channel portion of the pixel transistor is removed by etching selectivity using an aqueous alkaline solution.
(32) The method of manufacturing the imaging device according to any one of (26) to (31), in which, after the formation of the charge accumulation section for each pixel, a second sacrificial layer is formed on the charge accumulation section.
(33) The method of manufacturing the imaging device according to (32), in which the second sacrificial layer is formed by oxidation using a material having large etching selectivity over the first insulating film.
(34) The method of manufacturing the imaging device according to (33), in which the second sacrificial layer is formed using germanium.
(35) The method of manufacturing the imaging device according to (32), in which the second sacrificial layer is formed using a material having large etching selectivity over the first insulating film.
(36) The method of manufacturing the imaging device according to (35), in which the second sacrificial layer is formed using a III-V group compound semiconductor material.
(37) The method of manufacturing the imaging device according to (32), in which the second sacrificial layer is formed using amorphous carbon.

This application claims the benefit of Japanese Priority Patent Application JP 2020-178463 filed with the Japan Patent Office on October 23, 2020, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. An imaging device comprising:
a first semiconductor layer including, for each pixel, a photoelectric conversion section and a charge accumulation section that accumulates signal charge generated in the photoelectric conversion section;
a second semiconductor layer stacked on the first semiconductor layer and having a first surface provided with a pixel transistor, the pixel transistor having a three-dimensional structure and reading the signal charge from the charge accumulation section; and
a through-wiring line that directly couples the charge accumulation section and a gate electrode of the pixel transistor to each other.

2. The imaging device according to claim 1, wherein the pixel transistor has a fin-type structure.

3. The imaging device according to claim 1, wherein
the second semiconductor layer further has a second surface opposed to the first semiconductor layer, on a side opposite to the first surface, and
the gate electrode penetrates through the first surface and the second surface of the second semiconductor layer.

4. The imaging device according to claim 3, wherein an end portion of a penetrating part, which penetrates the second semiconductor layer, of the gate electrode protrudes from the second surface of the second semiconductor layer.

5. The imaging device according to claim 4, wherein the through-wiring line couples the charge accumulation section and the end portion of the gate electrode protruding from the second surface of the second semiconductor layer to each other.

6. The imaging device according to claim 3, wherein the through-wiring line is in contact with a side surface of the gate electrode penetrating the second semiconductor layer.

7. The imaging device according to claim 6, wherein the through-wiring line is further in contact with a portion of a top surface of the gate electrode.

8. The imaging device according to claim 3, wherein
the pixel transistor includes a plurality of fins, and
a first width of the through-wiring line penetrating between the plurality of fins is narrower than a second width of the through-wiring line extending above the gate electrode.

9. The imaging device according to claim 1, wherein the pixel transistor has a gate-all-round structure.

10. The imaging device according to claim 9, wherein
the pixel transistor includes
a semiconductor layer provided on a side of the first surface of the second semiconductor layer and extending in a direction substantially parallel to a planar direction of the second semiconductor layer,
the gate electrode covering a top surface and an undersurface of a portion of the semiconductor layer and a pair of side surfaces,
a first insulating film provided between the semiconductor layer and the gate electrode and covering the top surface and the pair of side surfaces of the semiconductor layer, and
a second insulating film covering the undersurface of the semiconductor layer, and
the second insulating film is provided to be wider than a third width in a direction orthogonal to an extending direction of the semiconductor layer.

11. The imaging device according to claim 10, wherein an extending part, of the second insulating film, extending outward beyond the third width of the semiconductor layer is formed below the second insulating film covering the undersurface of the semiconductor layer.

12. The imaging device according to claim 10, wherein the gate electrode has a raised part that is wider than the through-wiring line, on a side of a surface opposed to the first semiconductor layer.

13. The imaging device according to claim 12, wherein the width of the raised part is wider than a wiring diameter of the through-wiring line.

14. The imaging device according to claim 10, wherein
the pixel transistor includes
a semiconductor layer provided on the side of the first surface of the second semiconductor layer and extending in the direction substantially parallel to the planar direction of the second semiconductor layer,
the gate electrode covering a top surface and an undersurface of a portion of the semiconductor layer and a pair of side surfaces,
a third insulating film provided between the semiconductor layer and the gate electrode and covering the top surface, the undersurface, and the pair of side surfaces of the semiconductor layer, and
a fourth insulating film provided spaced apart at a predetermined interval below the semiconductor layer.

15. The imaging device according to claim 14, wherein the fourth insulating film is provided to be wider than the third width of the semiconductor layer.

16. The imaging device according to claim 14, wherein the fourth insulating film is provided to be narrower than the third width of the semiconductor layer.

17. The imaging device according to claim 15, wherein the gate electrode has a raised part that is wider than the fourth insulating film, on a side of a surface opposed to the first semiconductor layer.

18. The imaging device according to claim 17, wherein the width of the raised part is wider than a wiring diameter of the through-wiring line.

19. The imaging device according to claim 10, wherein
the pixel transistor includes a source region and a drain region at both ends of the semiconductor layer provided on the side of the first surface of the second semiconductor layer and extending in the direction substantially parallel to the planar direction of the second semiconductor layer, and
a sacrificial layer is further provided that has side surfaces substantially same as the side surfaces of the semiconductor layer, immediately below the semiconductor layer in the source region and the drain region.

20. The imaging device according to claim 19, wherein the semiconductor layer has a substantially uniform width with respect to the extending direction.

21. The imaging device according to claim 1, wherein an amplification transistor, a reset transistor, a selection transistor, and an FD conversion gain switching transistor are provided, as the pixel transistor.

22. The imaging device according to claim 21, wherein the amplification transistor, the reset transistor, the selection transistor, and the FD conversion gain switching transistor each have the three-dimensional structure.

23. The imaging device according to claim 22, wherein a gate electrode of at least the amplification transistor, among the amplification transistor, the reset transistor, the selection transistor, and the FD conversion gain switching transistor, penetrates through the first surface and a second surface of the second semiconductor layer, the second surface being opposed to the first semiconductor layer, on a side opposite to the first surface.

24. The imaging device according to claim 21, wherein
the amplification transistor has the three-dimensional structure, and
the reset transistor, the selection transistor, and the FD conversion gain switching transistor each have a planar structure.

25. A light-receiving element comprising:
a first semiconductor layer including a photoelectric conversion section and a charge accumulation section that accumulates signal charge generated in the photoelectric conversion section;
a second semiconductor layer stacked on the first semiconductor layer and having a first surface provided with a transistor, the transistor having a three-dimensional structure and reading the signal charge from the charge accumulation section; and
a through-wiring line that directly couples the charge accumulation section and a gate electrode of the transistor to each other.
